(19) Europäisches Patentamt

European Patent Office

Office européen des brevets

(11) **EP 1 791 169 A1**

(12) **EUROPEAN PATENT APPLICATION**
published in accordance with Art. 158(3) EPC

(43) Date of publication:
**30.05.2007 Bulletin 2007/22**

(21) Application number: **05777070.3**

(22) Date of filing: **30.08.2005**

(51) Int Cl.:
*H01L 21/027* (2006.01)   *G03F 7/20* (2006.01)
*H01L 21/68* (2006.01)

(86) International application number:
**PCT/JP2005/015764**

(87) International publication number:
**WO 2006/025386 (09.03.2006 Gazette 2006/10)**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **31.08.2004 JP 2004251244**
**22.02.2005 JP 2005045660**

(71) Applicant: **NIKON CORPORATION**
**Tokyo 100-8331 (JP)**

(72) Inventors:
• **ISHII, Yuuki,**
**NIKON CORPORATION**
**Tokyo 100-8331 (JP)**
• **OKITA, Shinichi,**
**NIKON CORPORATION**
**Tokyo 100-8331 (JP)**

(74) Representative: **Gill, David Alan**
**W.P. Thompson & Co.,**
**55 Drury Lane**
**London WC2B 5SQ (GB)**

(54) **ALIGNING METHOD, PROCESSING SYSTEM, SUBSTRATE LOADING REPEATABILITY MEASURING METHOD, POSITION MEASURING METHOD, EXPOSURE METHOD, SUBSTRATE PROCESSING APPARATUS, MEASURING METHOD AND MEASURING APPARATUS**

(57)   An edge of a surface to be measured of wafer (W) and each of search alignment marks (SYM, SθM) on the wafer (W) are detected by an inline measurement instrument or the like that operates independently of an exposure apparatus, and position coordinates of the search marks (SYM, SθM) in an X'Y' coordinate system, which is a two-dimensional coordinate system substantially parallel to the surface to be measured and is set by a position of a notch of the wafer (W), are measured. Then, in pre-alignment performed when loading the wafer (W) into the exposure apparatus, the edge of the wafer (W) is detected, and from the detection results, position information of the object in the X'Y' coordinate system is measured. Further, a relative position in the X'Y' coordinate system of the wafer (W) to be loaded into the exposure apparatus based on measurement results of the pre-alignment with respect to a measurement field of an alignment system that measures positions of the search marks on the wafer (W) is adjusted based on measurement results of the inline measurement instrument or the like.

Fig. 18A

EP 1 791 169 A1

Fig. 18B

MA

SθM

V1

Y'

X'

**Description**

The present invention relates to positioning methods, processing systems, measurement methods of substrate loading repeatability, position measurement methods, exposure methods, substrate processing apparatuses, measurement methods, and measurement apparatuses, and more particularly, for exmpale, in a photolithography process for manufacturing semiconductor devices, liquid crystal display devices, imaging devices, thin film magnetic heads and the like, relates to a positioning method and a processing system used to form a circuit pattern with high accuracy and high throughput, a measurement method of substrate loading repeatability in which loading repeatability of a substrate whose position is set to a predetermined datum position is measured, a position measurement method in which position information of a substrate is measured using the measurement method of substrate loading repeatability, an exposure method and a substrate processing apparatus that perform processing while controlling a position of a substrate using the position information measured in the position measurement method, and a measurement method and a measurement apparatus that measure position information of marks on an object.

In a lithographic process for manufacturing semiconductor devices, liquid crystal display devices and the like, an exposure apparatus that transfers a pattern formed on a mask or reticle (hereinafter generally referred to as a 'reticle') onto a substrate such as a wafer coated with resist or the like or onto a glass plate (hereinafter generally referred to as a 'wafer') via a projection optical system, for example, a projection exposure apparatus of a sequentially moving type (hereinafter shortened to an 'exposure apparatus') such as a reduction projection exposure apparatus by a step-and-repeat method (the so-called stepper) and a scanning projection exposure apparatus by a step-and-scan method (the so-called scanning stepper) that is an improvement of the stepper is mainly used.

In the case of manufacturing semiconductor devices or the like, different circuit patterns are formed in many layers on a wafer. However, an inconvenience may occur in the properties of the circuit if the overlay accuracy between the layers is poor. In such a case, the chip does not satisfy desired properties, and in the worst case, the chip becomes defective, which reduces the yield. Accordingly, in an exposure process, it becomes important to accurately overlay a reticle on which a circuit pattern is formed on a pattern that is already formed in each shot area on a wafer when transfer is performed.

Therefore, in the exposure process, alignment marks are arranged in advance in each of a plurality of shot areas on the wafer on which circuit patterns are formed, and in the case of performing the exposure process (the overlay exposure process) again, each alignment mark is observed by a certain observation apparatus and positions (coordinate values on a stage coordinate system of a wafer stage on which the wafer is mounted (a coordinate system that sets movement of the wafer stage, normally, a coordinate system that is set by measurement axes of a laser interferometer)) of the alignment marks are measured based on the observation results. After that, based on the measurement results, that is, position information of the marks and known position information of a projection position of a reticle pattern (which is pre-measured), a deviation between the stage coordinate system and an array coordinate system that is set by a plurality of shot areas on the wafer is obtained, then the so-called wafer alignment (fine alignment) in which a positional relation between each shot area and the projection position of the reticle pattern is obtained is performed, taking the deviation into consideration (e.g. Patent Documents 1 to 3 and the like).

Incidentally, since such alignment marks (hereinafter referred to as 'fine alignment marks') are observed with a high magnification from the viewpoint of increasing detection accuracy, an observation field of the observation apparatus on observation of the fine alignment marks is narrow by necessity. Then, in order to catch the mark in the narrow observation field without fail, a deviation between the stage coordinate system and the array coordinate system is detected as follows, prior to the observation of the fine alignment marks.

First, by detecting an outer edge section of the wafer that includes at least a notch (or an orientation flat), a deviation of an orientation and of a center position of the wafer on the wafer stage is roughly detected, and a wafer position is adjusted in accordance with the deviation. This detection operation is generally called as pre-alignment. In other words, in pre-alignment, positioning of wafer W is performed based on a detected outer shape of the wafer.

Further, in at least two points on the wafer, marks, the so-called search alignment marks, which can be observed with a low magnification by an observation apparatus are arranged along with shot areas and the fine alignment marks. With respect to the wafer that is positioned by the pre-alignment, each search alignment mark is observed by a predetermined observation apparatus using results of the pre-alignment as a datum, that is, using the wafer outer shape as a datum. Then, based on the observation results, a position of each search alignment mark is detected, and based on the position of each search alignment mark, a rotation component and an offset of the wafer are computed. This detection operation is generally called as search alignment. In the fine alignment described above, the fine alignment marks are measured using results of the search alignment as a datum.

In this manner, conventionally, in an exposure apparatus, a series of alignment processing, that is, pre-alignment, search alignment and fine alignment has been performed before exposure in order to achieve overlay exposure with high accuracy. Since each alignment processing is performed based on results of a preceding alignment processing thereof, it is requisite for performing the alignment processing with good precision that the preceding alignment processing is favorably performed.

In the meantime, in a substrate processing factory that has a plurality of exposure apparatuses, overlay exposure is often performed in different exposure apparatuses due to scheduling of the processes of the exposure apparatuses. In such a case, the items referred to below become, for example, causes of errors of the positions of search alignment marks. That is, in an exposure apparatus that performs exposure of a previous layer (hereinafter referred to as a 'previously layer exposure apparatus'), there are

A. Offset (e.g. about 40μm),
B. Pre-alignment and repeatability of wafer loading to the exposure apparatus (e.g. 3σ=about 15μm), and in an exposure apparatus that performs exposure of a next layer (hereinafter referred to as a 'next layer exposure apparatus'), there are
C. Offset (e.g. about 40μm),
D. Pre-alignment and repeatability of wafer loading (e.g. 3σ=about 15μm),
E. Manufacturing error of a measurement apparatus that performs mark measurement, and a magnification tolerance of an optical system that detects marks (e.g. about 10μm) and the like.

Taking such points into consideration, for example, a measurement range of a measurement apparatus that measures the search alignment marks is set as follows, for example:

$$A+C+\sqrt{(B^2+D^2)}+E=133\mu m \quad (\pm 66.5\mu m).$$

However, sometimes an outer shape of a wafer slightly deviates due to warpage of the wafer or the like, which deviates the positions of search marks with respect to each wafer at times, even when the outer shape of the wafer is detected and the wafer is loaded based on the outer shape as a datum. Also, sometimes wafer loading repeatability is decreased due to insufficient adjustment of a mechanism that loads the wafer into an exposure apparatus on wafer loading, changes with time or the like. Thus, it is required to reduce effects of fluctuation causes A. to E. described above as much as possible, and contain the search alignment marks and the like within the measurement range of a measurement apparatus without fail.

Further, measurement of loading repeatability of the wafer, which was positioned by the pre-alignment and loaded into an exposure apparatus, has been performed by suspending the process in the exposure apparatus once and loading a datum wafer for apparatus adjustment that is not a wafer of the process into the exposure apparatus a plurality of times (e.g. 60 times) in a periodical maintenance (e.g. refer to Patent Document 4). However, also from the viewpoint of throughput, it is not preferable to suspend the process in order to measure loading repeatability using such a datum wafer. Moreover, in the case measurement of the wafer loading repeatability is performed only at the time of the maintenance, the occurrence of abnormality in the wafer loading repeatability cannot be recognized until the measurement is performed, which may reduce the yield until the measurement is performed.

Patent Document 1: Kokai (Japanese Unexamined PatentApplication Publication) No. 61-044429
Patent Document 2: the U.S. Patent No. 4,780,617
Patent Document 3: Kokai (Japanese Unexamined PatentApplication Publication) No. 62-084516
Patent Document 4: Kokai (Japanese Unexamined PatentApplication Publication) No. 05-283315

The present invention has been made under such circumstances, and according to a first aspect of the present invention, there is provided a positioning method, comprising: a pre-measurement process in which before an object that has at least two marks formed on a surface to be measured thereof is loaded into a processing apparatus that performs predetermined processing to the object, at least a part of an outer edge of a surface to be measured of the object and each of the marks are detected, and a position coordinate of each of the marks in an outer shape reference coordinate system that is a two-dimensional coordinate system substantially parallel to the surface to be measured and is set by at least one datum point on the outer edge is measured based on the detection results; a main measurement process in which at least a part of the outer edge of the surface to be measured of the object is detected, and position information of the object in the outer shape reference coordinate system is measured based on the detection results, in order to perform positioning of the object on loading of the object into the processing apparatus; and an adjustment process in which a relative positional relation in the two-dimensional coordinate system of the object to be loaded into the processing apparatus based on the measurement results of the main measurement process with respect to a measurement field of a mark measurement unit that is arranged within the processing apparatus and measures a position of each of the marks on the object is adjusted, based on measurement results in the pre-measurement process.

In this case, the 'outer shape reference coordinate system' is a coordinate system based on an outer shape of the object as a datum. For example, such a coordinate system that is a two-dimensional coordinate system substantially parallel to the surface to be measured of the object and is set by at least one datum point on the outer edge of the surface to be measured of the object is to be included in the outer shape reference coordinate system.

With this method, when loading the object into the processing apparatus, in the case a least a part of the outer edge of the surface to be measured of the object is detected, and based on the detection results, position information of the object in the outer shape reference coordinate system that is a two-dimensional coordinate system substantially parallel to the surface to be measured of the object and is set by at least one datum point on the outer edge of the object is measured, then based on the measurement results, positioning of the object is performed in the main measurement process, in the pre-measurement process prior to the main measurement process, at least a part of the outer edge of the surface to be measured of the object and at least two marks formed on the surface to be measured of the object are detected, and based on the detection results, measurement of a position coordinate of each mark in the outer shape reference coordinate system is performed beforehand. Further, in the adjustment process, a relative positional relation in the two-dimensional coordinate system between the object to be loaded into the processing apparatus by the positioning based on the measurement results of the main measurement process, and the measurement field of the mark measurement unit that measures a position of each of the marks on the object is adjusted based on the measurement results in the pre-measurement process.

In this manner, outer shape variation of the object caused by A. offset, B. pre-alignment and repeatability of the wafer loading to the processing apparatus in the previous layer processing apparatus, and variation in a mark position due to a difference of the outer shape reference coordinate system are measured beforehand, and based on the measurement results, mark measurement can be adjusted. With this adjustment, when the mark position on the object loaded into the processing apparatus is measured using the mark measurement unit, the mark can always be located within the measurement field of the mark measurement unit, and the mark positions can be measured without fail. As a consequence, the processing with high accuracy and high throughput can be achieved based on measurement results of the mark positions.

Further, according to a second aspect of the present invention, there is provided a processing system, comprising: a processing apparatus that performs predetermined processing to an object; a mark measurement unit that performs position measurement of at least two marks formed on the object loaded into the processing apparatus; a pre-measurement apparatus that, before the object that has at least two marks formed on a surface to be measured thereof is loaded into the processing apparatus, detects at least a part of an outer edge of the surface to be measured of the object and each of the marks, and measures a position coordinate of each of the marks in an outer shape reference coordinate system that is a two-dimensional coordinate system substantially parallel to the surface to be measured and is set by at least one datum point on the outer edge of the object, based on the detection results; an outer edge measurement unit that detects at least a part of the outer edge of the surface to be measured of the object, and measures position information of the object in the outer shape reference coordinate system based on the detection results, in order to perform positioning of the object on loading of the object into the processing apparatus; and an adjustment unit that adjusts a relative positional relation in the two-dimensional coordinate system of the object to be loaded into the processing apparatus based on the measurement results of the outer edge measurement unit with respect to a measurement field of the mark measurement unit, based on measurement results of the pre-measurement apparatus.

With this apparatus, before the object is loaded into the processing apparatus, the pre-measurement apparatus measures the position coordinates in the outer shape reference coordinate system of the marks on the object, and based on the measurement results, the adjustment unit adjust the position of the measurement field of the mark measurement unit, and therefore the marks can be contained within the measurement field without fail.

According to a third aspect of the present invention, there is provided a measurement method of substrate loading repeatability in which repeatability of a loading position of a substrate that is loaded to a datum position arranged within a substrate processing apparatus, the method comprising: a position setting process in which positions of a plurality of the substrates on which a device pattern is to be sequentially transferred are sequentially set to the datum position; a measurement process in which position information of a mark that is formed on the substrate loaded to the datum position is sequentially measured by a measurement instrument arranged within the substrate processing apparatus; and a computation process in which the loading repeatability is computed based on measurement results of the measurement process.

With this method, since the loading repeatability is measured using results of the measurement of position information of the mark formed on the substrate (the substrate on which a device pattern is to be transferred) that is normally performed during substrate processing (e.g. exposure processing), it is unnecessary not only to use an exclusive datum wafer as in the related art, but also to suspend the processing. Accordingly, the substrate loading repeatability can be measured without reducing processing efficiency.

According to a fourth aspect of the present invention, there is provided a position measurement method in which position information that indicates a position of a substrate whose position is set to a predetermined datum position is measured, the method comprising: a process in which loading repeatability of the substrate disposed at the datum position is measured using the measurement method of substrate loading repeatability of the present invention; and a process in which the position of the substrate is adjusted in accordance with tendency of the loading repeatability, and position information of a mark formed on the substrate is measured. In such a case, since the substrate loading repeatability can be measured using the measurement method of substrate loading repeatability of the present invention, processing efficiency of the mark measurement improves.

According to a fifth aspect of the present invention, there is provided an exposure method in which a predetermined pattern is transferred onto a substrate, the method comprising: a substrate measurement process in which position information that indicates a position of the substrate is obtained using the position measurement method of the present invention; and a transfer process in which position control of the substrate is performed based on the position information of the substrate obtained in the substrate measurement process, and the pattern is transferred onto the substrate while performing. In such a case, since the transfer is performed while performing position control of the substrate using the position information of the substrate obtained using the position measurement method of the present invention, exposure with high throughput and high accuracy can be achieved.

According to a sixth aspect of the present invention, there is provided a substrate processing apparatus that sequentially processes a plurality of substrates, the apparatus comprising: position setting means that sequentially sets positions of the substrates to a predetermined datum position; measurement means that measures position information of a mark formed on the substrate whose position is set to the datum position; and computation means that computes loading repeatability of the substrate based on measurement results of the measurement means. With this apparatus, the substrate loading repeatability can actually be obtained from the measurement results of the position information of the mark formed on the substrate whose position is actually set.

According to a seventh aspect of the present invention, there is provided a measurement method, comprising: a first process in which at least a part of an outer edge of a surface to be measured of an object that has a mark formed on the surface to be measured thereof is measured; a second process in which the mark is measured; and a third process in which position information of the mark in an outer shape reference coordinate system that is a two-dimensional coordinate system substantially parallel to the surface to be measured and is set by at least one datum point on the outer edge is obtained based on measurement results of the first and second processes.

With this method, the position information of the mark in the outer shape reference coordinate system that is set by at cast one datum point on the outer edge can be obtained, based the measurement results of at least a part of the outer edge af the surface to be measured of the object, and the measurement results of the mark.

According to an eighth aspect of the present invention, there is provided a measurement method, comprising: a first process in which at least a part of an outer edge of an object is measured before the object is loaded into a processing apparatus that performs predetermined processing to the object; and a second process in which measurement results of the first process and/or evaluation results obtained by evaluating the measurement results of the first process in a predetermined evaluation method are/is sent to the processing apparatus.

With this method, before loading the object into the processing apparatus, at least a part of the outer edge is measured and the measurement results and the like are sent to the processing apparatus. In this manner, the processing apparatus can perform processing after the object is loaded, taking the measurement results into consideration.

According to a ninth aspect of the present invention, there is provided a measurement apparatus, comprising: a first measurement sensor that measures at least a part of an outer edge of a surface to be measured of an object that has a mark formed on the surface to be measured thereof; a second measurement sensor that measures the mark; and a computation unit that obtains position information of the mark in an outer shape reference coordinate system that is a two-dimensional coordinate system substantially parallel to the surface to be measured and is set by at least one datum point on the outer edge, based on measurement results of the first and second sensors.

With this apparatus, the position information of the mark in the outer shape reference coordinate system that is set by at lest one datum point on the outer edge can be obtained, based on the measurement results of at least a part of the outer edge of the surface to be measured of the object in the first measurement sensor and the measurement results of the mark in the second measurement sensor.

According to a tenth aspect of the present invention, there is provided a measurement apparatus, comprising: a sensor that is disposed outside a processing apparatus that performs predetermined processing to an object and measures at least a part of an outer edge of the object before the object is loaded into the processing apparatus; and a transmission unit that sends measurement results of the sensor and/or evaluation results obtained by evaluating the measurement results of the sensor in a predetermined evaluation method to the processing apparatus.

With this apparatus, before loading the object into the processing apparatus, the sensor measures at least a part of the outer edge, and the transmission unit sends the measurement results, the evaluation results and/or the like to the processing apparatus. In this manner, the processing apparatus can perform processing after the object is loaded, taking the measurement results into consideration.

FIG. 1 is a block diagram showing a schematic configuration of a processing system related to an embodiment of the present invention;

FIG. 2 is a view showing a schematic configuration of an exposure apparatus related to the embodiment cf the present invention;

FIG. 3A is a perspective view shawing a wafer stage and a wafer holder;

FIG. 3B is a plan view showing the wafer stage and the wafer holder;

FIG. 3C is a view (a partial sectional view) when viewing the wafer stage and the wafer holder from a -Y side;

FIG. 4 is a perspective view showing a wafer transport system and a pre-alignment system;

FIG. 5 is a view showing a simplified inner configuration of a measurement unit;

FIG. 6A is a view showing measurement positions of a notch wafer to be measured by the measurement unit;

FIG. 6B is a view showing measurement positions of a wafer to which an orientation flat is arranged to be measured by the measurement unit;

FIG. 7 is a view schematically showing an entire configuration of a substrate processing apparatus;

FIG. 8A is a perspective view schematically showing a configuration of an inline measurement instrument;

FIG. 8B is a block diagram showing a configuration of the inline measurement instrument;

FIG. 9 is a flowchart showing a flow of a wafer process of the embodiment of the present invention;

FIG. 10 is a view showing a computation method of a center position and a rotation amount of a wafer;

FIG. 11 is a flowchart showing computation processing of a center position and a rotation amount of a wafer;

FIG. 12A is a view showing velocity distribution of a lowering operation of a loading arm;

FIG. 12B is a view showing velocity distribution of a lowering operation of a center table;

FIG. 13 is a view showing positions where search alignment marks and the like are formed on a wafer;

FIG. 14 is a view used to explain pipeline processing in the embodiment of the present invention;

FIG. 15A is a flowchart (No. 1) showing a sequence of pre-measurement processing and pre-alignment optimization in the embodiment of the present invention;

FIG. 15B is a flowchart (No. 2) showing a sequence of pre-alignment optimization;

FIG. 16 is a flowchart (No. 3) showing a sequence of pre-measurement processing and pre-alignment optimization in the embodiment of the present invention;

FIG. 17A is a view (No. 1) showing a state of edge measurement of a wafer in the inline measurement instrument;

FIG. 17B is a view (No. 2) showing a state of edge measurement of a wafer in the inline measurement instrument;

FIG. 17C is a view (No. 3) showing a state of edge measurement of a wafer in the inline measurement instrument;

FIG. 18A is a view showing a model of position deviation amounts of the search marks;

FIG. 18B is a view showing a state of correction of a search mark measurement field;

FIG. 19 is a flowchart showing a condition setting sequence of wafer loading repeatability measurement;

FIG. 20 is a view showing an example of a configuration of a sensor by the transmission illumination method;

FIG. 21 is a view showing a schematic configuration of an exposure apparatus that is suitable for another repeatability measurement method;

FIG. 22 is a perspective view showing a schematic configuration of a wafer delivery mechanism;

FIG. 23A is a view showing schematic configuration of a first pre-alignment unit;

FIG. 23B is a view used to explain wafer position adjustment;

FIG. 24A is a view (No.1) showing an arrangement of image processors that a second pre-alignment unit comprises;

FIG. 24B is a View (No. 2) showing an arrangement of image processors that the second pre-alignment unit comprises;

FIG. 25 is a side view (No. 1) showing a schematic configuration of the image processor;

FIG. 26 is a side view (No. 2) showing a schematic configuration of the image processor;

FIG. 27 is a flowchart showing processing of the exposure apparatus;

FIG. 28 is a flowchart showing details of condition setting related to wafer position setting repeatability measurement;

FIG. 29 is a view showing an example of a lowering operation of an adjustment arm when delivering a wafer from the adjustment arm to a center table;

FIG. 30 is a view showing an example of a lowering operation of the center table when delivering a wafer from the center table to a wafer holder;

FIG. 31A is a view (No. 1) showing another arrangement of image processors that the second pre-alignment unit comprises;

FIG. 31B is a view (No. 2) showing yet another arrangement of image processors that the second pre-alignment unit comprises;

FIG. 32 is a view showing a schematic configuration of another image processor; and

FIG. 33 is a view showing a schematic configuration of yet another image processor.

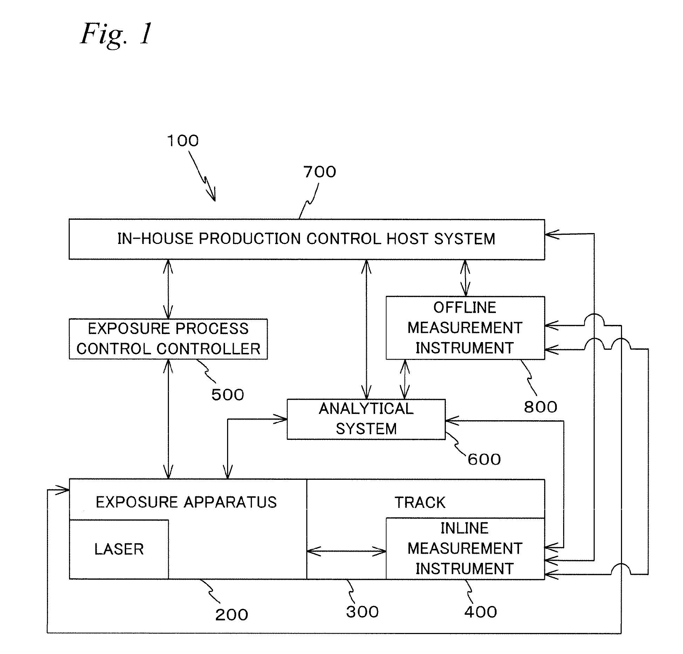

An embodiment of the present invention will be described below, referring to FIGS. 1 to 19. FIG. 1 schematically shows the entire configuration of a processing system 100 of the embodiment, in which a positioning method related to the present invention is carried out.

Processing system 100 is located in a 'substrate processing factory' where devices such as microdevices are manufactured by processing a substrate (hereinafter generally referred to as a 'wafer W') such as a semiconductor wafer or glass plate as an object. As is shown in FIG. 1, processing system 100 is equipped with an exposure apparatus 200 that comprises a light source such as laser light source, and a coating/developing apparatus (hereinafter referred to as a 'track') 300 that is disposed adjacent to exposure apparatus 200. Within track 300, an inline measurement instrument 400 is arranged.

The combination of exposure apparatus 200 and track 300 can be regarded as a substrate processing apparatus as a unit. In the substrate processing apparatus, a coating process in which a photosensitive agent such as photoresist is coated on the wafer, an exposure process in which a pattern of a mask or a reticle is transferred on the wafer on which the photosensitive agent is coated, a developing process in which the wafer after the exposure process is developed, and the like are performed. Of these processes, the coating process and the developing process are carried out by track 300, and the exposure process is carried out by exposure apparatus 200.

In the substrate processing apparatus, exposure apparatus 200 and track 300 are connected inline to each other. The inline connection in this case means the connection between the apparatuses or between processing units within each apparatus via a transport unit that automatically transports a wafer such as a robot arm and a slider.

Incidentally, FIG. 1 shows only one substrate processing apparatus due to space limitations on the page, however, in actual a plurality of substrate processing apparatuses are arranged in processing system 100. That is, in processing system 100, exposure apparatus 200 and track 300 are arranged in plural.

Further, processing system 100 is equipped with an exposure process control controller 500 that centrally controls the exposure process carried out by each exposure apparatus 200, an analytical system 600 that performs various types of computation processing and analytical processing, an in-house production control host system 700 that performs overall control over the respective apparatuses in the substrate processing factory, and an offline measurement instrument 800.

Among the respective apparatuses constituting processing system 100, at least each substrate processing apparatus (200, 300) and offline measurement instrument 800 are arranged in a clean room where the temperature and the humidity are controlled. Further, the respective apparatuses are connected to each other via a network such as a LAN (Local Area Network) that is set up in the substrate processing factory or a dedicated line (by wired or wireless), and data communication can appropriately be performed between them.

Inline measurement instrument 400 is an instrument that operates independently of exposure apparatus 200, and is arranged as one of a plurality of processing units disposed in track 300, which will be described later, and measures in advance various types of information related to a wafer before the wafer is loaded into exposure apparatus 200.

Offline measurement instrument 800 is a measurement instrument that is arranged independently of other apparatuses, and is arranged in singular or in plural in processing system 100. Offline measurement instrument 800 is also connected via the network or dedicated line described above so that offline measurement instrument 800 can receive the measurement results at inline measurement instrument 400. Incidentally, in FIG. 1, offline measurement instrument 800 is shown as an instrument that offline performs predetermined processing to a wafer. As an example of the offline measurement instrument, an overlay measurement instrument that measures an overlay state by measuring overlay marks that are exposed and formed by an exposure apparatus, a line-width measurement instrument that measure a line width of a pattern, or the like can be cited, however, an instrument that performs predetermined processing is not limited to these instruments. For example, instead of or in addition to offline measurement instrument 800, an inspection apparatus that inspects whether or not there are defects on a substrate based on image data obtained by picking up an image on the substrate, a test apparatus that actually performs current test in order to discriminate electrical (operation) abnormality of a circuit pattern that is exposed and formed on a substrate, a laser repair apparatus that performs repair processing of a circuit pattern that is exposed and formed on a substrate using laser, or the like may be incorporated as a part of the lithography system of the embodiment.

[Exposure apparatus]

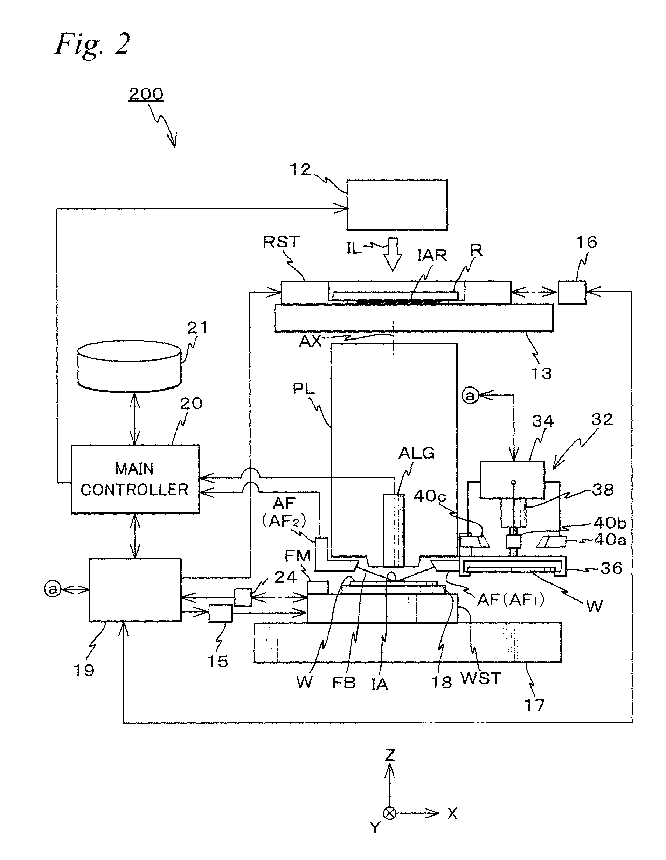

In the embodiment, exposure apparatus 200 is to be a projection exposure apparatus by a step-and-scan method (a scanning exposure apparatus). FIG. 2 shows a model of the schematic configuration of exposure apparatus 200. As is shown in FIG. 2, exposure apparatus 200 is equipped with an illumination system 12, a reticle stage RST that holds a reticle R, a projection optical system PL, a wafer stage WST as a stage on which wafer W having an approximately circular shape to be loaded is mounted, a control system thereof, and the like.

Illumination system 12 is, for example, as disclosed in Kokai (Japanese Unexamined Patent Application Publication) No. 2001-313250 (the corresponding U.S. Patent Application Publication No. 2003/0025890) and the like, configured containing a laser light source shown in FIG. 1 and an illumination optical system that includes an illuminance uniformity optical system including an optical integrator (such as fly-eye lens, an inner reflection type integrator, or a diffractive optical system) and the like, a relay lens, a variable ND filter, a reticle bind, a dichroic mirror and the like (none of which are shown). Illumination system 12 illuminates an illumination light IL with uniform illuminance to a slit-shaped illumination area IAR that is set by the reticle blind arranged on reticle R on which a circuit pattern or the like is drawn. In this case, as illumination light IL, a far-ultraviolet light such as a KrF excimer laser light (wavelength: 248nm), a vacuum ultraviolet light such as an ArF excimer laser light (wavelength: 193nm) or an $F_2$ laser light (wavelength: 157nm), or the like is used. As illumination light IL, an emission line (such as a g-line or an i-line) in ultraviolet range from an extra-high pressure mercury lamp can also be used. Incidentally, respective drive sections within illumination system 12, that is, the variable ND filter, the reticle blind and the like are controlled by a main controller 20. As long as the national laws in designated states (or elected states), to which this international application is applied, permit, the above disclosures of the publication and the U.S. Patent Application Publication or the U.S. Patent are incorporated herein by reference.

Reticle stage RST is disposed on a reticle base plate 13, and reticle R is fixed by, for example, vacuum suction on an upper surface of the reticle stage. Reticle stage RST has a structure finely drivable within a plane (an XY plane) perpendicular to an optical axis of illumination system 12 (which coincides with an optical axis AX of projection optical system to be described later) two-dimensionally (an X-axis direction, a Y-axis direction orthogonal to the X-axis direction, and a rotation direction around a Z-axis direction orthogonal to the XY plane (a θz direction)) by a reticle stage drive section (not shown) including, for example, a linear motor, a voice coil motor or the like, and is also drivable in a predetermined scanning direction (to be the Y-axis direction, in this case) at a designated scanning velocity. Reticle stage RST has a sufficient movement stroke in the Y-axis direction enough for an entire surface of reticle R to cross the optical axis of illumination system 12.

A side surface of reticle stage RST is polished and a reflection surface is formed to reflect an interferometer beam from a reticle laser interferometer (hereinafter referred to as a 'reticle interferometer') 16. Reticle interferometer 16 makes a returning light from the reflection surface and a returning light from a reference section (not shown) interfere, and based on a photoelectric conversion signal of the interference light, constantly detects the position (including the θz rotation) of reticle stage RST within a stage movement plane (the XY plane) at a resolution of, for example, around 0.5 to 1 nm. As measurement axes of reticle interferometer 16, at least two axes in the scanning direction and at least one axis in a non-scanning direction are arranged in actual.

Position information of reticle stage RST from reticle interferometer 16 is sent to a stage controller 19 and main controller 20 via stage controller 19, and according to instructions from main controller 20, stage controller 19 drives reticle stage RST via the reticle stage drive section (not shown) based on the position information of reticle stage RST.

Projection optical system PL is disposed below reticle stage RST in FIG. 1, and a direction of optical axis AX of the projection optical system (which coincides with the optical axis of the illumination optical system) is to be the Z-axis direction. As projection optical system PL, for example, a dioptric system that is both-side telecentric, and is configured of a plurality of lens elements disposed at predetermined spacing along optical axis AX is used. The projection magnification of projection optical system PL is, for example, 1/5 (or 1/4) or the like.

Therefore, when illumination light IL from illumination system 12 illuminates illumination area IAR on reticle R, illumination light IL that has passed through reticle R forms a reduced image (a partial inverted image) of a circuit pattern of the illumination area of reticle R on wafer W whose surface is coated with a resist (photosensitive agent), via projection optical system PL.

Wafer stage WST is disposed on a wafer base plate 17 that is disposed below projection optical system PL in FIG. 1, and on wafer stage WST a wafer holder 18 is mounted. On wafer holder 18, wafer W is held by vacuum suction. Wafer holder 18 is configured capable of inclining in an arbitrary direction with respect to a best image-forming plane of projection optical system PL and finely movable in the optical axis AX direction (the Z-axis direction) of projection optical system PL, by a drive section (not shown). Further, a rotation operation around the 2-axis of wafer holder 18 is also possible.

Wafer stage WST has a structure not only movable in the scanning direction (the Y-axis direction) but also movable in the non-scanning direction (the X-axis direction) orthogonal to the scanning direction so that scanning exposure can be performed by relatively moving a plurality of shot areas (divided areas) on wafer W with respect to an exposure area IA, respectively, and a step-and-scan operation is performed in which an operation of performing scanning exposure to each shot area on wafer W and an operation of moving wafer stage WST to an accelerating starting position for exposure of the next shot are repeated. This step-and-scan operation will be described later.

Wafer stage WST is driven in two-dimensional directions, i.e. the X-axis and Y-axis directions by a wafer drive unit 15. Wafer drive unit 15 is configured including three linear motors in total, which are an X-axis linear motor that drives wafer stage WST in the X-axis direction and a pair of Y-axis linear motors that drive wafer stage WST in the Y-axis direction integrally with an X-axis linear guide serving as a stator of the X-axis linear motor. However, in FIG. 2, for the sake of simplification of the drawing, wafer drive unit 15 is shown as a block.

The position of wafer stage WST is measured by a wafer laser interferometer 24. That is, a side surface in an X-axis direction minus side (a -X side) and a side surface in a Y-axis direction minus side (a -Y side) of wafer stage WST are polished to form reflection surfaces. An interferometer beam is irradiated from wafer laser interferometer 24 to these reflection surfaces, and the position of wafer stage WST is constantly detected by wafer laser interferometer 24 at a resolution of, for example, around 0.5 to 1 nm, based on a photoelectric conversion signal of the interference light obtained by making returning lights from the respective reflection surfaces and a returning light from a reference section (not shown) interfere. Incidentally, as wafer laser interferometer 24, in actual an X-axis interferometer that irradiates an interferometer beam to the side surface on the X-axis direction minus side (the -X side) of wafer stage WST and a Y-axss interferometer that irradiates an interferometer beam to the side surface on the Y-axis direction minus side (the -Y side) are arranged. The X-axis interferometer and the Y-axis interferometer are multi-axis interferometers having a plurality of measurement axes respectively, and can measure rotation (including $\theta z$ rotation (yawing), $\theta x$ rotation (pitching) being rotation around an X axis, and $\theta y$ rotation (rolling) being rotation around a Y axis) of wafer stage WST, besides the X position and Y position of wafer stage WST. Further, a plurality of measurement axes in the X-axis direction include a measurement axis that passes through optical axis AX of projection optical system PL and a measurement axis that passes through a detection center of an alignment system ALG, which will be described later. And, at least one of a plurality of measurement axes in the Y-axis direction passes through optical 1 axis AX of projection optical system PL and the detection center of alignment system ALG. With this arrangement, wafer laser interferometer 24 of the embodiment can measure the X and Y positions of wafer stage WST without the so-called Abbe error even at any time in exposure and alignment.

A measurement value of each measurement axis of wafer laser interferometer 24 is sent to stage controller 19 in FIG. 2 and to main controller 20 via stage controller 19, and according to instructions from main controller 20, stage controller 19 controls the position of wafer stage WST. Incidentally, as the interferometer that measures the position of wafer stage WST, a plurality of interferometers are arranged as described above, however, these interferometers are represented by wafer laser interferometer 24 in FIG. 2.

As is shown in FIG. 2, a fiducial mark plate FM is fixed on wafer stage WST so that a surface of fiducial mark plate FM has substantially the same height as a surface of wafer W. On the surface of fiducial mark plate FM, for example, a baseline measurement fiducial mark used to measure a relative positional relation between a position of the detection center of alignment system ALG to be described later and a position of a projected image of a reticle pattern, and other fiducial marks are formed.

Further, in exposure apparatus 200 of the embodiment, as is shown in FIG. 2, alignment system ALG by an off-axis method used to detect a position of an alignment mark (a wafer mark) arranged al ong with each shot area on wafer W is arranged on a side surface of projection optical system PL, more specifically, on a side surface on the -Y side of projection optical system PL. As alignment system ALG, for example, an alignment sensor of FIA (Field Image Alignment) system as disclosed in, for example, Kokai (Japanese Unexamined Patent Application Publication) No. 02-054103, and the corresponding U.S. Patent No. 4,962,318, is used. Alignment system ALG irradiates an illumination light (e.g. a white light) that is a light in the wavelength range to which photoresist coated on wafer W is not photosensitive and has a predetermined wavelength width (e.g. about 500-800nm) to a wafer via an optical fiber, and forms an image of the alignment mark on wafer W and an image of an index mark on an index plate disposed within a plane conjugate with wafer W, on a photodetection plane of an imaging device (such as CCD camera) through a objective lens or the like, and detects the images. In other words, alignment system ALG is a measurement unit by an epi-illumination method. Alignment system ALG outputs the imaging results of the alignment mark (or the fiducial mark on fiducial mark plate FM) to main controller 20. As long as the national laws in designated states (or elected states), to which this international application is applied, permit, the above disclosures of the publication and the U.S. Patent Application Publication or the U.S. Patent are incorporated herein by reference.

In exposure apparatus 200, a multiple focal point position detection system AF by an oblique method is fixed to a holding member (not shown) that supports projection optical system PL. Multiple focal point position detection system AF is constituted by an irradiation optical system $AF_1$ that supplies an image-forming beam (a detection beam FB) for forming a plurality of slit images toward a best image-forming plane of projection optical system PL from an oblique direction with respect to optical axis AX and a photodetection optical system $AF_2$ that severally receives the respective reflected beams of the image-forming beams reflected off the surface of wafer W via a slit. As multiple focal point position detection system AF ($AF_1$, $AF_2$), a multiple focal point position detection system having the configuration similar to the one that is disclosed in, for example, Kokai (Japanese Unexamined Patent Application Publication) No. 06-283403, and the corresponding U.S. Patent No. 5,448,332, and the like is used. The multiple focal point position detection system is used to detect position error in the Z-axis direction with respect to an image-forming plane at a plurality of points on the wafer surface, and to drive wafer holder 18 in the Z-axis direction and inclination directions so that predetermined spacing between wafer W and projection optical system PL is maintained. Wafer position information from multiple focal point position detection system AF is sent to stage controller 19 via main controller 20. Stage controller 19 drives wafer holder 18 in the Z-axis direction and the inclination directions based on the wafer position information. As long as the national laws in designated states (or elected states), to which this international application is applied, permit, the above disclosures of the publication and the U.S. Patent Application Publication or the U.S. Patent are incorporated herein by reference.

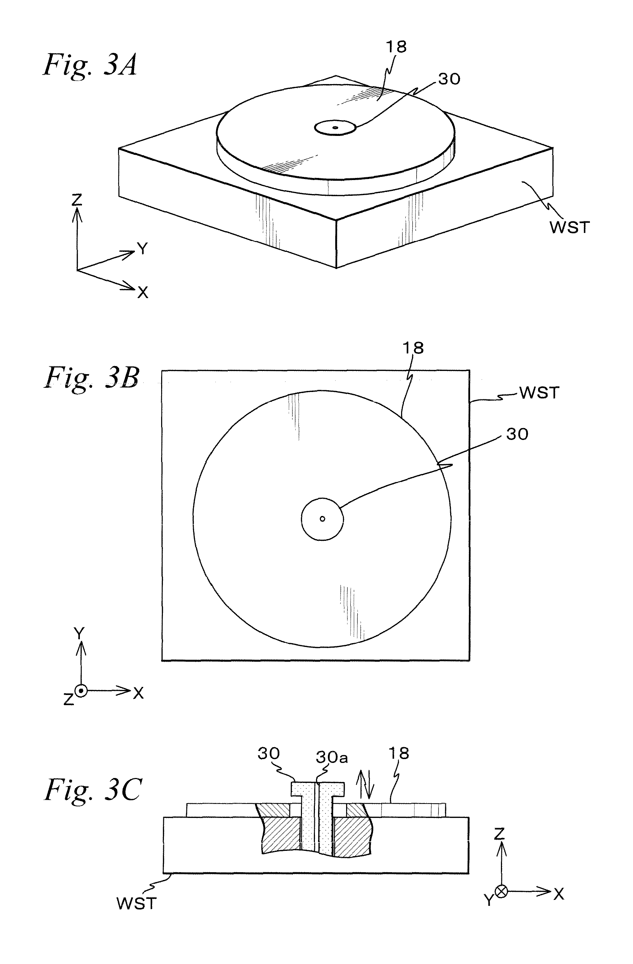

In the vicinity of a center portion of wafer holder 18 mounted on wafer stage WST, a center table 30 is formed as can be seen when viewing FIGS. 3A to 3C together. Center table 30 connects to, for example, a link mechanism (not shown) and the like, and vertically moves, for example, by the link mechanism being driven due to rotation of a cam (not shown) and can protrude and recede with respect to an upper surface of wafer holder 18. The rotation control of the cam is performed by main controller 20 via stage controller 19. Such center table 30 is arranged in order to deliver wafer W in a state where wafer W is spaced-apart from wafer holder 18. The wafer delivery is performed when center table 30 is located at a position that is slightly away from the top dead center (the upper limit) of the cam-link mechanism described above and at which an attitude of center table 30 is most stable. This stable position (which is called as a 'wafer delivery position') is an adjustment value that can be adjusted by a predetermined measurement apparatus, and is measured by the measurement apparatus at the time of start-up of the apparatus or maintenance, and the position is set in the apparatus as the wafer delivery position of center table 30.

In a substantially center portion of a section that is in contact with wafer W of center table 30, an opening 30a is arranged, and opening 30a is communicated with a gas supply/exhaust mechanism (not shown). Further, a peripheral wall is arranged on the circumference of an upper portion of center table 30, though the peripheral wall is not shown in the drawings. When exhaust is performed by the gas supply/exhaust mechanism in a state where wafer W is mounted on center table 30, a space enclosed by wafer W, the upper portion of center table 30 and the peripheral wall is depressurized and wafer W is pressed by atmospheric pressure and is suctioned by vacuum to center table 30. In other words, by performing exhaust by the gas supply/exhaust mechanism while supporting wafer W, center table 30 can hold wafer W by vacuum suction.

Further, though it is not shown in the drawings, on a supporting surface of center table 30 that supports wafer W, multiple pins are disposed spaced-apart a predetermined distance, and wafer W is to be supported by the tips of the multiple pins. Accordingly, even when exhaust is performed by the gas supply/exhaust mechanism described above and wafer W is pressed to center table 30 by outside pressure, wafer W is supported by uniformity power and is not deformed. Incidentally, such pins are also disposed in plural on wafer holder 18, and wafer W is supported by the pins when being mounted on wafer holder 18.

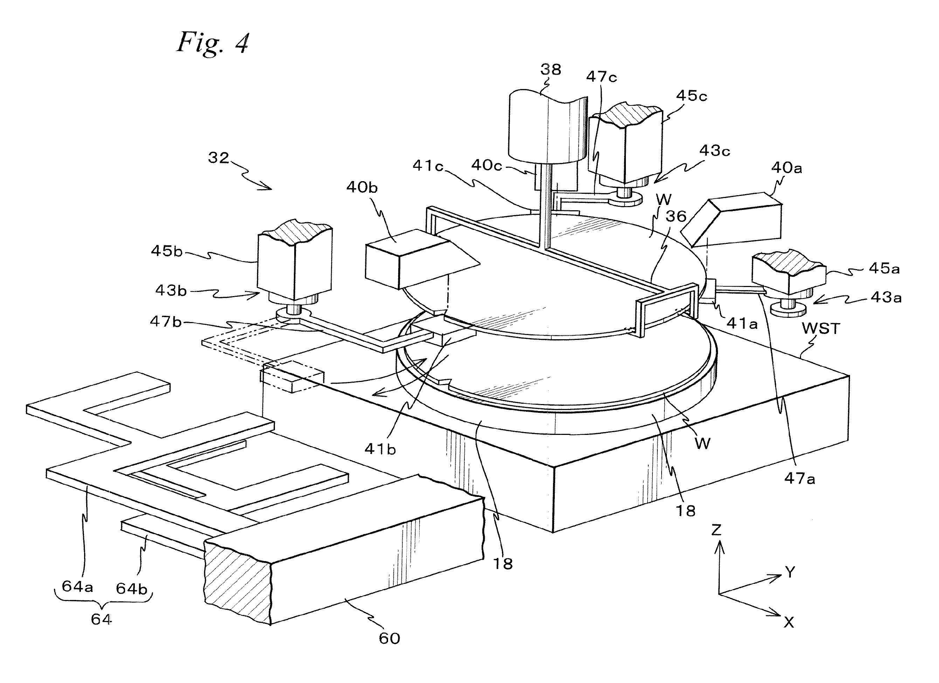

Referring back to FIG. 2, exposure apparatus 200 is further equipped with a wafer pre-alignment unit 32 that is disposed at a wafer load position. Wafer pre-alignment unit 32 is equipped with a pre-alignment unit main body 34, a vertical movement/rotation mechanism 38 that is arranged below pre-alignment unit main body 34 and can be vertically moved and rotated/driven suspending and supporting a wafer loading arm (hereinafter referred to as a 'loading arm') 36, and three measurement units 40a, 40b and 40c that are disposed above loading arm 36. As is shown in FIG. 4, wafer pre-alignment unit 32 is further equipped with background plates 41a, 41b and 41c as three reflection members that are arranged individually corresponding to three measurement units 40a, 40b and 40c, and three background plate drive mechanisms 43a, 43b and 43c that individually drive background plates 41a to 41c.

Each of background plate drive mechanisms 43a to 43c has a motor and is suspended and supported by a part of a body (not shown) of exposure apparatus 200 via supporting member 45a, 45b and 45c respectively. Each of background plates 41a to 41c is attached to a drive shaft (a rotation axis) of background plate drive mechanism 43a to 43c via L-shaped supporting members 47a to 47c respectively. In this case, as is representatively shown in FIG. 4 with respect to background plate 41b, background plate drive mechanisms 43a to 43c rotate and drive background plates 41a to 41c back and forth between a position (a position shown by a solid line) that is irradiated by a light for detection that is irradiated from measurement units 40a, 40b and 40c in the manner to be described later, and a position (a position shown by a two-dot chain line) that is not irradiated by the light for detection from measurement units 40a to 40c. Background plate drive mechanisms 43a to 43c are controlled by stage controller 19 based on instructions from main controller 20.

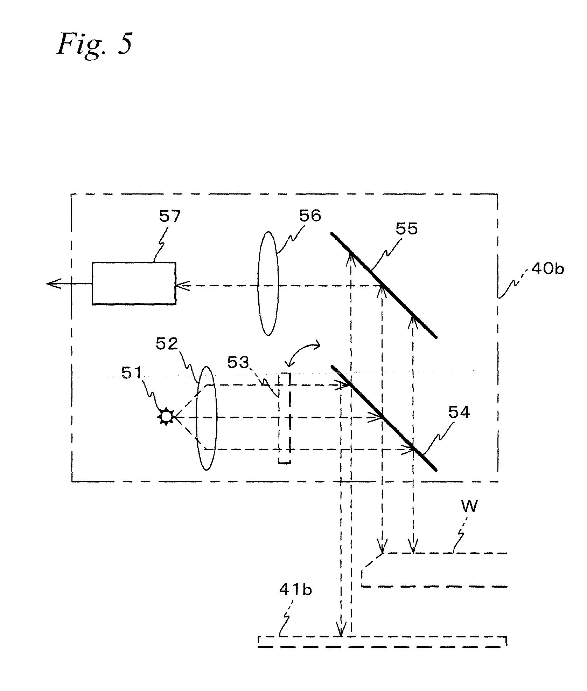

As is representatively shown in FIG. 5 with respect to measurement unit 40b, measurement units 40a to 40c are configured including a light source 51, a collimator lens 52, a diffusion plate 53, a half mirror 54, a mirror 55, an image-forming optical system 56 and an imaging unit 57. Here, respective components of measurement unit 40b will be described along with the operations thereof.

An irradiation light for observation emitted from light source 51 is changed to parallel beams by passing through collimator lens 52. The illuminance of the parallel beams is uniformized by diffusion plate 53. Incidentally, it is possible not to use diffusion plate 53 because diffusion plate 53 can be withdrawn/inserted on an optical path. A part of the parallel beams is refracted downward by half mirror 54 and irradiated to an upper surface (a pattern formation surface) and an upper surface (a pattern formation surface) of background plate 41b (the one that has a low reflectance such as a black ceramic is used).

Such an illumination light for observation is reflected off the upper surface of wafer W and the upper surface of background plate 41b. A part of the reflected beams passes through half mirror 54 and is reflected off mirror 55, and then forms an upper surface image of wafer W and an upper surface image of background plate 41b on a photodetection plane of imaging unit 57 by passing through image-forming optical system 56. Imaging unit 57 picks up the images thus formed on the photodetection plane and sends the imaging results to pre-alignment unit main body 34.

Incidentally, as image-forming optical system 56, an optical system that is telecentric on the object side is used. This is because an image height (a distance from the optical axis to an image point) changes in a commonly-used image-forming system when an object moves in an optical axis direction, however, in the optical system that is telecentric on the object side, an image on an observation plane blurs but the image height does not change.

Meanwhile, when a chief ray inclines, a detection result of an outer edge position of wafer W shifts in accordance with '(a distance between wafer W and background plate 41b) x (the inclination of the chief ray)' (for example, in the case a distance between wafer W and background plate 41b is 2mm and the inclination of the chief ray is 2.5mrad, a detection result of an outer edge position of wafer W shifts by about $5\mu$m). Therefore, adjustment of a telecentric degree of image-forming optical system 56 needs to be performed in accordance with detection accuracy required for the outer edge position detection of wafer W. Incidentally, the similar consideration is needed with regard to the inclination of the background plate. An inclination drive section used to incline background plates 41a to 41c may be arranged at each of movers 47a to 47c.

Further, a depth of focus of image-forming optical system 56 is a depth of focus that is deep to the extent of including the spacing between a surface of wafer W and a surface of background plate 41b. In addition, it is preferable that a focal position and the spacing between an upper surface of wafer W and background plate 41b can be arbitrarily set according to a depth of focus and required detection accuracy. Normally, a focal position is conformed to an upper surface of wafer W.

Inside pre-alignment unit main body 34, a controller is built in that includes a signal processing system that processes signals sent from measurement units 40a, 40b and 40c, a control system of vertical movement/rotation mechanism 38, and the like.

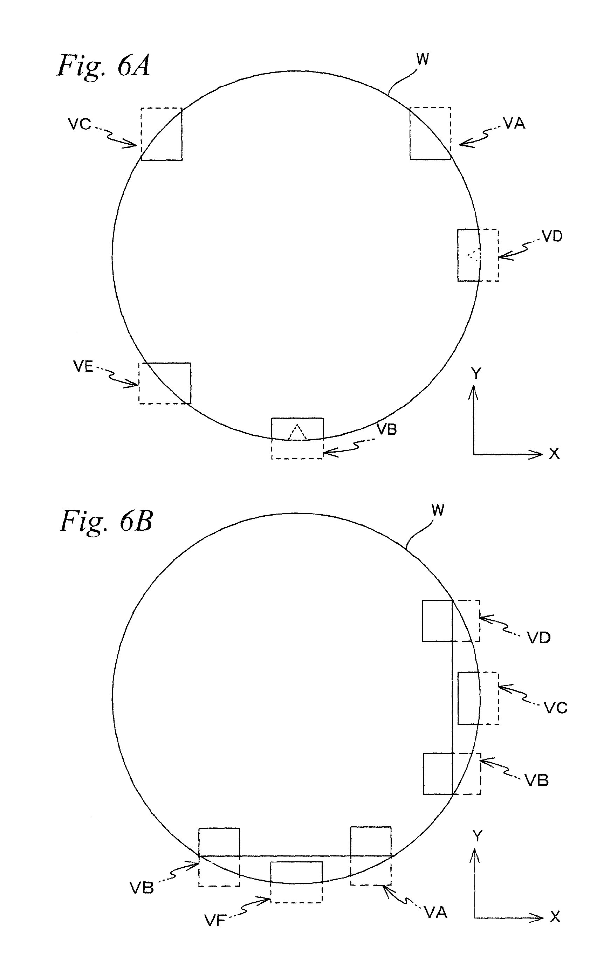

Wafer pre-alignment unit 32 is controlled by stage controller 19 based on instructions from main controller 20, and detects an outer edge (an outer shape) of wafer W that is located at an angle of +45 degrees, 180 degrees and -45 degrees respectively from a + Y direction (the outer edge corresponding to imaging fields VA, VB and VC in FIG. 6A), as at least a part of the outer edge. Then, imaging signals from three measurement units 40a, 40b and 40c are processed by the controller built in pre-alignment unit main body 34, and based on signals from the controller, an X error, a Y error and a θz error of wafer W are obtained by stage controller 19. Stage controller 19 controls vertical movement/rotation mechanism 38 to correct the θz error out of these errors.

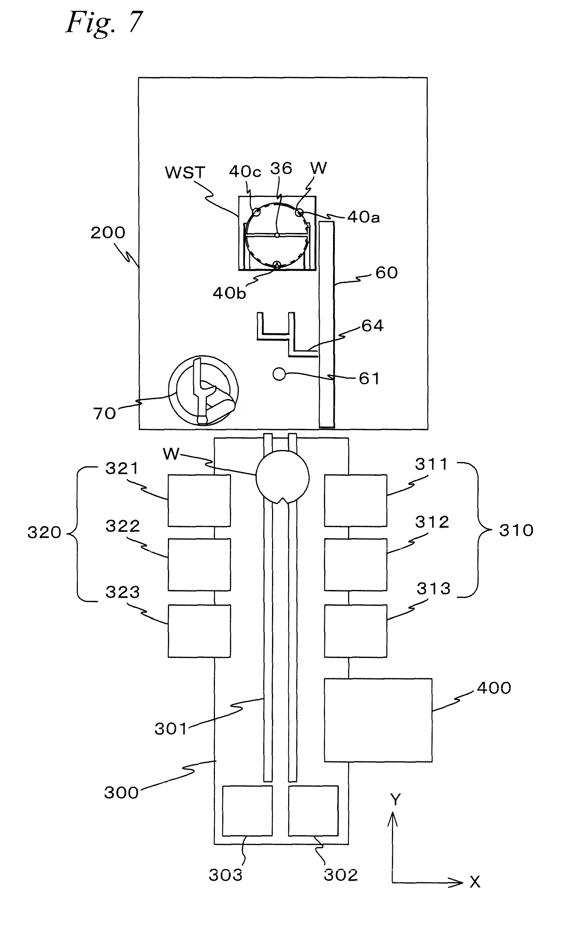

Further, as is shown in FIG. 6A, a position of a notch of wafer W is at a position of measurement unit 40b, that is, the direction of the notch is a -Y direction (at an angle of 180 degrees from the +Y direction) when viewing from a center of wafer W. However, there is also the case wafer W is mounted on wafer holder 18 in a state where the aforementioned direction is rotated by 90 degrees, that is, a state where the notch is located in a +X direction (at an angle of +90 degrees from the +Y direction) when viewing from the center of wafer W. In such a case, as is disclosed in Kokai (Japanese Unexamined Patent Application Publication) No. 09-036202, and the corresponding U.S. Patent No. 6, 225, 012 or No. 6, 400, 445, a measurement unit (having a built-in CCD camera) may be disposed at positions corresponding to both the +X direction and the -Y direction (five measurement units that pick up images of areas VA to VE respectively), or wafer W may be rotated by 90 degrees using vertical movement/rotation mechanism 38 of wafer pre-alignment unit 32 after the outer shape is detected using measurement units 40a, 40b and 40c. Incidentally, in the case measurement is performed by a measurement unit that corresponds to the position of the +X direction, normally the wafer is rotated by 90 degrees beforehand by a table 61 shown in FIG. 7. As long as the national laws in designated states (or elected states), to which this international application is applied, permit, the above disclosures of the publication and the U.S. Patent Application Publication or the U.S. Patent are incorporated herein by reference.

Further, also with respect to a wafer that has an orientation flat (hereinafter shortened to as an 'OF'), there is a case wafer W is mounted on wafer holder 18 in a state where OF is located in the -Y direction (at an angle of 180 degrees from the +Y direction) or the +X direction (at an angle of +90 degrees from the +Y direction) as is shown in FIG. 6B, and accordingly a measurement unit (having a built-in CCD camera) may be disposed at positions corresponding to both the +X direction and the -Y direction (six measurement units that pick up images of areas VA to VF respectively). Incidentally, because the method and the optical arrangement of this operation are substantially similar to the method disclosed in, for example, Kokai (Japanese Unexamined Patent Application Publication) No. 09-036202, the detailed description is omitted here. As long as the national laws in designated states (or elected states), to which this international application is applied, permit, the above disclosure of the publication is incorporated herein by reference.

Incidentally, the X error and the Y error obtained based on the outer shape measurement of wafer W by wafer pre-alignment unit 32 are sent to main controller 20 via stage controller 19. Then, according to instructions from main controller 20, stage controller 19 corrects the X error and the Y error by finely driving wafer stage WST by the amounts corresponding to the X and Y errors, for example, at the time of loading wafer W to wafer holder 18, which will be described later. Alternatively, the correction may also be possible by adding an offset of the X and Y error amounts to a movement amount of wafer stages WST on search alignment, which will be described later. Incidentally, the rotation error that is obtained based on the outer shape measurement of wafer W by wafer pre-alignment unit 32 is corrected by rotating and driving the wafer using rotation mechanism 38 of loading arm 36.

Loading arm 36 has a horizontal member that is horizontally attached to a lower end of a drive shaft that is driven by vertical movement/rotation mechanism 38, an extending section that is fixed to one end (on a +X side) of a longitudinal direction (the X-axis direction) of the horizontal member, and has a predetermined length extending in a direction (the Y-axis direction) orthogonal to the longitudinal direction, a pair of T -shaped hook sections that protrude downward from both ends of the extending section, a hook section that protrudes downward from the other end of the longitudinal direction of the horizontal member. As is shown in FIG. 4, loading arm 36 is structured so that a wafer can be loaded into a space section by wafer transport arm 64 from the -Y direction. Also, loading arm 36 is structured so as to vertically transport wafer W by drive of vertical movement/rotation mechanism 38 in a state where a back surface of wafer W is held by suction via an intake hole of the hook section.

As is shown in FIG. 4, to a wafer transport arm 64, a load arm 64a and an unload arm 64b are separately arranged, and are severally driven by an arm drive mechanisms 60 in predetermined strokes along the Y-axis direction. Arm drive mechanism 60 is equipped with a liner guide that extends in the Y-axis direction and a slide mechanism that moves back and forth in the Y-axis direction along the linear guide. When wafer W is delivered from load arm 64a of wafer transport arm 64 to loading arm 36, the delivery of wafer W is performed by loading arm 36 vertically moving. Further, when wafer W after exposure on wafer stages WST is taken out, wafer W is delivered from center table 30 on wafer stage WST to unload arm 64b of transport arm 64 by the center table 30 vertically moving. These drive mechanisms are controlled by stage controller 19 shown in FIG. 2.

The control system is mainly configured of main controller 20, stage controller 19 under the control of main controller 20, and the like, in FIG. 2. Main controller 20 is configured including the so-called microcomputer (or work station) made up of a CPU (Central Processing Unit), a ROM (Read Only Memory), a RAM (Random Access Memory) and the like, and performs the overall control of exposure apparatus 200 as a whole.

Main controller 20 connects to, for example, an input unit (not shown) such as a keyboard and a display unit (not shown) such a CRT display (or a liquid crystal display). Further, main controller 20 connects to a storage unit 21 used to store apparatus parameters and the like as will be described later. The program and the like that are executed by the CPU of main controller 20 are assumed to be installed in storage unit 21.

[Coating/developing apparatus]

Next, track 300 that each substrate processing apparatus comprises will be described, with reference to FIG. 7. Track 300 is arranged in a chamber that encloses exposure apparatus 200 so that track 300 can connect to exposure apparatus 200 by an inline method. In track 300, a transport line 301 that transports wafer W is arranged so as to cross a center section of track 300. At one end of transport line 301, a wafer carrier 302 that houses multiple wafers W which have not been exposed or to which processing has been performed by a substrate processing apparatus of a previous process, and a wafer carrier 303 that houses multiple wafers W to which an exposure process and a development process have been completed by the present substrate processing apparatus are disposed, and at the other end of transport line 301, a transport opening (not shown) that has a shutter on a side surface of the chamber of exposure apparatus 200 is arranged.

Further, a coater section (a coating section) 310 is arranged along one side of transport line 301 arranged in track 300, a developer section (a development section) 320 is arranged along the other side. Coater section 310 is configured including a resist coater 311 that coats wafer W with photoresist, a prebake unit 312 that is made up of a hot plate used to prebake the photoresist on wafer W, and a cooling unit 313 used to cool down prebaked wafer W.

Developer section 320 is configured comprising a post-bake unit 321 used to bake the photoresist on wafer W after an exposure processing, that is, to perform the so-called PEB (Post-Exposure Bake), a cooling unit 322 used to cool down wafer W after PEB, and a development unit 323 used to perform development of the photoresist of wafer W.

Further, in the embodiment, inline measurement instrument 400 that pre-measures information related to wafer W before transporting the wafer W to exposure apparatus 200 is inline arranged.

Further, in track 300, a measurement apparatus that measures a shape of a pattern (a resist pattern) of the photoresist formed on wafer W that is developed by development unit 323 may be inline arranged. This measurement apparatus is used to measure a shape of a resist pattern (such as a line width of the pattern and an overlay error of the pattern) that is formed on wafer W. However, in the embodiment, from the viewpoint of reducing the apparatus cost, such an error of the pattern shape is to be measured by inline measurement instrument 400.

Incidentally, the configuration and the arrangement of respective units (resist coater 311, prebake unit 312, and cooling unit 313) constituting coater section 310, respective units (post-bake unit 321, cooling unit 322, and development unit 323) constituting developer section 320, and inline measurement instrument 400 are merely examples, and in actual, a plurality of other processing units and buffer units are further arranged, and also respective units are arranged spatially, and robot arms and elevating machines that transport wafer W between respective units are also arranged. Further, the order of processing is not constantly the same, and sometimes the route through which wafer W passes between respective units and is processed is optimized and changed from the viewpoint of processing details of processing units and a speedup of the entire processing time.

Main controller 20, coater section 310 and developer section 320, inline measurement instrument 400 and analytical system 600 that exposure apparatus 200 comprises are connected to each other wired or wireless as is described earlier, and signals that indicate respective processing starts or processing ends are sent/received. Further, detection results that are detected by inline measurement instrument 400 (raw signal waveform data, i.e. data that is the first order output from pre-measurement sensor 410, which will be described later, or data obtained by performing signal processing of the output, which has the equivalent contents to the original imaging data or originally includes information that enables the original image to be restored), measurement results that are obtained by processing the detection results by a predetermined algorithm, or evaluation results that are obtained by evaluating based on the measurement results are sent (notified) to main controller 20 of exposure apparatus 200 directly or via analytical system 600. Main controller 20 stores the sent information in storage unit 21.

In this case, the 'raw signal waveform data' is a measurement signal that is output from a detection sensor such as a CCD comprised in a measurement apparatus that measures a measurement subject, or a signal that is obtained by performing any processing (such as electrical filtering processing) to the measurement signal and substantially has the same contents with the measurement signal.

In exposure apparatus 200, table 61 is disposed almost along an extended line of a center axis of transport line 301 arranged in track 300, and wafer transport arm 64 and the like that transports wafer W to loading arm 36 and the like are disposed on a further +Y side. Further, on the -X side of table 61, a transport robot 70 that can transport holding wafer W at its tip portion is arranged.

Further, sensors that are used to measure the temperature, the humidity and the pressure inside the chamber of exposure apparatus 200 and the temperature, the humidity and the pressure outside the substrate processing apparatus are arranged, and detection signals of these sensors are supplied to main controller 20 and recorded in storage unit 21 a certain period.

[Inline measurement instrument]

Next, the configuration of inline measurement instrument 400 will be described. At least one pre-measurement sensor 410 is arranged corresponding to types of information related to a wafer, that is measurement items. For example, a sensor that measures alignment marks or other marks formed on a wafer, a line width, a shape and a defect of a pattern, a sensor that measures a surface shape (flatness) of a wafer, a focus sensor and the like are exemplified. Plural types of sensors are preferably arranged in order to flexibly cope with the measurement items, a state of a wafer, resolution and others so that the sensors can be selected and used according to the situation. Incidentally, because the similar sensors can be used as measurement sensors of offline measurement instrument 800, the description is omitted. However, as a mater of course, inline measurement instrument 400 and offline measurement instrument 800 in which different measurement methods (including measurement principle) and different measurement items are used may be employed.

In the following description, as an exmpale, inline measurement instrument 400 using a pre-measurement sensor that measures an edge of wafer W and positions of search alignment marks formed on wafer W will be described.

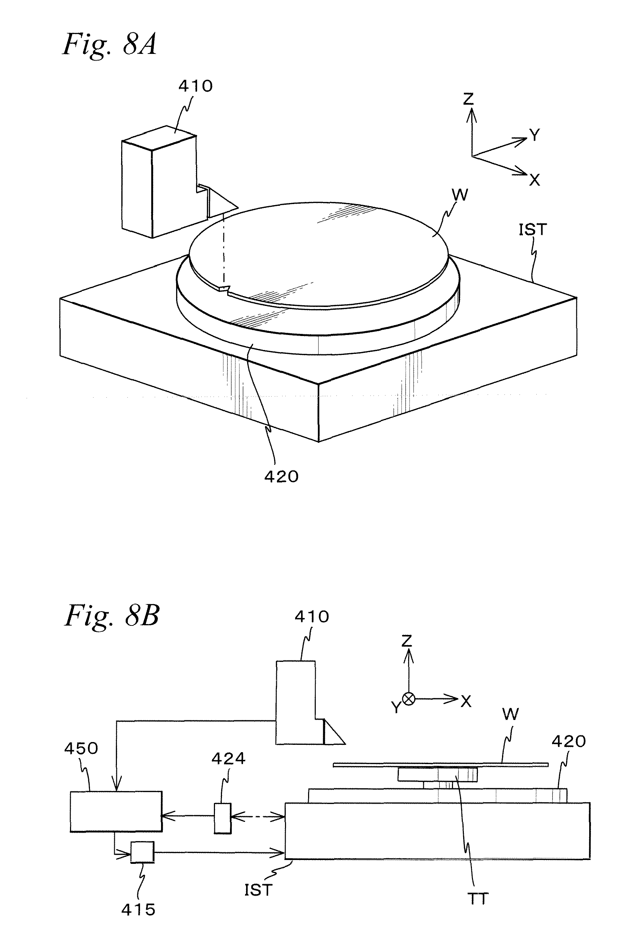

FIGS. 8A and 8B show an example of a schematic configuration of inline measurement instrument 400. As is shown in FIGS. 8A and 8B, inline measurement instrument 400 is configured including a stage unit IST that is movable within the XY plane, pre-measurement sensor 410, a stage drive unit 415, a background plate 420, a laser interferometer system 424 and a pre-measuremtent controller 450.

Stage unit IST is configured including an XY stage and a Z stage, and as is shown in FIG. 8B, the position and the attitude of stage unit IST is adjustable in directions within the XY plane, the Z-axis direction, and inclination directions with respect to the XY plane. Further, as is shown in FIG. 8B, laser interferometer system 424 is arranged to measures a position of stage unit IST in the respective directions. Laser interferometer system 424 has a similar configuration to wafer laser interferometer 24 of exposure apparatus 200, and can measure at least an XY plane position of stage unit IST. In a center portion of stage unit IST, a turntable TT that is rotatable around the rotation axis is arranged, and wafer W can be held by suction on turntable TT. In other words, when wafer W is held on turntable TT, wafer W can be rotated by rotation of the axis of turntable TT. Further, on an upper surface of stage unit IST, discoidal background plate 420 that has a larger diameter than that of wafer W is arranged. When viewing wafer W mounted on turntable TT from above, background plate 420 covers an entire edge of wafer W. Incidentally, as a position measurement system of stage unit IST, a linear encoder system may be used instead of laser interferometer system 424.

Pre-measurement sensor 410 is a sensor that can detect both of at least a part of the edge of wafer W and the positions of alignment marks formed on wafer W, and a sensor that basically has the same configuration as alignment system ALG comprised in exposure apparatus 200 can be used. In other words, pre-measurement sensor 410 is a sensor by an imaging method that illuminates a detection subject by the epi-illumination method and picks up an image of the detection subject using a reflected beam of the illumination.

Incidentally, pre-measurement sensor 410 employs a variable power optical system, and an imaging magnification can be changed in accordance with a detection subject depending on the case the edge of wafer W is detected or the case the marks on wafer W are detected.

Pre-measurement controller 450 performs the overall control of stage unit IST and pre-measurement sensor 410 in pre-measurement. Further, pre-measurement controller 450 receives detection results of pre-measurement sensor 410 and position information of stage unit IST that is detected by laser interferometer system 424 at the time of the detection, and based on the detection results, measures position coordinates of the marks on wafer W in an outer shape reference coordinate system of the wafer. Incidentally, it is needless to say that such position control accuracy of stage unit IST is required to be sufficiently higher with respect to the required accuracy of the detection results of the edge and the marks of wafer W and the like, which are information used to determine the outer shape reference coordinate system of wafer W.

Inline measurement instrument 400 performs pre-measurement (including measurement necessary for optimization of measurement conditions in exposure apparatus 200) with respect to wafer W before being loaded into exposure apparatus 200, with the configuration described above. Pre-measurement results in inline measurement instrument 400 are directly sent to main controller 20 of exposure apparatus 200, or sent to main controller 20 of exposure apparatus 200 via analytical system 600 or in-house production control host system 700, exposure process control controller 500 or the like.

Incidentally, a pre-measurement process by inline measurement instrument 400 can be performed after mark formation of the previous layer on wafer W is completed. The pre-measurement process is performed after wafer W is loaded into track 300, and preferably after coating resist and before loading wafer W into exposure apparatus 200, that is, before pre-alignment processing in exposure apparatus 200. Incidentally, the location where inline measurement instrument 400 is placed is not limited to that in the embodiment, and besides in track 300, for example, may be placed in the chamber of exposure apparatus 200, or another apparatus that is exclusively used for measurement and is independent of theses apparatuses may be arranged and connected by a transport unit. However, in the case inline measurement instrument 400 is placed in track 300, there is the advantage that a dimension shape of an exposure resist pattern can be promptly measured.

[Wafer process]

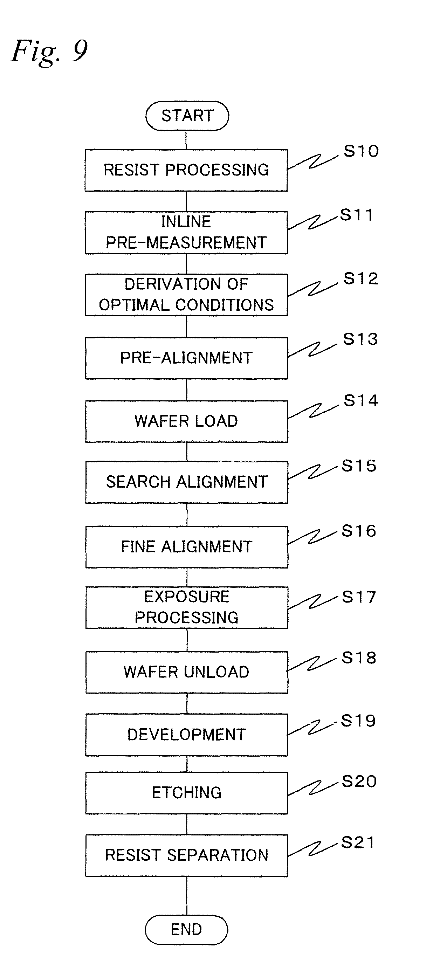

Next, an operation in the case processing is performed to one wafer W included in one lot (a group of a predetermined number of wafers (object group)) in processing system 100 shown in FIG. 1 is described, with reference to the flowchart in FIG. 9. First, when a start order of the processing to wafer W is sent to from in-house production control host system 700 is sent to main controller 20 of exposure apparatus 200 via LAN and exposure process control controller 500, main controller 20, based on the start order of the processing, outputs various types of control signals to exposure apparatus 200, coater section 310, developer section 320 and inline measurement instrument 400 for making them perform the processing to wafer W in predetermined procedures. When the control signals are output, one wafer W that is taken out of wafer carrier 302 is transported to resist coater 311 via transport line 301 and coated with resist, and after resist processing (S10) is performed via prebake unit 312 and cooling unit 313 along transport line 301, wafer W is loaded on the stage unit of inline measurement instrument 400 and inline pre-measurement processing (S11) is performed to wafer W. In this case, though the pre-measurement processing (S11) is performed after the resist processing (S10), the order may be reversed. However, when the pre-measurement processing is performed after the resist coating, the measurement (measurement affected by the resist) can be performed to wafer W in a state where wafer W is actually loaded into the exposure apparatus (i.e. a state where wafer W is coated with resist), which is advantageous from the viewpoint of measurement accuracy.

In the pre-measurement processing (S11) in inline measurement instrument 400, detection of the edge of wafer W and measurement of positions of search alignment marks formed on wafer W are carried out. This measurement will be described later. The measurement results of the pre-measurement processing (such as a center position and a rotation amount of wafer W, and coordinate position information of the marks) are notified, for example, to main controller 20 of exposure apparatus 200 via communication line directly or via analytical system 600, along with raw waveform signal data (imaging data) that is the output of the imaging device of pre-measurement sensor 410. Based on the notified data, main controller 20 performs processing (S12) to optimize measurement conditions used when measuring the edge or the marks of wafer W on alignment in exposure apparatus 200. Incidentally, in order to reduce processing burden of main controller 20, analytical apparatus 600 may be made to implement a part of or all of such optimization processing and to send the analytical results to main controller 20.

After or in parallel with this processing (S12), wafer W to which the pre-measurement processing is completed is transported on transport line 301 to in the vicinity of exposure apparatus 200, and delivered to transport robot 70. Transport robot 70 delivers the received wafer W onto table 61, and table 61 holds wafer W by suction. At this point of time, the position of wafer W in the X-axis direction and the Y-axis direction and the orientation of a notch (or OF) of wafer W are assumed to be roughly adjusted by a positioning unit (not shown). Wafer transport arm 64 turns around to the -Y side of turntable 61 by drive of arm drive mechanism 60, and receives wafer W that is held on table 61. Then, wafer transport arm 64 holding wafer W is driven to a predetermined position (a position where wafer transport arm 64 can deliver wafer W) within the space section of loading arm 36 that awaits at a position above a wafer load position, and wafer W held by wafer transport arm 64 is loaded into the space section of loading arm 36.

In this state, stage controller 19 raises loading arm 36 a predetermined amount by driving vertical movement/ rotation mechanism 38, and when loading arm 36 reaches a predetermined position, stage controller 19 release the suction of wafer W by wafer transport arm 64 at appropriate timing, and then starts the vacuum suction of wafer W by loading arm 36 (vacuum is turned 'ON') at appropriate timing. When loading arm 36 is raised until wafer W is completely supported by loading arm 36, stage controller 19 makes wafer transport arm 64 withdraw to the -Y side. By this operation, the delivery of wafer W from wafer transport arm 64 to loading arm 36 is completed.

When main controller 20 confirms that the delivery of wafer W is completed, for example, based on an output of a sensor (not shown) that detects changes in the pressure within a vacuum suction path that connects to loading arm 36, main controller 20 instructs stage controller 19 to move (insert) background plates 41a to 41c below wafer W.

Main controller 20 confirms that the insertion of background plates 41a to 41c below the wafer is completed, based on the output of the sensor (not shown), and then instructs stage controller 19 to perform pre-alignment measurement of wafer W. Based on the instructions, stage controller 19 starts the outer shape edge measurement of wafer W described earlier using measurement units 40a to 40c that constitute wafer pre-alignment unit 32. That is, in this manner, pre-alignment of wafer W using wafer pre-alignment unit 32 is started (S13).

In the pre-alignment, images of three areas (VA, VB, VC) in the vicinity of the outer edge of wafer W shown in FIG. 6A are picked up by measurement units 40a to 40c respectively. The imaging results are sent to pre-alignment unit main body 34, and pre-alignment unit main body 34 computes a center position and a rotation amount of wafer W that is held by loading arm 36 based on the imaging results and sends them to main controller 20 via stage controller 19.

The computation method of a center position and a rotation amount of wafer W performed by pre-alignment unit main body 34 will be described next.

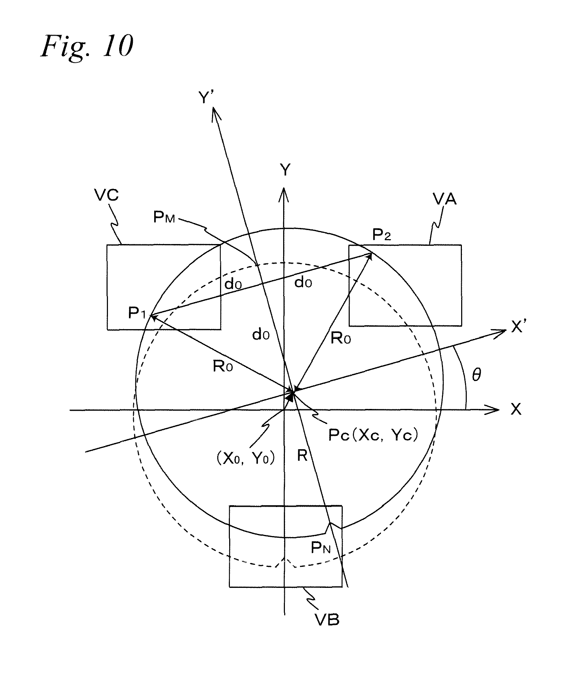

FIG. 10 shows a model of a state of picking up the images. In FIG. 10, wafer W that is held by loading arm 36 according to a design value is shown by a dotted line, and an actual position of wafer W that is held by loading arm 36 is shown in a solid line. Measurement units 40a, 40b and 40c are set to pick up the images of the edges at an angle of +45 degrees, 180 degrees and -45 degrees from the +Y direction when wafer W is located at the position in design (the position shown by a dotted line), and the respective imaging fields are to be VA, VB and VC. In the embodiment, based on imaging results of imaging fields VA to VC, a position $P_N$ of a notch of wafer W is obtained, and other two points (edge points) $P_1(X_1, Y_1)$ and $P_2 (X_2, Y_2)$ of the edges of wafer W are determined based on the notch as a datum, and then a center position and a rotation amount $\theta$ of wafer W are computed from the three points. Incidentally, as a premise, points $P_1$ and are assumed to be points that a distance (to be $2_{d0}$) between the points becomes $2_{d0}=(\sqrt{2}) \cdot R_0$ when a design value of a radius of wafer W is $R_0$ (100mm in the case of an 8-inch wafer). Further, center position $P_C$ is a point that is assumed to be located at a distance $R_0=(\sqrt{2}) \cdot d_0$ from both edges $P_1$ and $P_2$.

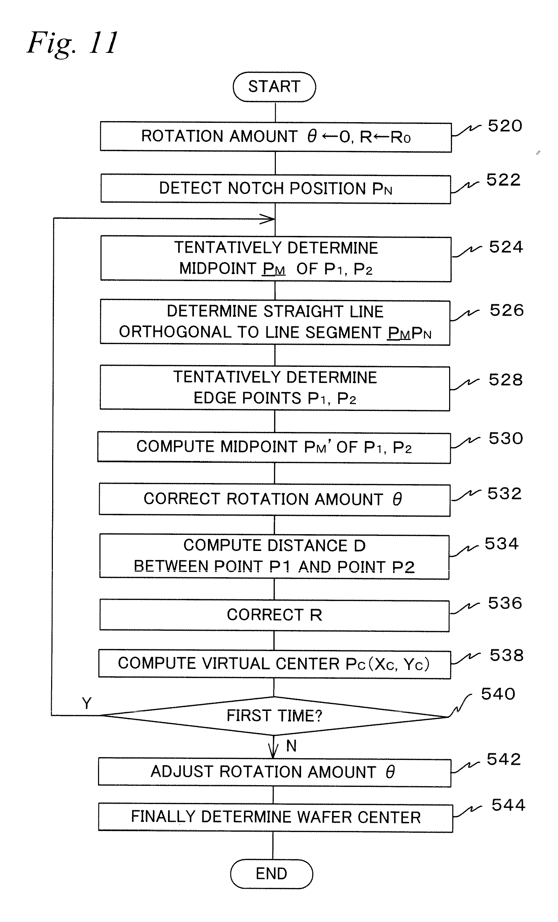

FIG. 11 shows a flowchart of computation processing of center position offset and rotation amount $\theta$ of wafer W. As is shown in FIG. 11, first in step 520, rotation amount $\theta$ of wafer W is initialized to 'zero', and an estimated value R of a distance between a notch center position $P_N$, which will be described later, and $P_C$ is initialized to its design value $R_0$ (=100mm). In the next step, step 522, predetermined image processing is performed to an imaging result VB and notch center position $P_N (X_N, Y_N)$ is detected. In the next step, step 524, an estimated value $\underline{P_M} (\underline{X_M}, \underline{Y_M})$ of a midpoint $P_M (X_M, Y_M)$ of edge points $P_1$ and $P_2$ is obtained using the following equation.

[Equation 1]

$$\left.\begin{array}{l} \underline{X_M} = X_N - (R+d_0) \cdot \sin\theta \\ \underline{Y_M} = Y_N + (R+d_0) \cdot \cos\theta \end{array}\right\} \quad \cdots(1)$$

In the next step, step 526, a straight line L, which passes through midpoint $P_M$, and is perpendicular to a line segment $\underline{P_M}P_N$, expressed in the following equation, is obtained.

[Equation 2]

$$L : (y - \underline{Y_M}) = A \cdot (x - \underline{X_M}) \Big\rbrace$$
$$A = -\frac{(\underline{X_M} - X_N)}{(\underline{Y_M} - Y_N)} \Bigg\rbrace \qquad \cdots (2)$$

In the next step, step 528, based on imaging results VA and VC, positions of intersecting points of straight line L and the edges of wafer W are obtained using predetermined image processing, and each intersecting point is tentatively determined as edge point $P_1$ and $P_2$. In the next step, step 530, a midpoint $P_M$' ($X_M$', $Y_M$') of edge points $P_1$ and $P_2$ is computed using the following equation.

[Equation 3]

$$X_M' = \frac{(X_1 + X_2)}{2} \Bigg\rbrace$$
$$Y_M' = \frac{(Y_1 + Y_2)}{2} \Bigg\rbrace \qquad \cdots (3)$$

In the next step, step 532, from a difference between estimated midpoint $\underline{P_M}$ and midpoint $P_{M'}$, rotation amount θ of wafer W is corrected using the following equation.

[Equation 4]

$$\theta = \theta + (\underline{X_M} - X_M') / R_0 / \sqrt{(1 + A^2)} \qquad \cdots (4)$$

In the next step, step 534, a distance D between edge points and $P_2$ is computed. In the next step, step 536, based on distance D and a difference between distance D and a design value $D_0 = 2d_0$, R is corrected using the following equation.

[Equation 5]

$$R = R + (D - D_0) \cdot \sqrt{(R_0^{\,2} - d_0^{\,2})} / 2d_0 \qquad \cdots (5)$$

In the next step, step 538, a virtual center $P_C(X_C, Y_C)$ is obtained using the following equation.

[Equation 6]

$$X_C = X_N - R \cdot \sin\theta \Big\rbrace$$
$$Y_C = Y_N + R \cdot \cos\theta \Big\rbrace \qquad \cdots (6)$$

In the next step, step 540, the judgment is made of whether or not the number of computation times of virtual center $P_C$ is one. When the judgment is affirmed, the procedure returns to step 524, and when the judgment is denied, the procedure proceeds to step 542. In this case, because this is the first time, the judgment is affirmed and the procedure returns to step 524. Then, after the processing of steps 524 to 538 is performed again, the judgment in step 540 is denied and the procedure proceeds to step 542.

In step 542, loading arm 36 is rotated by -θ so that rotation amount θ of wafer W that is obtained becomes 'zero'. In the next step, step 544, a final position $(X_C', Y_C')$ of the virtual center of wafer W is computed using the following equation.

[Equation 7]

$$
\left.
\begin{aligned}
X_C' &= (X_C - X_0) \cdot \cos\theta + (Y_C - Y_0) \cdot \sin\theta + X_0 \\
Y_C' &= -(X_C - X_0) \cdot \sin\theta + (Y_C - Y_0) \cdot \cos\theta + Y_0
\end{aligned}
\right\} \quad \cdots(7)
$$

In this case, $(X_0, Y_0)$ is a rotation center position of loading arm 36.

As is described above, in the pre-alignment performed by pre-alignment unit 32, based on the imaging results of the outer edge of wafer W by measurement unit 40b, notch position $P_N$ of wafer W is detected first. Notch position $P_N$ becomes a datum point on the outer edge of a surface to be detected of an object. And, using notch position $P_N$ as a datum, other two edge points $P_1$ and $P_2$ on the outer edge of wafer W are detected based on measurement results of other measurement units 40a and 40c, using the calculation method described above. Then, based on notch position $P_N$ and edge points $P_1$ and $P_2$, a center position and a rotation amount of wafer Ware computed. In this manner, in the pre-alignment, an outer shape of a wafer is detected first, and a center position and a rotation amount of wafer W in a coordinate system based on the outer shape as a datum (the outer shape reference coordinate system) are computed. In FIG. 10, a coordinate system set by an X' axis and a Y' axis is the outer shape reference coordinate system. Incidentally, a loop of steps 524 to 540 may be repeated several times.

After the pre-alignment processing is completed, stage controller 19 notifies main controller 20 of information related to the center position, the notch position and the radius of wafer W that are computed by pre-alignment unit main body 34 described above, and also makes background plates 41a to 41c withdraw based on instructions from main controller 20.

Meanwhile, main controller 20 instructs stage controller 19 to move wafer stage WST to a wafer load position. By the instructions, stage controller 19 moves wafer stage WST to the wafer load position via wafer drive unit 15 while monitoring measurement values of wafer laser interferometer 24. With the operation described above, wafer stage WST at the wafer load position and loading arm 36 above the wafer load position come into an overlapping state in a vertical direction. Incidentally, at this point of time, based on information on X and Y errors out of information on X, Y and θz errors of wafer W described earlier, stage controller 19 may set the position of wafer stage WST to a position where the X and Y errors are canceled. Incidentally, at this point of time, in the case the position of wafer stages WST is set according to the design value without taking into consideration the results of the pre-alignment (the offset), the position of wafer stage WST when measuring search alignment marks to be described later may be adjusted based on the information on the X and Y errors. Further, at this point of time, as will be described later, the position of wafer stage WST may be further corrected so that position deviation amounts of the search alignment marks on the outer shape reference coordinate system of wafer W, which are measured in inline measurement instrument 400 (or offline measurement instrument 800), are canceled.

When wafer stage WST reaches the wafer load position, main controller 20 raises center table 30 and also lowers loading arm 36 to a position where wafer W is mounted on center table 30. At this point of time, when loading arm 36 reaches a predetermined position, stage controller 19 makes loading arm 36 release vacuum suction to wafer W, and immediately after that, makes center table 30 start vacuum suction to wafer W at appropriate timing.

Loading arm 36 is continuously lowered until wafer W is supported by only center table 30, that is, until the hook section of loading arm 36 is completely away from wafer W. Afterward, stage controller 19 moves wafer stage WST in the +Y direction when wafer W is in a state completely held by vacuum suction power of center table 30.

Further, stage controller 19 lowers center table 30 until center table 30 goes down into wafer holder 18, and makes wafer holder 18 mount wafer W. At this point of time, when center table 30 reaches a predetermined position, by stage controller 19 releasing the vacuum suction of center table 30 and starting the vacuum suction by wafer holder 18 at appropriate timing, wafer W is held by suction by wafer holder 18. Incidentally, as is described earlier, since the errors of Y, Y and θz of wafer W measured by pre-alignment unit 32 are canceled by the rotation of loading arm 36 and the correction of a position of wafer stage WST described earlier, wafer W is held at a desired position on wafer stage WST. In the mean time, loading arm 36 is raised to the original position.

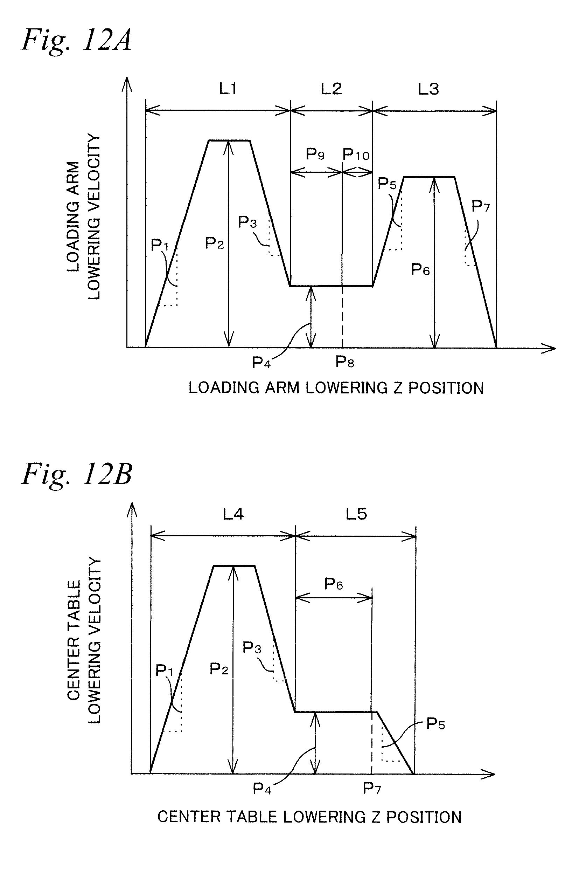

FIG. 12A shows a velocity distribution in the lowering operation of loading arm 36. In FIG. 12A, a horizontal axis shows a position of loading arm 36 in the Z-axis direction when being lowered (which is called as a 'loading arm lowering Z potion'). Incidentally, the right-side direction of the horizontal axis is the -Z direction. As is shown in FIG. 12A, in the lowering operation of loading arm 36, in a certain zone from a starting position of the lowering operation, that is, a zone L1, loading arm 36 is accelerated/decelerated in order to increase a lowering speed of loading arm 36. Further, in a zone including a position where wafer W is delivered to center table 30, that is, a zone L2, loading arm 36 is lowered at a constant low speed in order to deliver wafer W without position deviation. Further, in a zone corresponding a period until a predetermined space is created between loading arm 36 and wafer W, after wafer W is sufficiently away from the hook section of loading arm 36 and is delivered to center table 30 completely, that is, a zone L3, loading arm is lowered while being accelerated/decelerated again. By setting the lowering operation of loading arm 36 in detail in this manner, not only the delivery of wafer W from loading arm 36 to center table 30 can be executed with good accuracy, but also the delivery time can be shortened.

Incidentally, acceleration, velocity and the like that set the acceleration/deceleration described above are adjustable as wafer loading parameters. As is shown in FIG. 12A, as the wafer loading parameters that set the lowering operation of loading arm 36, there are an accelerated velocity $P_1$, a maximum velocity $P_2$ and a decelerated velocity $P_3$ of loading arm 36 in zone L1, a lowering velocity $P_4$ of loading arm 36 in zone L2, an accelerated velocity $P_5$, a maximum velocity $P_6$ and a decelerated velocity $P_7$ of loading arm 36 in zone L3, the sum of a position of loading arm 36 where the vacuum suction of the loading arm is released (vacuum is turned 'OFF') and an offset of the lowering Z position of the loading arm (hereinafter referred to as 'loading arm vacuum off position + loading arm vacuum off position offset') $P_8$, a distance from a position where the deceleration in zone L1 ends to the loading arm vacuum off position, a distance $P_{10}$ from the loading arm vacuum off position to a position where the acceleration starts again in Zone L3, and the like. A length of Zones L1 to L3 is determined by setting values of parameters $P_1$ to $P_{10}$. The following table 1 shows apparatus parameters with respect to the lowering operation of loading arm 36. Incidentally, since the entity of vertical movement/ rotation mechanism 38 that lowers loading arm 36 is a mechanism that is driven by revolution of a motor, as is shown in table 1, the names of parameters relating to the accelerated velocity, the velocity and the decelerated velocity in the lowering operation of loading arm 36 are '-motor revolution accelerated velocity', '--- motor revolution velocity' and '--- motor revolution decelerated velocity'. Further, a measurement tool to measure the loading arm vacuum off position has been provided before, and an optimum loading arm vacuum off position can be measured using the measurement tool. The reason why the parameter name of parameter $P_8$ is the 'loading arm vacuum off position + loading arm vacuum off position offset' in the following table 1 is that the vacuum off position of loading arm 36 is controlled as a position that is obtained by adding a predetermined offset value to a Z position of loading arm 36 at the time when the vacuum of center table 30 is turned 'ON' (at the time when wafer W is suctioned by center table 30 and the vacuum pressure of center table 30 becomes equal to or greater than a predetermined value), and the predetermined off set value serves as a parameter.

[Table 1]

| Parameter No. | Parameter Name | Unit |
|---|---|---|
| $P_1$ | Loading arm motor revolution accelerated velocity before delivery | rpss |
| $P_2$ | Loading arm motor revolution velocity before delivery | rps |
| $P_3$ | Loading arm motor revolution decelerated velocity before delivery | rpss |
| $P_4$ | Loading arm motor revolution velocity on delivery | rps |
| $P_5$ | Loading arm motor revolution accelerated velocity after delivery | rpss |
| $P_6$ | Loading arm motor revolution velocity after delivery | rps |
| $P_7$ | Loading arm motor revolution decelerated velocity after delivery | rpss |
| $P_8$ | Loading arm vacuum off position + loading arm vacuum off position offset | mm |
| $P_9$ | Length of loading arm low velocity area before delivery | mm |
| $P_{10}$ | Length of loading arm low velocity area after delivery | mm |

Incidentally, in the above table 1, the unit of '-revolution velocity' is 'rps' and the unit of '--- revolution accelerated velocity' or '--- revolution decelerated velocity' is 'rpss', and 'rps' means 'revolutions of a motor per second', and 'rpss' means 'a change amount of revolutions of a motor per second'.

Further, FIG. 12B shows a velocity distribution of the lowering operation of center table 30 from when center table 30 receives wafer W until center table 30 delivers wafer W to wafer holder 18. In FIG. 12B, a horizontal axis shows a position of center table 30 in the Z-axis direction when being lowered (which is called as a 'center table lowering Z potion'), and the right-side direction of the horizontal axis is the -Z direction. As is shown in FIG. 12B, in the lowering operation of center table 30, in a certain zone from a starting position of the operation, that is, a zone L4, center table 30 accelerated/decelerated in order to increase a lowering speed of center table 30. Further, in a zone including a position where center table 30 delivers wafer W to wafer holder 18, that is, a zone L5, center table 30 is lowered at a constant low speed in order to deliver wafer W without generating a position deviation of the wafer. By setting the lowering operation of center table 30 in this manner, not only the delivery of wafer W from center table 30 to wafer holder 18 can be executed with good accuracy, but also the delivery time can be shortened.

Further, as parameters that set the lowering operation of center table 30, as is shown in FIG. 12B, there are an accelerated velocity $P_1$, a maximum velocity $P_2$, decelerated velocity $P_3$ of center table 30 in zone L4, a lowering velocity $P_4$ and a decelerated velocity $P_5$ of center table 30 in zone L5, a distance $P_6$ from a position where the deceleration in zone L4 ends to a center table lowering Z position where the vacuum holding of center table 30 is released (hereinafter referred to as a 'center table vacuum off position), and 'center table (CT) vacuum off position + center table (CT) vacuum off position offset' $P_7$. A length of Zone L4 and L5 is determined by setting values of parameters $P_1$ to $P_7$. The following table 2 shows apparatus parameters with respect to the lowering operation of center table 30. Incidentally, since the entity of a drive mechanism that lowers center table 30 is a cam mechanism and a link mechanism that are driven by revolution of a motor, the names of parameters relating to the accelerated velocity, the velocity and the decelerated velocity of center table 30 are expressed as '--- motor revolution accelerated velocity', '--- motor revolution velocity' and '--- motor revolution decelerated velocity' in table 2.

The reason why the parameter name of parameter $P_7$ is the 'CT vacuum off position + CT vacuum off position offset' is the same as the reason why parameter $P_8$ of loading arm 36 is the 'loading arm vacuum off position + loading arm vacuum off position offset' described above, and a relation between 'loading arm 36' and 'center table 30' merely changes to a relation between 'center table 30' and 'wafer holder 18'.

[Table 2]

| Parameter No. | Parameter Name | Unit |
|---|---|---|
| $P_1$ | CT motor revolution accelerated velocity before delivery | rpss |
| $P_2$ | CT motor revolution velocity before delivery | rps |
| $P_3$ | CT motor revolution decelerated velocity before delivery | rpss |
| $P_4$ | CT motor revolution velocity on delivery | rps |
| $P_5$ | CT motor revolution decelerated velocity after delivery | rpss |
| $P_6$ | Length of CT low velocity area before delivery | mm |
| $P_7$ | CT vacuum off position + CT vacuum off position offset | mm |

Respective parameters $P_1$ to $P_{10}$ that set the load operation of a wafer are adjusted to appropriate values before exposure apparatus 200 is actually operated, that is, before an exposure process is executed by performing the transport operation and the exposure operation of the wafer. When the parameters are not appropriately adjusted, for example, the timing of vacuum release between loading arm 36 and center table 30 or the like is not right, and there is a possibility that vibration of wafer W is generated and loading repeatability of wafer W deteriorates. In this manner, the wafer loading parameters described above affect loading repeatability of wafer W. In the case wafer loading repeatability is judged to deteriorate in the loading repeatability measurement processing of the embodiment, which will be described later, the wafer loading parameters described above may be adjusted in the subsequent maintenance.

Incidentally, among the wafer loading parameters, parameter $P_8$ 'loading arm vacuum off position + loading arm vacuum off position offset' of loading arm 36 and parameter $P_7$ 'CT vacuum off position + CT vacuum off position offset' of center table 30 are the most important parameters. Accordingly, only these two parameters may be set to different values with respect to each apparatus, and other parameters may be set to values that are common in apparatuses.

With the operations described above, wafer load (S14) is completed, and an 'exposure preparation complete command' is sent from stage controller 19 to main controller 20. At the time of receiving the 'exposure preparation complete command' and confirming that the wafer exchange described above is completed, main controller 20 instructs stage controller 19 to move wafer stage WST to a wafer alignment starting position. After that, processing shifts to an alignment sequence of wafer W.

Based on the instructions above, stage controller 19 moves wafer stage WST to the wafer alignment starting position along a predetermined route via wafer drive unit 15, while monitoring measurement values of wafer laser interferometer 24. At this point of time, wafer stage WST moves a predetermined distance from a waiting position in the -X direction, that is, moves in a reverse direction along the same route as the time when wafer stage WST moves to the wafer load position.

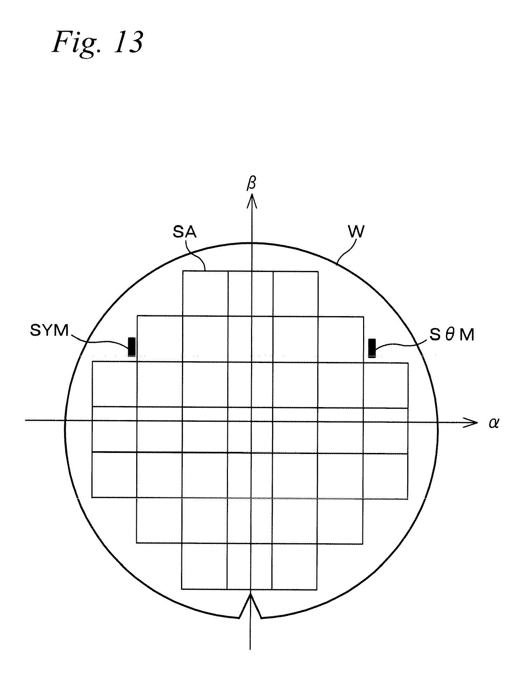

After wafer stage WST moves to the wafer alignment starting position, search alignment is carried out (S15). Incidentally, in this case, the description will be made assuming that exposure of the first layer of wafer W has been completed, and exposure of the second and succeeding layers will be performed. As is shown in FIG. 13, on wafer W, at least two search alignment marks SYM and SθM are to be formed at predetermined positions in a portion other than shot areas SA, besides a circuit pattern in each shot area and an X mark and a Y mark (not shown) as fine alignment marks that are formed on street lines between shot areas SA with respect each shot area SA and used to detect XY position information of the shot area SA. Search alignment marks SYM and SθM are respectively formed at positions at which spacing between the search alignment marks in the X-axis direction is longer and a distance from the respective search alignment marks to the Y-axis direction is longer when viewing from the center position of wafer W, and search alignment marks SYM and SθM are formed on wafer W so that an array coordinate system of a plurality of shot areas SA can be roughly grasped when the formation positions of the search alignment marks can be tentatively obtained.

First, main controller 20 instructs stage controller 19 to move wafer stage WST so that search alignment mark SYM is located within an imaging field of alignment system ALG. Stage controller 19 that has received the instructions moves wafer stage WST via wafer drive unit 15. Incidentally, in the case the position of wafer stag WST has not been corrected based on results of the pre-alignment (information on the X and Y errors) when wafer W has been loaded, the position of wafer stage WST may be corrected at this point of time. Further, as will be described later, the position of wafer stage WST may be further corrected so that a position deviation amount of the search mark in the outer shape reference coordinate system of wafer W, which is measured by inline measurement instrument 400 (or offline measurement instrument 800), is canceled.

Incidentally, after the movement of wafer stage WST is completed, main controller 20 instructs alignment system ALG to pick up an image. According to the instructions, alignment system ALG picks up an image of an area including search alignment mark SYM. The imaging result is sent to main controller 20, and main controller 20 obtains a position $(X_1, Y_1)$ of search alignment mark SYM on the stage coordinate system (the XY coordinate system) based on the imaging result. In the case position correction of wafer stage WST (adjustment of a relative position between alignment system ALG and wafer W) has not been performed yet based on the pre-alignment results and the pre-measurement results of inline measurement instrument 400, the correction can be performed at this point of time. Incidentally, it is preferable that the position of the search alignment mark can be obtained with good accuracy based on image processing using a statistical method, for example, a correlation algorithm such as a template matching, or a waveform processing algorithm in which a waveform is sliced with a predetermined slice level or an edge is extracted by differentiating a waveform.

Incidentally, in the embodiment, in the case the position $(X_1, Y_1)$ of search alignment mark SYM is outside a planned range in this search alignment, main controller 20 judges that wafer W is not loaded in a normal state and pre-alignment (wafer loading) abnormality occurs due to some cause and wafer W is not in a state where exposure processing to wafer W can be normally performed, and main controller 20 displays an search false detection error and suspends the processing (stops the operation of exposure apparatus 200) (a post-loading judgment process). In this case, an operator refers to the error display and performs maintenance to exposure apparatus 200 and ascertains the cause of the error. At this point of time, for example, adjustment of an inclination of the background plate and a telecentric degree of the image-forming optical system, position adjustment of loading arm 36 and the like may be performed in pre-alignment unit 32.

In the case the abnormality is not detected in particular, main controller 20 first instructs stage controller 19 so that search alignment mark SθM is located within the imaging field of alignment system ALG. Stage controller 19 that receives the instructions moves wafer stage WST to a position at which search alignment mark SθM is located within the imaging field of alignment system ALG by driving wafer drive unit 15.

Next, main controller 20 instructs alignment system ALG to pick up an image. According to the instructions, alignment system ALG picks up an image of an area including search alignment mark SθM. Also in this case, position correction of wafer stage WST (adjustment of a relative position between alignment system ALG and wafer W) based on the pre-alignment results and the pre-measurement results of inline measurement instrument 400 can be performed. The imaging result is sent to main controller 20. Main controller 20 computes a position $(X_2, Y_2)$ of search alignment mark SθM on the stage coordinate system using the imaging result similarly to the case when the position of search alignment mark SYM is obtained.

Also in this case, as in the detection of search alignment mark SYM, in the embodiment, in the case the position $(X_2, Y_2)$ of search alignment mark SθM is outside the range set in advance, pre-alignment (wafer loading) abnormality is judged to occur and the processing may be suspended by displaying an error such as a search false detection error on a display unit (not shown) (post-loading judgment process).

Main controller 20 computes a position deviation amount (which is to be $(\Delta X, \Delta Y)$) of the center position and a rotation deviation amount (which is to be $\Delta \theta$) of wafer W with respect to the stage coordinate system based on the

position $(X_1, Y_1)$ of search alignment mark SYM and the position $(X_2, Y_2)$ of search alignment mark SθM that have been obtained. For example, $\Delta\theta$ is obtained from a distance between both marks in design and a position deviation $(Y_1-Y_2)$ in the Y-axis direction, and a position deviation between the center position of wafer W when the $\Delta\theta$ is canceled and the original center position of wafer W becomes a position deviation amount $(\Delta X, \Delta Y, \Delta\theta)$.

Then, main controller 20 sequentially moves wafer stage WST via stage controller 19, and makes alignments system ALG sequentially detect alignment marks (wafer marks) arranged along with specific shot areas (sample shots) set in advance on wafer W, and then obtains positions of the wafer marks (the fine alignment marks) of the sample shots using the detection results (a relative position between each mark and a detection center of alignment system ALG) and a measurement value of wafer laser interferometer 24 at the time of detecting each mark. Based on the obtained positions of the wafer marks, main controller 20 obtains an array coordinate system $\alpha\beta$ shown in FIG. 13 by computing linear errors that are typified by a rotation of the entire wafer, an orthogonality degree, scaling in the X- and Y-directions (magnification errors), and an offset in the X and Y directions, using the statistical computation that is disclosed in, for example, Kokai (Japanese Unexamined Patent Application Publication) No. 61-044429, and the corresponding U.S. Patent No. 4,780,617, and the like, and performs EGA (Enhanced Global Alignment (fine alignment)) to compute array coordinates of the shot areas on wafer W based on the computation results (S16: a detection process). In this case, the X position and the Y position of wafer stage WST at the time of wafer alignment are controlled based on the measurement value of the measurement axis in the Y-axis direction that passes through optical axis AX of projection optical system PL and the detection center of alignment system ALG and the measurement value of the measurement axis in the X-axis direction that passes through the detection center of alignment system ALG. As long as the national laws in designated states (or elected states), to which this international application is applied, permit, the above disclosures of the publication and the U.S. Patent Application Publication or the U.S. Patent are incorporated herein by reference.

Incidentally, at this point of time, results of the search alignment, that is, the position deviation amount $(\Delta X, \Delta Y)$ and the rotation deviation amount $\Delta\theta$ of wafer W are added to a movement position of the wafer stage at the time of detecting the fine alignment marks, and accordingly the fine alignment marks cannot be outside the imaging field of alignment system ALG.

In this case, as is described above, since the measurement axes of wafer laser interferometer 24 that are used for measurement of the X-position and Y position of wafer stage WST have a positional relation with respect to alignment system ALG that does not cause an Abbe error, an error due to yawing (θz rotation) of wafer stage WST does not occur. However, because a height of a surface of wafer W is different from a height of each measurement axis of wafer laser interferometer 24, stage controller 19 obtains a pitching amount and a rolling amount using measurement values of a plurality of measurement axes as is described earlier, and based on these amounts, corrects an Abbe error in the vertical direction that occurs when wafer holder 18 is inclined.

After the foregoing EGA is completed, main controller 20 accurately overlays each shot area on wafer W onto a projection position of a reticle pattern by moving wafer stage WST by the baseline from the position obtained in the EGA, and performs exposure (S17). However, because scanning exposure is performed in exposure apparatus 200, when actual exposure to be described later is performed, the movement of wafer stage WST is movement to a scanning starting position (an acceleration starting position) for exposure of each shot that is deviated in the scanning direction by a predetermined distance from a position of a shot center of wafer stage WST that has moved by the baseline from the position obtained in the EGA.

After exposure is completed, wafer W is unloaded from wafer stage WST using a wafer unloader (not shown) (S18).

As is descried above, before wafer W is loaded into exposure apparatus 200, pre-measurement is performed in inline measurement instrument 400 and the position coordinates of search alignment marks SYM and SθM are obtained in the outer shape reference coordinate system (the X'Y' coordinate system) based on the outer shape of wafer W (S11). Then, based on the detection results and the like of the pre-measurement, measurement conditions of an edge of wafer W in pre-alignment unit 32 and measurement conditions of the search alignment marks in alignment system ALG are optimized (S12). Further, in exposure apparatus 200, under the control of stage controller 19 according to instructions of main controller 20, wafer W is delivered from wafer delivery arm 64 to loading arm 36 of pre-alignment unit 32, and the so-called pre-alignment is performed in which an edge of wafer W is measured by measurement units 40a, 40b and 40c under the optimized measurement conditions, and a center position and a rotation amount of wafer W in a wafer outer shape reference coordinate system based on the measurement results are computed (S13). Then, based on the computation results, wafer W is loaded on wafer holder 18 of wafer stage WST by cooperate operations of wafer stage WST, center table 30 thereof and the like (S14). Further, after the search alignment processing (S15) including the mark measurement under the optimized measurement conditions and the fine alignment processing (S16), and the like are carried out, a pattern of a reticle is transferred to each shot area on the wafer W (S17).

Incidentally, in the search alignment processing, adjustment of the relative position of wafer stage WST and alignment system ALG needs to be performed so that search alignment marks SYM and SθM are located within the imaging field of alignment system ALG. In the embodiment, a target position of wafer stage WST at this point of time is determined taking into consideration not only the design positions of the search alignment marks when using the outer shape reference coordinate system based on the center position and the rotation amount of wafer W detected in the pre-alignment as a datum, but also the actually measured position coordinates of the search alignment marks in the outer shape reference coordinate system of wafer W that have been pre-measured in inline measurement instrument 400, as will be described later.

Such adjustment of the relative position of wafer stage WST and alignment system ALG may be performed at the time of loading the wafer in S14. in other words, since alignment system ALG is fixed, the position of wafer stage WST when wafer W is loaded may be deviated by the position deviation amount described above that has been pre-measured in inline measurement instrument 400.

Meanwhile, after wafer W that has been unloaded from wafer stage WST is transported by the wafer unloader and an unload robot (not shown) to transport line 301 of track 300, wafer W is sent along transport line 300 sequentially to post-bake unit 321, cooling unit 322 and development unit 323. Then, in development unit 323, a resist pattern image corresponding to a device pattern of a reticle is developed on each shot area of wafer W (S19). With respect to wafer W to which the development is completed, a line width, an overlay error and the like of the formed pattern are inspected as needed by inline measurement instrument 400 or another measurement apparatus in the case the measurement apparatus is separately arranged, and wafer W is placed within wafer carrier 303 by transport line 301.

After that, wafer W housed in wafer carrier 303 is transported to other processing apparatuses, and etching (S20, scraping off the section that is not protected by resist), resist separation (S21, separating the resist that has become unnecessary) and the like are performed. By repeatedly performing the processing of S10 to S21 described above, multiple circuit patterns are formed on, for example, wafers of one lot housed in wafer carrier 302.

Incidentally, in the above description, the pre-measurement to wafer W is performed by inline measurement instrument 400 arranged in track 300, but the pre-measurement may be performed by offline measurement instrument 800. However, to use inline measurement instrument 400 in track 300 for the pre-measurement makes it possible to perform the pre-measurement immediately after the resist processing, and therefore, it can be said that it is advantageous in terms of throughput to use inline measurement instrument 400.

The wafer process processing described above is performed in each substrate processing apparatus, and each substrate processing apparatus is overall controlled by exposure process control controller 500. Exposure process control controller 500 stores various types of information and various parameters that are used to control processes concerning each lot or each wafer to be processed in processing system 100, and various types of information such as exposure history data in a storage unit that is attached to exposure process control controller 500. And, based on these various types of information, each exposure apparatus 200 is controlled so that appropriate processing is implemented to each lot. Further, exposure process control controller 500 obtains alignment conditions (various conditions used when performing alignment measurement (such as the number and an arrangement of sample shots, whether a method is a multipoint method or one point method in a shot, and algorithm used when performing signal processing)) used for alignment processing in each exposure apparatus 200, and registers them in each exposure apparatus 200. Exposure process control controller 500 also stores various types of data such as the EGA log data measured in exposure apparatus 200, and appropriately controls each exposure apparatus 200 based on the data.

Further, analytical system 600 is an apparatus that operates independently of exposure apparatus 200, track 300, the light source of exposure apparatus 200, inline measurement instrument 400, offline measurement instrument 800 and the like, and analytical system 600 collects various types of data from each of these apparatuses via network and analyzes the data.

[Pipeline processing]

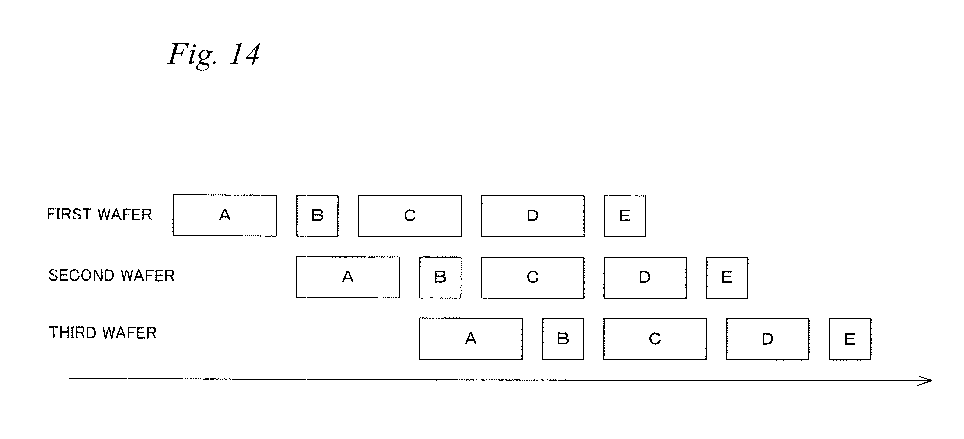

Although it is undeniable that the wafer process processing is delayed due to adding the inline pre-measurement process by inline measurement instrument 400 described above, the delay can be suppressed by applying pipeline processing as described below. The pipeline processing will be described with reference to FIG. 14.

Since the inline pre-measurement process is added, the wafer process processing consists of five processes, i.e. resist processing process A to form a resist film, pre-measurement process B by inline measurement instrument 400, exposure process C to perform alignment and exposure, development process D to perform heat treatment and development after exposure, and in the case of performing measurement of a resist pattern, pattern dimension measurement process E. In these five processes, the pipeline processing in which several wafers W (three wafers in FIG. 14) are processed in parallel is performed. To be specific, by performing pre-measurement process B of wafer W in parallel with exposure process C of the preceding wafer, the influence given on the entire throughput can be suppressed to an extremely small level.

Further, in the case resist dimension measurement process E is carried out after implementing development process D, since pre-measurement process B and resist dimension measurement process E are performed pipeline-wise in inline measurement instrument 400 at the timing so that both processes do not overlap with each other, the apparatus cost can be reduced since a resist dimension measurement apparatus does not need to be separately arranged, and also the throughput is hardly affected adversely.

Incidentally, the pipeline processing shown in FIG. 14 is merely an example, and it is a matter of course that the processes may be scheduled so that while exposure of the preceding wafer is being performed, the pre-alignment of wafer W is performed.

[Inline pre-measurement processing and optimization processing]

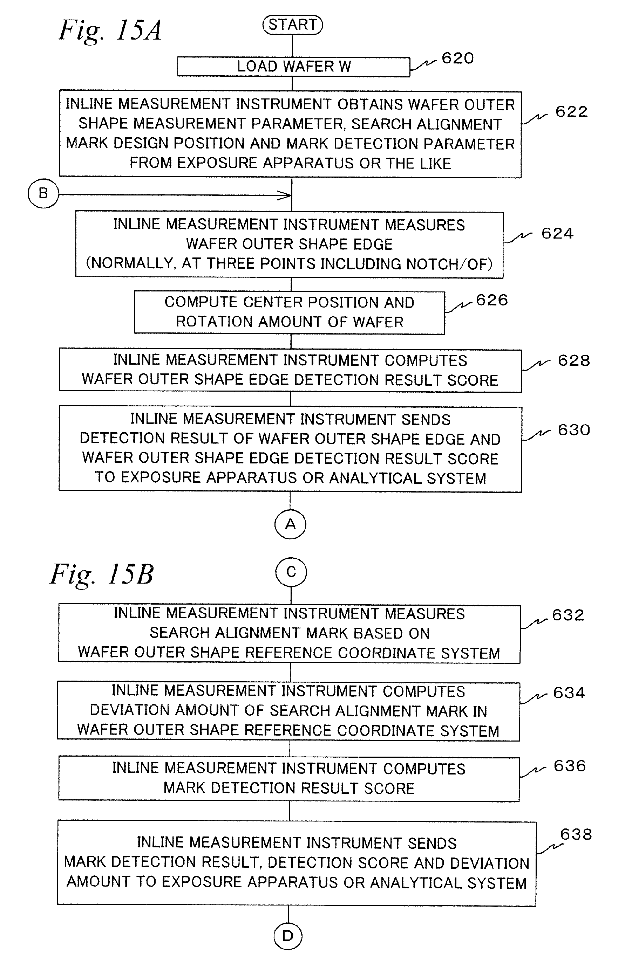

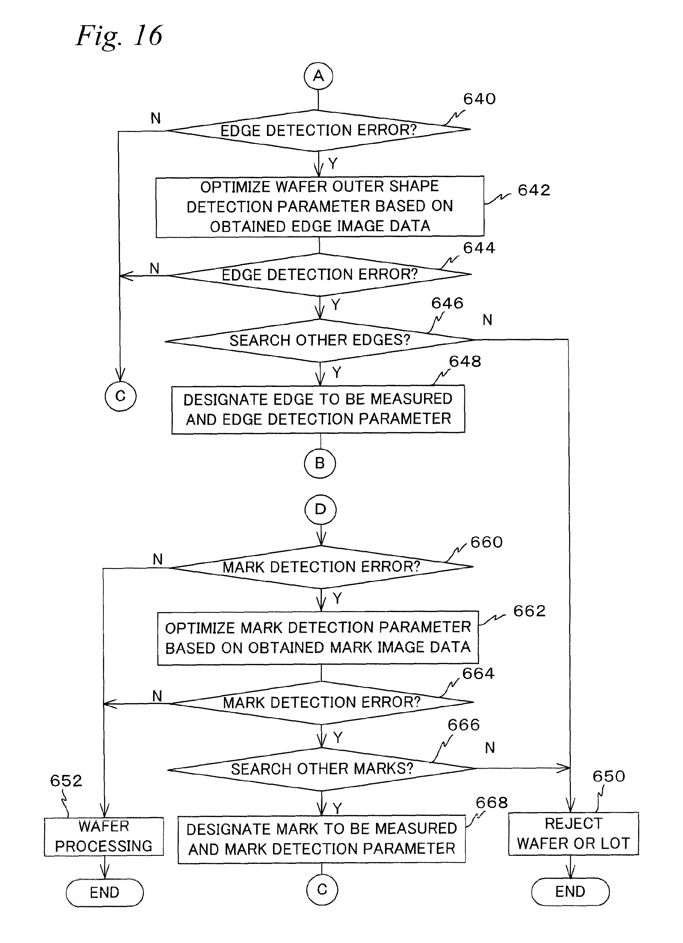

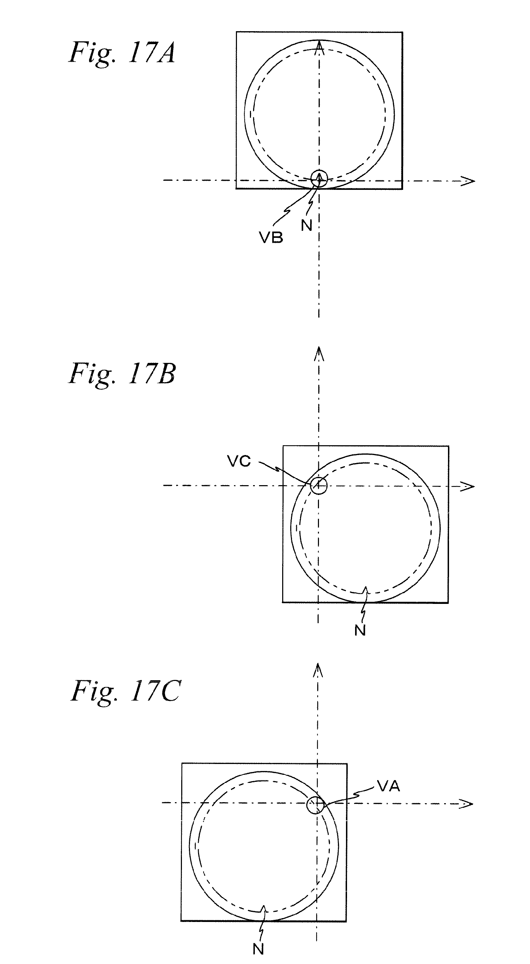

Next, a series of processing, which includes the pre-measurement processing (S11) in inline measurement instrument 400 and the alignment optimization processing (S12) by the inline pre-measurement that are implemented before wafer W is loaded into exposure apparatus 200 in the wafer process processing described above, will be described in more detail. FIGS. 15A, 15B and 16 respectively show a flowchart showing the series of operations. First, as shown in FIG. 15A, in step 620, wafer W is loaded on turntable TT of stage unit IST by a transport robot (not shown). Then, in the next step, step 622, through communication with exposure apparatus 200, analytical system 600 or in-house production control hose system 700, inline measurement instrument 400 obtains wafer outer shape measurement parameters such as a wafer size (12 inch/8 inch/6 inch) of wafer W that is subject to exposure, a wafer type (notch/OF), and a wafer loading direction (an angle of 180 degrees/+90 degrees from the +Y direction), design position information of search alignment marks to be measured in exposure apparatus 200 (alignment system ALG), and mark detection parameters (parameters related to types of algorithms used to measure marks and processing algorithm of selected signal waveforms, such as slice level). Next, in step 624, pre-measurement controller 450 of inline measurement instrument 400 measures an outer edge (normally, three points including a notch/OF portion) of wafer W held on turntable TT, based on the obtained wafer outer shape measurement parameters. For example, in the case the wafer outer shape measurement parameters are set to '8 inch', 'notch' and '180 degrees from the +Y direction)', as is shown in FIGS. 17A, 17B and 17C, an image near the edge of wafer W is picked up, while sequentially setting a position of the edge at an angle of -45 degrees, 180 degrees, and +45 degrees from the +Y direction within a measurement field of pre-measurement sensor 410 by moving stage unit IST via stage drive unit 415. With this operation, imaging data corresponding to imaging areas VA to VC (which are to be imaging data VA to VC) shown in FIG. 6A is obtained (The reference mark 'N' in FIGS. 17A, 17B and 17C is a notch position).

In the next step, step 626, pre-measurement controller 450 computes a center position and a rotation amount of wafer W based on imaging data VA, VB and VC as imaging results or on data that is obtained by performing signal processing of the imaging data. Since the computation method is similar to the computation method of center position and a rotation amount of wafer W in pre-alignment unit 32 shown by the flowchart in FIG. 11, the description is omitted. In this case, based on the obtained center position and rotation amount of wafer W, an outer shape reference coordinate system of wafer W is determined.

In the next step, step 628, pre-measurement controller 450 of inline measurement instrument 400 evaluates detection results of a part of the edges of wafer W, that is, imaging data VA, VB and VC or the data obtained by performing signal processing of the imaging data, according to a predetermined evaluation criterion. In this case, the evaluation is performed in a score form. In other words, a score (hereinafter referred to as an 'edge detection result score') of a detection result that shows a level of the evaluation is computed, and the detection result is evaluated using the score (an evaluation process). Incidentally, the edge detection result score will be described later.

In the next step, step 630, pre-measurement controller 450 of inline measurement instrument 400 sends the wafer outer shape edge detection result (OK/NG), the edge detection result scores and the like to main controller 20 of exposure apparatus 200 or analytical system 600. That is, in the case the edge detection result score is better than a threshold value determined in advance, pre-measurement controller 450 sends information (OK) indicating that the edge is appropriate as a mark to be measured in exposure apparatus 200 to exposure apparatus 200 (or analytical system 600), and in the case the edge detection result score is worse than a threshold value determined in advance, pre-measurement controller 450 sends information (NG) indicating that the edge is inappropriate to be measured in exposure apparatus 200 to exposure apparatus 200 (or analytical system 600).

Incidentally, in the case the score is worse than the threshold value, raw signal waveform data (imaging data) that is judged to be NG may be sent to exposure apparatus 200 (or analytical system 600) along with the score and the NG information. Incidentally, in principle, it is preferable that imaging data of all edges measured in inline measurement instrument 400 are sent to exposure apparatus 200, however, a communication period of time is longer due to sending the imaging data of all edges, which brings about the possibility of reducing the throughput, and also a receiving side of the imaging data has a burden of preparing a large capacity storage media. Therefore, in the embodiment, the imaging data concerning only the edges that are judged to be inappropriate is preferably sent.

Next, in response to sending of the information in the above step 630, main controller 20 of exposure apparatus 200, which receives the sent information in the above step 630, judges whether or not there is an edge of wafer W that is an edge detection error (NG) in step 640 of FIG. 16. With this operation, the judgment can be made of whether or not detection of the edges of wafer W has been normally performed based on the edge detection result score in inline measurement instrument 400 or the like. Step 640 needs to be performed at least before the pre-alignment. When the judgment is affirmed, the procedure proceeds to step 642, and optimization processing of the wafer outer shape measurement parameters is executed based on at least one of the raw signal waveform data in the case the detection result of the edges of wafer W (the raw signal waveform data) has been sent, and the edge detection score as the evaluation result that has been sent from inline measurement instrument 400 in the case the raw signal waveform data has not been sent. Incidentally, in the case the raw signal waveform data of the edges has not been sent, the data may be newly obtained from inline measurement instrument 400 and the optimization processing may be executed based on the data.

In the optimization processing, measurement repeatability ($3\sigma$ of a wafer center XY, $3\sigma$ of a wafer rotation amount $\theta$) in the pre-alignment measurement in pre-alignment unit 32 is used as an evaluation scale. The optimization processing is performed by, for example, comparing the obtained detection result of the edges of wafer W and the detection result of the edges of wafer W that have been logged in storage unit 21, and deriving optimal values of the wafer outer shape measurement parameters, that is, measurement conditions of the wafer outer shape (illumination conditions of pre-measurement sensor 410 (such as voltage adjustment value (illumination intensity) of LED as a light source, a illumination wavelength of an illumination light for measurement used in pre-measurement sensor 410, an incident angle (an illumination angle), a dark field, and a bright field), the number of screens of repeated measurement of the same edge, an imaging magnification of pre-measurement sensor 410, an edge measurement algorithm, and the like).

Incidentally, the optimization processing of the wafer outer shape measurement parameters may be performed by pre-measurement controller 450 of inline measurement instrument 400. In the case the judgment in step 640 is denied, that is, in the case there is no edge detection error, the procedure proceeds to step 632 (FIG. 15B).

After executing the optimization processing of the wafer outer shape measurement parameters in step 642, in step 644, the judgment is made of whether or not there is an edge detection error as a result of performing edge detection again, and when the judgment is denied, the procedure proceeds to step 632 (FIG. 15B). It can be said that step 644 is a process in which the detection result of the edges of the wafer is re-evaluated after the optimization, and based on the re-evaluation result, the judgment is made of whether or not exposure can be normally performed to the wafer (a post-optimization judgment process).

Meanwhile, when the judgment is affirmed in step 644, in step 646, the judgment is made of whether or not to search other wafer outer shape edge positions except for the notch (or OF) position, according to set priority order.

In the case the judgment is made that other edges of wafer W should be searched for in step 646, main controller 20 designates positions of other edges to be additionally measured and the wafer outer shape measurement parameters, and notifies inline measurement instrument 400. Then the procedure returns to step 624 in FIG. 15A, and the wafer edge measurement is performed again.

Meanwhile, in the case other edges are not searched for and the judgment is denied in step 646, the procedure proceeds to step 650, the wafer W is rejected (excluded from processing processes) without transporting the wafer into exposure apparatus 200. Incidentally, in step 650, in the case the number of rejected wafers W exceeds the number (a predetermined number) that is set in advance, all wafers W in the lot including the rejected wafers W are rejected.

On the other hand, when the judgment is denied in step 640 or step 644, the procedure proceeds to step 632 in FIG. 15B. In step 632, inline measurement instrument 400 (pre-measurement controller 450) moves stage unit IST via stage drive unit 415, and estimates rough positions of search alignment marks SYM and S$\theta$M from a coordinate system that is set by the center position and the rotation amount of wafer W that have been obtained from the outer shape of the wafer in the above step 626 and design position coordinates of search alignment marks SYM and S$\theta$M, and then detects search alignment marks SYM and S$\theta$M while sequentially setting the position of stage unit IST so that the search alignment marks of wafer W are located within a detection field of pre-measurement sensor 410. In step 634, inline measurement instrument 400 (pre-measurement controller 450) measures position coordinates of the search alignment marks in the outer shape reference coordinate system using the detection results, and computes position deviation amounts of the search alignment marks in the outer shape reference coordinate system from the design position coordinates using the measurement results. Incidentally, since imaging data obtained with high magnification is necessary as the detection results in order to accurately measure the positions of search alignment marks SYM and S$\theta$M, prior to detection of search alignment marks SYM and S$\theta$M, pre-measurement controller 450 needs to adjust the imaging magnification to higher than that at the time of edge detection by adjusting a variable power optical system that pre-measurement sensor 410 comprises.

In the next step, step 636, pre-measurement controller 450 of inline measurement instrument 400 evaluates the suitability of the search alignment marks SYM and S$\theta$M as the marks to be detected in exposure apparatus 200 according to a predetermined evaluation criterion, based on the imaging data of search alignment marks SYM and S$\theta$M output from pre-measurement sensor 410 or data obtained by performing signal processing of the imaging data, and computes a score (hereinafter called as a 'mark detection score') that indicates a level of the evaluation in a score form. In the embodiment, the evaluation and the computation of the score are performed in pre-measurement controller 450. However, in the case all the pre-measurement results are sent to analytical system 600 or exposure apparatus 200 (main controller 20), the receiving side (main controller 20 or analytical system 600) may perform the evaluation and the score computation. Incidentally, the mark detection score will be described later.

In the next step, step 638, inline measurement instrument 400 sends the deviation amounts of search alignment marks SYM and SθM, the detection results (OK/NG) of search alignment marks SYM and SθM, and the mark detection result score to exposure apparatus 200 or analytical system 600. In other words, in the case the mark detection result score is better than a threshold value determined in advance, inline measurement instrument 400 sends information (OK) indicating that the mark is appropriate as a mark to be measured in exposure apparatus 200, and in the case the sore is worse than a threshold value determined in advance, inline measurement instrument 400 sends the score and information (NG) indicating that the mark is inappropriate as a mark to be measured in exposure apparatus 200. Incidentally, in the case the score is worse than the threshold value, raw signal waveform data (imaging data) of the mark signal may be sent along with the score and NG information. In the embodiment, the measured mark raw waveform signal data concerning only the mark that is judged to be inappropriate or the mark (the measurement error mark) that is judged to be impossible to be measured is sent.

Incidentally, in the embodiment, pre-measurement controller 450 may be configured so as to perform a control operation in which the judgment is made of whether or not to send the information described above. The information and information to be described later that is notified from inline measurement instrument 400 to exposure apparatus 200 may be notified to exposure apparatus 200 via analytical system 600. However, in order to simplify the description, in the following description, the information is to be notified directly to exposure apparatus 200. Incidentally, in the case the information is notified to exposure apparatus 200 via analytical system 600, analytical system 600 may be made to perform a part of processing or whole processing to be performed by exposure apparatus 200 and to send the results to exposure apparatus 200.

Further, a configuration may be employed in which information of analytical system 600 is sent to exposure apparatus 200 via in-house production control host system 700 and exposure process control controller 500.

Next, in step 660, in response to sending of the information in the above step 638, main controller 20 of exposure apparatus 200 that receives the information judges whether or not the number of mark detection errors (NG) is equal to or greater than a set permissible number, and in the case the number of mark detection errors is equal to or greater than the set permissible number, executes optimization processing of the mark detection parameters based on the raw signal waveform data in the case the raw signal waveform data of the marks have been sent, or in the case the raw signal waveform data have not been sent, main controller 20 obtains imaging data (raw signal waveform data) of the marks with respect to all of or a part of the relevant marks from inline measurement instrument 400, and executes the optimization processing of the mark detection parameters in step 662. Incidentally, the optimization processing of the mark detection parameters may be performed by pre-measurement controller 450 of inline measurement instrument 400. In step 660, in the case the number of mark detection errors does not reach the set permissible number and the judgment is denied, the procedure proceeds to wafer processing in step 652.

After executing the optimization processing of the mark detection parameters in step 662, as a result of detecting the marks again, in the case the number of mark detection errors does not reach the set permissible number and the judgment is denied in step 664, the procedure proceeds to the wafer processing in step 652, and in the case the judgment is affirmed, the procedure proceeds to step 666 that is performed after execution of the optimization of the mark detection parameters, and based on information registered in advance, the judgment is made of whether or not to search other marks according to priority order set in advance with respect to design coordinate positions of other marks within a search area designated in advance. Incidentally, in the embodiment, only two search alignment marks SYM and SθM are used, however, multiple marks that become potential search alignment marks are formed on wafer W in actual, and in this case, other marks are selected from among the potential marks.

In the case the judgment is made that other mark positions should be searched for in step 666, in step 668 exposure apparatus 200 designates positions of other alignment marks to be additionally measured and the mark detection parameters, and notifies inline measurement instrument 400, then the procedure returns to step 632 in FIG. 15B and the pre-measurement processing of the marks is repeated.

Meanwhile, in step 666, in the case there are still the mark detection errors that is equal to or greater than the permissible number set in advance, though all the marks (the potential marks of the measurement subject) within the area set in advance are measured, the procedure proceeds to step 650, in which the wafer W is rejected (excluded from processing processes) without transporting the wafer W into exposure apparatus 200. Further, in step 650, in the case the number of rejected wafers W exceeds the number set in advance, all wafers W of a lot including the rejected wafers W are rejected.

Incidentally, the conditions under which the reject processing of wafer W is performed are not limited to the conditions described above. In the case the judgment is made that it is not preferable to further carry out pattern exposure processing (a favorable device cannot be obtained) based on all results (not only the edges of wafer W and position information of the marks on wafer W, but also a predicted wafer deformation amount based on a focus error, a pattern line width, pattern defect, the temperature variation within the apparatus) of pre-measurement performed by inline measurement instrument 400 and the like, the reject processing of a wafer may be performed similarly to the embodiment.

When the procedure proceeds to step 652 that is performed after the judgment in step 660 or step 664 is denied, S11 (inline pre-measurement) and S12 (derivation of optimal conditions) in FIG. 9 are to be completed. The wafer processing in step 652 corresponds to steps S13 (pre-alignment) to S17 (exposure) of the wafer process in FIG. 9.

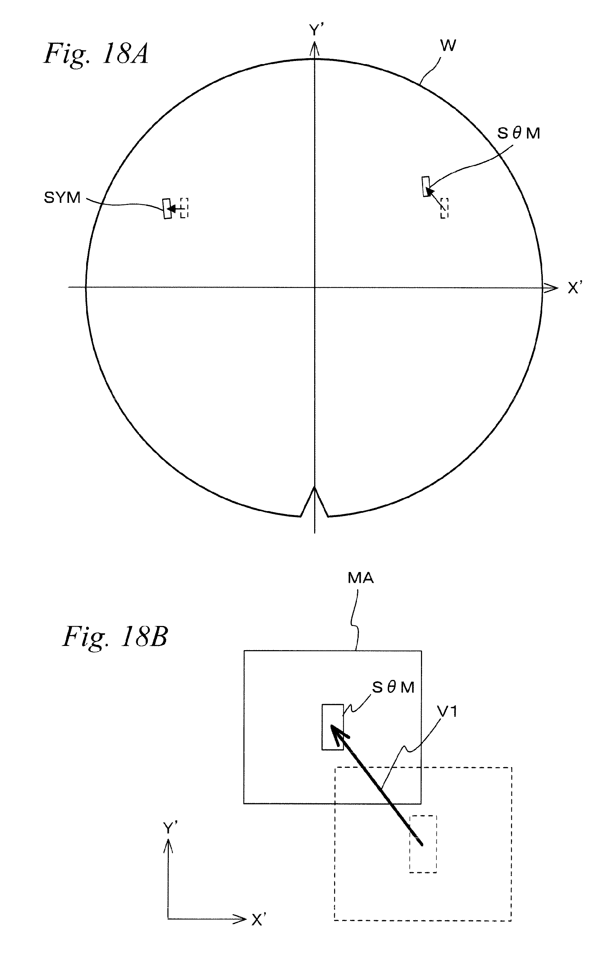

In step 652, first, the wafer is loaded into the exposure apparatus and pre-alignment (S13) is performed, and as is described above, the edges of wafer W are detected, and based on the detection results, a center position and a rotation amount of wafer W are computed. Then, in wafer load (S14) or search alignment (S15), a position of wafer stage WST is adjusted by an amount corresponding to the position deviation amount of the search alignment marks in the outer shape reference coordinate system of wafer W that has been pre-measured in inline measurement instrument 400. In this manner, because the relative position between wafer stage WST and alignment system ALG is adjusted by the amount corresponding to the position deviation amount, occurrence of a search measurement error or the like, which is caused by the position deviations of search alignment marks in the outer shape reference coordinate system due to A. the offset and B. the pre-alignment and loading repeatability in the previous layer exposure apparatus, can be avoided. FIG. 18A shows an example of the search alignment marks that are formed by exposure in a previous layer exposure apparatus and whose formation positions are deviated from the design values with respect to the outer shape reference coordinate system of wafer W due to an offset of the exposure apparatus and a deviation of a pre-alignment loading position. In FIG. 18A, the positions of the search alignment marks in design are indicated by a dotted line, and the actual positions are indicated by a solid line. In FIG. 18A, the position deviation amounts of the search alignment marks that are measured by the pre-measurement of inline measurement instrument 400 are indicated by arrows.

FIG. 18B shows a magnified view of a neighboring area of search alignment mark SθM. FIG. 18B shows a measurement field MA of alignment system ALG at the time when the position of wafer stage WST is adjusted by the amount corresponding to the position deviation amount of the search alignment mark as is described above. As is shown in FIG. 18B, because the position of wafer stage WST is adjusted by the amount corresponding to the position deviation amount, measurement field MA moves by an amount of an arrow V1 and search alignment mark SθM is located within the measurement field of alignment system ALG. Incidentally, the imaging magnification of alignment system ALG may be set to much higher in the case the increase in the imaging magnification increases the reliability of putting the search alignment marks within the measurement field without fail as is described above. In this manner, detection accuracy of the search alignment marks can further be improved.

[Correction of differences between sensors]

In the mean time, the pre-measurement in inline measurement instrument 400 is performed only to measure beforehand the measurement subjects of various alignments that are performed in exposure apparatus 200. Accordingly, for example, the situation has to be avoided in which wafer W that can be measured without any problems in exposure apparatus 200 cannot normally be measured in inline measurement instrument 400. Thus, the pre-measurement in inline measurement instrument 400 needs to be consistent with main measurement in exposure apparatus 200. In the embodiment, by comparing various detection scores as the evaluation results with respect to the detection results by pre-measurement sensor 410 in the pre-measurement process of inline measurement instrument 400 with various detection scores as the evaluation results with respect to the detection results of the edges of wafer W in the measurement process of exposure apparatus 200, both scores with respect to the same wafer (which may be a datum wafer, for example) are made to be consistent with each other (a consistency process).

First of all, differences between sensors (which are characteristic differences between pre-measurement sensor 410 and measurement units 40a to 40c, and include a difference in signal processing algorithms) between inline measurement instrument 400 and pre-alignment unit 32 of exposure apparatus 200 that detect the edge of wafer W are corrected. First, main controller 20 of exposure apparatus 200 logs imaging data concerning the wafer outer shape edge (including a notch/OF) where an edge detection error occurs in storage unit 21, in the pre-alignment of S13. Then, main controller 20 sends the imaging data, outer shape measurement parameters and detection error information to analytical system 600 or inline measurement instrument 400, and compares the imaging data (raw signal waveform data) of the edge measured by inline measurement instrument 400 with edge raw signal waveform data with respect to the same edge by pre-alignment unit 32 (measurement units 40a to 40c) of exposure apparatus 200 and optimizes a score correction value so that the score based on the measurement result of the pre-alignment coincides with the score based on the measurement result of inline measurement instrument 400. In this manner, the score with respect to the imaging data of at least a part of the edge of the wafer in the pre-measurement process can be made to substantially coincide with the score with respect to the imaging data of the same edge in the pre-alignment, which enables effective pre-measurement.

Further, differences between sensors (which are characteristic differences between pre-measurement sensors 410 and alignment system ALG, and include a difference in signal processing algorithms) between inline measurement instrument 400 and alignment system ALG of exposure apparatus 200 are corrected. By comparing mark raw signal waveform data sent from inline measurement instrument 400 with the detection results (mark raw signal waveform data)

with respect to the same mark by exposure apparatus 200(alignment system ALG), a score correction value is optimized so that the score based on the measurement result of inline measurement instrument 400 coincides with the score based on the measurement result of alignment system ALG. Incidentally, in the alignment processing, normally main controller 20 of exposure apparatus 200 logs at least the detection results (the mark raw signal waveform data) concerning the mark where a detection error occurs, and therefore main controller 20 may send this mark raw signal waveform data, detection parameters and detection error information to analytical system 600 or inline measurement instrument 400, compare them with the mark raw signal waveform data measured by inline measurement instrument 400, and optimize a score correction value so that the detection scores with respect to the same mark coincide with each other.

Incidentally, the correction processing of the characteristic differences between sensors described above has been described regarding the case of the differences between inline measurement instrument 400 and exposure apparatus 200, however, the correction processing with respect to the characteristic differences between sensors can be performed in the similar manner also between offline measurement instrument 800 and exposure apparatus 200.

[Edge detection result score]

Next, the edge detection result score referred to above will be described. The edge detection result score is obtained using a predetermined evaluation criterion as is described earlier in the above step 628 (refer to FIG. 15A). In the embodiment, a plurality of characteristic amounts that are related to a detection state of an edge (including a notch portion) of wafer W in the imaging data of the edge of wafer W are to be a predetermined evaluation criterion. The characteristic amount is an amount that serves as a scale for determining whether or not a characteristic of an edge of a wafer can be accurately detected. As the characteristic amount related to the edge of the wafer, for example, intensity of a wafer edge pattern (i.e. contrast between a bright portion and a dark portion near the edge) that is obtained from detection results (imaging data), variation in the intensity of the wafer edge pattern, a curvature of the edge of the wafer that is obtained from the imaging data, differences between an approximate curve (an approximate line is also possible) obtained by approximating an edge portion of the wafer and a plurality of edge positions, and the like can be cited. In the embodiment, after obtaining the plurality of characteristic amounts, the total value that is obtained by performing the optimized weighting on each characteristic amount and calculating the sum is defined as an edge detection result score and computed as an evaluation result, and the judgment is made of whether the imaging data of the edge of wafer W is 'appropriate (OK) or inappropriate (NG)' by comparing it with a threshold value set in advance. In this case, in order to correctly judge 'whether the edge imaging data is appropriate or inappropriate', it is preferable that the weighting of each of the plurality of characteristic amounts is optimized with respect to each exposure process or each lot.

[Mark detection result score]

The mark detection result score referred to above will be described next. The mark detection result score is also obtained using a predetermined evaluation criterion. After obtaining a plurality of characteristic amounts with respect to each pattern such as a mark pattern width error that is a characteristic amount in a mark signal pattern, a mark pattern edge spacing error, mark pattern edge intensity and variation in the mark pattern edge intensity, the total value that is obtained by performing the optimized weighting on each characteristic amount and calculating the sum is defined as a mark detection result score, and the judgment is made of whether or not there is a mark by comparing it with a threshold value set in advance. In this case, in order to correctly judge 'whether the mark raw signal waveform data is appropriate or inappropriate', it is preferable that the weighting of each of the plurality of characteristic amounts is optimized with respect to each exposure process, each lot or each mark structure, as in the case of the edge detection result score.

Incidentally, as a more specific characteristic amount, in the case an edge portion of detection results (raw signal waveform data) of the mark is detected, the regularity of a pattern width of the mark (e.g. uniformity that is one of characteristics of the mark) and the regularity of pattern spacing (e.g. regularity that is one of characteristics of the mark) are obtained as characteristic amounts based on the detection results of the edge portion (the edge position). In this case, the 'edge portion' is not an outer edge of a surface to be measured of wafer W, but is a boundary between a pattern portion where the mark is formed and a non-pattern portion, like a boundary between a line portion and a space portion in a line-and-space mark. At this point of time, processing to remove a noise included in the signals may be performed.

Incidentally, a line pattern width and line pattern spacing are better when the variations from the design values are smaller, and also when the variation in the edge shape uniformity is smaller, 'the suitability of a waveform signal of the mark' is judged to be high. In this case, the lower the score is, the better it is. On the contrary, in the case template matching between a detection waveform and a reference waveform is performed for detection of the mark, that is, the so-called correlation algorithm is used, it is also possible to make the correlation value as a score. In this case, the higher the score is, the better it is.

[Wafer loading repeatability measurement]

Next, wafer loading repeatability measurement will be described. In the embodiment, loading repeatability measurement of wafer W loaded into exposure apparatus 200 is performed during the lot processing. In other words, in the embodiment, the loading repeatability measurement of exposure apparatus 200 is performed by measuring a loading position of one wafer W every time when the wafer W is loaded into exposure apparatus 200, according to the flowchart in FIG. 9.

The measurement of the loading repeatability is performed by measuring positions of marks on wafer W after being loaded (that is, the measurement is performed during a period from the load of wafer W in S14 until the unload of wafer W in S18). However, since the outer shape of a wafer and a mark state (such as the formed marks are in a good state or a poor state (a break state)) on wafer W, and a fluctuation state of mark positions due to wafer deformation or the like) are varied even in the same lot, the causes other than the loading repeatability of exposure apparatus 200 are to affect measurement results of the mark positions on wafer W, comparing with the case when the loading repeatability is measured by loading a datum wafer a plurality of times. In the embodiment, by removing components due to the causes other then the loading repeatability of exposure apparatus 200 from the measurement results of the mark positions, that is, by performing the so-called normalization of the measured mark positions, the measurement of the loading repeatability of exposure apparatus 200 during the lot processing is achieved.

Because the causes other then the loading repeatability of exposure apparatus 200 are varied, it is difficult to remove all the causes, but it is enough in terms of the accuracy to remove components due to several causes that have significant effects. However, these components are varied depending on each exposure apparatus 200 within processing system 100, and it is preferable that which components due to which causes should be removed can be set with respect to each exposure apparatus 200. Further, there is also the case when the number of wafers required for the measurement of the loading repeatability is different depending on each exposure apparatus. Therefore, it is preferable that measurement conditions of the loading repeatability can be set including presence/absence of the measurement, as internal parameters of exposure apparatus 200 with respect to each apparatus number of the exposure apparatuses. Thus, the setting of the measurement conditions will be described first.

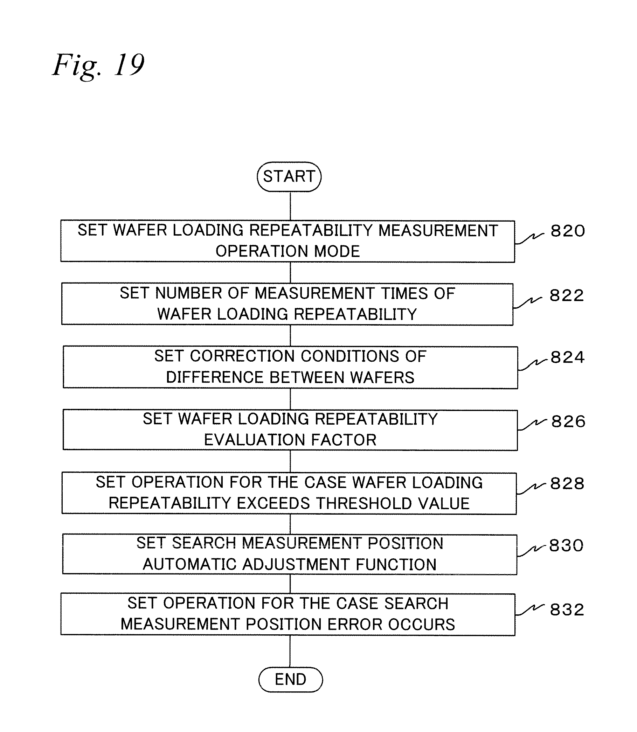

FIG. 19 shows an example of a setting sequence of the conditions for the wafer loading repeatability measurement during the lot processing. As is shown in FIG. 19, first, in step 820, a wafer loading repeatability measurement operation mode is set. To be more specific, the following items are set here: whether or not to perform the wafer loading repeatability measurement (i.e. presence/absence of the measurement); presence/absence of termination conditions of the measurement execution in the case the loading repeatability measurement is executed; and the number of lots of wafers or the number of wafers to be used for computation of the wafer loading repeatability when there are the execution termination conditions. When the number of wafers is designated, the designation is also performed as to whether to continuously perform the measurement to the wafers in the next lot(s). Since it can be considered that the characteristics of wafers W are substantially the same as wafers W in the next lot(s) when the same process has been performed to the wafers, it is often the case that the wafer loading repeatability measurement can be continuously performed to the next lot (s).

In the next step, step 822, the number of wafers to be used for computation of the wafer loading repeatability is set. In this case, the number of wafers when computing the wafer loading repeatability is set. Normally, from the aspect of stability of $3\sigma$ of the loading repeatability, the number of wafers is set to from 10 to 25 that is the number of wafers included in one lot. Incidentally, in the case the number of processed wafers W in exposure apparatus 200 exceeds the set number, the most recent loading repeatability can always be obtained by discarding loading repeatability measurement data of the wafer that has first been measured and sequentially loading the measurement data of a new wafer and then computing the loading repeatability.

In the next step, step 824, correction conditions of differences between wafers of mark positions, which are applied to when performing the normalization of the mark measurement results in the wafer loading repeatability measurement, are set. In the following description, two correction conditions will be described.

<Correction condition No. 1: wafer outer shape difference>

First, as one of great causes that deviate the mark positions on wafer W, other than the loading repeatability of the exposure apparatus, an outer shape difference of the Wafer can be considered. As is described earlier, in exposure apparatus 200, an outer shape of wafer W is detected in pre-alignment unit 32 and from the outer shape a center position and a rotation amount of wafer Ware computed, then based on the computation results, wafer W is loaded on wafer stage WST. This operation is the same also in a previous layer exposure apparatus, and in particular, when performing exposure of the first layer, search alignment marks are formed using only the outer shape of the wafer as a datum, and therefore the formation positions of the search alignment marks are different from those on other wafers in the case an outer shape of the wafer is different from those of other wafers. Thus, with respect to such wafer outer shape differences, the mark positions need to be normalized.

In order to remove the effect of the wafer outer shape differences, the position deviation amounts of search alignment marks SYM and SθM in the wafer outer shape reference coordinate system that are obtained in the pre-measurement of inline measurement instrument 400 can be used. As is described earlier, search alignment marks SYM and SθM are formed based on the wafer outer shape as a datum and a position deviation component of the search alignment marks caused by the wafer outer shape differences between different wafers can be removed, by subtracting position deviation amounts from the design coordinates of the formation positions of search alignment marks SYM and SθM based on the wafer outer shape as a datum as is shown in FIG. 18A, from the position measurement results of search alignment marks SYM and SθM in the search alignment in step S15 in FIG. 9.

Incidentally, because an offset and the loading repeatability of the previous layer exposure apparatus are also reflected in the position deviation amounts described above, components caused by the offset and the loading repeatability are also canceled.

<Correction condition No. 2: wafer deformation component, mark deformation component>

In the mean time, the position deviations of the search alignment marks are not always caused by the wafer outer shape differences described above. The formation positions of the search alignment marks are greatly affected also by an exposure state of each wafer in the previous layer exposure apparatus. A position deviation component of the search alignment marks due to this effect is called as a wafer deformation component. Naturally, the search alignment mark itself is also different from those on other wafers. This is called as a mark deformation component. In the embodiment, the setting to remove the wafer deformation component and the mark deformation component between wafers is also possible.

Since the search alignment marks are formed accompanying formation of an array of shot areas by exposure of the previous layer exposure apparatus, by measuring an array state of shot areas formed on wafer W, measurement positions of the search alignment marks can be normalized with respect to the wafer deformation component and the mark deformation component described above.

In wafer alignment in step S16 in FIG. 9, an array coordinate system $\alpha\beta$ (refer to FIG. 13) of shot areas on wafer W that are formed by the previous layer exposure apparatus is obtained. Differences (a scaling component and components of orthogonality degree and the like) of the array coordinate system $\alpha\beta$ from the outer shape reference coordinate system X'Y' of wafer W correspond to the wafer deformation component and the mark deformation component described above (an offset component is cancelled under the correction condition No. 1). In the embodiment, by converting position measurement results of the search alignment marks in the search alignment in S15 in FIG. 9 based on alignment correction amounts (the scaling component and the orthogonality degree component) computed in the wafer alignment, the wafer deformation component and the mark deformation component can be canceled from the search alignment measurement results.

Incidentally, the array of shot areas formed on wafer W has not only linear components of the scaling and the like but also high-order components, and there are some cases when such components cannot be ignored. Here, the components are called as random components. Since the formation positions of the search marks also change due to the random components, in the case the random components are computed in the search alignment in step S15 in FIG. 9, the random components may be subtracted from the mark positions.

Incidentally, a wafer of which the random components exceed a threshold value set in advance may be excluded from the wafer loading repeatability data as an abnormal wafer. Normally, in most cases, the random components are sufficiently smaller compared to required accuracy of the wafer loading repeatability measurement, and therefore, the accuracy is hardly affected by omitting the normalization of the mark positions by the random components, and it is more preferable to use the random components only for measurement data abnormality judgment used in the wafer loading repeatability measurement.

In the next step, step 826, wafer loading repeatability evaluation factors are set. In this case, the wafer loading repeatability is computed and evaluation factors to be monitored are designated. As the evaluation factors of the wafer loading repeatability, the factors as shown in the following table 3 are cited.

[Table 3]

| Factor No. | Evaluation Factor Name | Unit |
|---|---|---|
| [1] | Y (3($\sigma$)) | $\mu$m |
| [2] | Y (Max-Min) | $\mu$m |
| [3] | $\theta$ (3$\sigma$) | $\mu$m |

(continued)

| Factor No. | Evaluation Factor Name | Unit |
|---|---|---|
| [4] | θ (Max-Min) | μm |
| [5] | Y-θ (3σ) | μm |
| [6] | Y-θ (Max-Min) | μm |
| [7] | X (3σ) | μm |
| [8] | X (Max-Min) | μm |

That is, as the factors of loading repeatability of wafer W, information related to a distribution of the center position (X, Y) and the rotation amount θ of wafer W after being loaded, and (X(3(σ), Y(3σ), θ(3σ), Y-θ(3σ)), a range from the maximum value to the minimum value (X(Max-Min), Y(Max-Min), (Y-θ) (Max-Min)) and the like can be cited.

In this case, out of the wafer loading repeatability measurement factors [1] to [8], the factors used for measurement are selected. For example, out of the wafer loading repeatability measurement factors [1] to [8] shown in the above table 3, factors [1], [2], [3], [4], [7] and [8] are designated. Further, in the embodiment, in the case the values of the designated evaluation factors exceed a threshold value in loading repeatability measurement processing during the lot processing, the judgment may also be made that exposure processing cannot normally be performed. Accordingly, in this case, abnormality judgment threshold values with respect to the designated evaluation factors are also set. Normally, the threshold values are set based on a search alignment area, a size of a search mark, and an offset between an exposure apparatus used for exposure of the previous layer in processing system 100 and exposure apparatus 200, and a threshold value of 3σ of Y, θ and X is set to, for example, about 15 [μm], and a threshold value of (Max-Min) of Y, θ and X is set to, for example, about 30[μm].

In the next step, step 828, operations in the case measurement results of the evaluation factors of the wafer loading repeatability exceed threshold values are set. In other words, in the case any one of the wafer loading repeatability evaluation factors designated in the above step 820 exceeds a threshold value, the operations can be designated as to: whether or not to display an error message in a display unit (not shown) of exposure apparatus 200; whether or not to notify a detailed report recording specific information such as in which evaluation factor abnormality occurs and what the abnormality value is, for example, to exposure process control controller 500; whether or not to continue the lot processing even in the case the abnormality occurs; whether or not to switch to a maintenance mode; and the like.

In the next step, step 830, in the setting of search measurement position automatic adjustment function, whether or not to automatically adjust the measurement position of the search alignment mark is designated in accordance with values of 3σ, Max-Min and a mean of the wafer loading repeatability.

In the next step, step 832, operations in the case a detection error of the search alignment mark (a search false detection error) occurs are set. In this case, for example, various operations are designated as to: whether or not to display an error message in a display unit (not shown) at the time when a search false detection error occurs; whether or not to notify a detailed report specifically recording detailed information such as the center position and the rotation amount of wafer W to exposure process control controller 500; whether or not to continue the lot processing even in the case the search false detection error occurs; whether or not to switch to a maintenance mode; whether or not to automatically retry the pre-alignment and the load of wafer W; whether or not to perform automatic adjustment of the measurement position of the search alignment mark at the time of the retry in the case the automatic adjustment has not been performed; whether or not to perform automatic correction of various parameters that set the automatic adjustment of the measurement position of the search alignment mark in the case the automatic adjustment has been already performed; and the like.

In this case, the automatic adjustment of the measurement position of a search alignment mark will be described. In the case measurement of the wafer loading repeatability is performed to several wafers W, and in the case a certain type of causal relation between the evaluation factors and the position of the search alignment mark can be found out, the position of the search alignment mark can be predicted to some extent from the measurement results of the wafer loading repeatability. With this prediction, the search measurement position and range when measuring the search alignment mark can be automatically corrected. For example, from a relation between the mean value, 3σ, the maximum value - the minimum value and the like that serve as the wafer loading repeatability measurement results of wafers W loaded so far and the position of the search alignment mark, a fluctuation prediction equation, which is used to predict a fluctuation of a search measurement position of each mark on wafer W that is loaded this time, is created using a predetermined statistical method such as the least-squares method. From the fluctuation prediction equation, a position of each search alignment mark on wafer W loaded this time is predicted, and a measurement range of search alignment marks may be determined taking the position into consideration. The automatic adjustment of the search alignment marks means that the errors due to C. an offset and D. loading repeatability and the like of a next layer exposure apparatus (i.e. exposure apparatus 200 in the embodiment) are reduced.

After completing the design sequence described above, in the case the loading repeatability measurement is set to be performed in the above step 820, in the wafer process in actual, every time when a wafer is loaded into exposure apparatus 200, the position measurement results of the search alignment marks are normalized (a normalization process) based on the foregoing correction conditions No. 1 and No. 2, and based on the normalized position measurement results, the loading repeatability of the wafer loaded into exposure apparatus 200 is measured (a repeatability measurement process). These processes described above are performed after the search alignment is performed, or after fine alignment is performed in the case the normalization of the mark positions is performed using results of the fine alignment.

Further, in the loading repeatability measurement processing, in the case the designated evaluation factor exceeds the threshold value and abnormality of the wafer loading repeatability is detected, the processing based on the setting in the conditions setting sequence described above is performed. For example, the lot processing is suspended, or in the case execution of maintenance is set, the process is suspended and the maintenance of the apparatus is performed. In the maintenance, inspection is performed regarding stability of loading arm 36 and center table 30, a parallelization degree between loading arm 36 and center table 30, a parallelization degree of center table 30 and wafer holder 18, adjustment of a pre-alignment image measurement unit (including adjustment of an optical system for pre-alignment), inclination adjustment of the background plate, flexure of the wafer, and the like. In the case abnormality is not found in the inspection, adjustment of the wafer loading parameters (e.g. fluctuation adjustment of a vacuum state of center table 30 and loading arm 36) shown in tables 1 and 2 described above may be performed.

Incidentally, in general, there is a difference of the loading repeatability of wafer W between the case a wafer direction is at an angle of 180 degrees from the +Y direction and the case a wafer direction is at an angle of +90 degrees from the +Y direction, and therefore it is preferable to severally evaluate the loading repeatability in each case.

As is obvious from the description so far, steps 624, 626, 632 and 634 (FIG. 15) correspond to a pre-measurement process, step S13 (refer to FIG. 9) corresponds to a main measurement process, adjustment of the position of wafer stage WST that is performed in the wafer load in step S14 or the search alignment in step S15 (refer to FIG. 9) in accordance with the pre-measured position deviation amounts of the search alignment marks corresponds to an adjustment process. Further, the search alignment in step S15 (refer to FIG. 9) corresponds to a mark measurement process and a post-loading judgment process. Further, steps 628, 630, 636 and 638 (FIG. 15) correspond to an evaluation process, step 642 (refer to FIG. 16) corresponds to an optimization step, step 640 (refer to FIG. 16) corresponds to a pre-optimization judgment process, step 644 (refer to FIG. 16) corresponds to a post-optimization judgment process and step 650 (refer to FIG. 16) corresponds to an exclusion process.

Further, in the embodiment, analytical system 600 in FIG. 1 corresponds to an analytical apparatus, alignment system ALG in FIG. 2 corresponds to a mark measurement unit, inline measurement instrument 400 or offline measurement instrument 800 in FIG. 1 corresponds to a pre-measurement apparatus and an evaluation apparatus, pre-alignment unit 32 corresponds to an outer edge measurement unit, main controller 20 in FIG. 2 corresponds to an adjustment unit, a normalization unit, a repeatability measurement unit, a derivation unit and the like.

As is described in detail above, according to the embodiment, when wafer W is loaded into exposure apparatus 200, in the pre-alignment measurement process in pre-alignment unit 32, at least a part of an outer edge (an edge) of a surface to be measured of wafer W is detected. Then, based on the detection results, position information of wafer W in the outer shape reference coordinate system (the X'Y' coordinate system) that is a two-dimensional coordinate system substantially parallel to the surface to be measured of wafer W (e.g. a surface of wafer W, on which shot areas are formed), and is set by at least one datum point (e.g. a notch center position) on the edge of wafer W is measured. Then, in the case pre-alignment of wafer W is performed based on the measurement results, before loading wafer W into exposure apparatus 200, at least a part of the edge of wafer Wand at least two search alignment marks SYM and SθM formed on the surface to be measured of wafer W are detected in the pre-measurement process in inline measurement instrument 400 or offline measurement instrument 800, independently of exposure apparatus 200, prior to pre-alignment. And based on the detection results, the position coordinate of each of search alignment marks SYM and SθM in the outer shape reference coordinate system (the X'Y' coordinate system) is measured beforehand.

Furthermore, by the pre-alignment, a relative position in the XY coordinate system between wafer W to be loaded into exposure apparatus 200 and a measurement field of alignment system ALG that measures the positions of search alignment marks SYM and SθM on wafer W is adjusted based on the pre-measurement results of inline measurement instrument 400 or the like. With this operation, since the search alignment marks on wafer W loaded into exposure apparatus 200 can be located within the measurement field of alignment system ALG without fail, the positions of the search alignment marks can surely be measured and exposure with high accuracy can be achieved based on the measurement results of the mark positions.

Incidentally, in the embodiment in pre-alignment unit 32 in exposure apparatus 200, the pre-alignment of wafer W is performed using the X'Y' coordinate system as the outer shape reference coordinate system, the X'Y' coordinate system being set by the center position and the rotation amount of wafer W obtained when using at least one specific point corresponding to an outer shape characteristic portion (a notch in the embodiment) on the edge of the wafer as a datum point. However, all the exposure apparatuses arranged in processing system 100 as in the embodiment do not always employ the coordinate system based on the notch as a datum, as the outer shape reference coordinate system serving as a datum when performing the pre-alignment. For example, among the exposure apparatuses, sometimes there is an exposure apparatus that detects at least four points on the edge of wafer W (which are obtained from three imaging fields VA to VC, and at least three points are obtained from imaging fields VA to VC respectively), uses a coordinate system that is set by a center position and a rotation amount of the wafer that are obtained in a statistical method using each detection point as a datum point, as an outer shape reference coordinate system. In this manner, in the case an exposure apparatus that uses an outer shape reference coordinate system differently set is included within processing system 100, an outer shape reference coordinate system differs depending on each layer even on the same wafer, and position of search alignment marks formed on wafer W are deviated. Therefore, in the case a wafer outer shape detection method of a previous layer exposure apparatus is different from that of a next layer exposure apparatus and their outer shape reference coordinate systems are different, the chance of generating search false detection errors increases accordingly. For example, the case can be considered where one of the previous layer exposure apparatus and the next layer exposure apparatus employs the wafer outer shape detection method by a pre-alignment system as is described in the embodiment and the other employs a method in which a wafer outer shape is detected while rotating a wafer using a line sensor that is arranged facing a wafer edge, as is disclosed in, for example, Kokai (Japanese Unexamined Patent Application Publication) No. 60-218853, and the corresponding U.S. Patent No. 4,907,035. The pre-measurement of position coordinates of search alignment marks in the outer shape reference coordinate system by inline measurement instrument 400 or the like as in the embodiment is effective for such a case in particular. As long as the national laws in designated states (or elected states), to which this international application is applied, permit, the above disclosures of the publication and the U.S. Patent Application Publication or the U.S. Patents are incorporated herein by reference.

In other words, in inline measurement instrument 400, with respect to the search alignment mark that is formed with an outer shape reference coordinate system of a previous layer, a position deviation amount from a design position of the mark in an outer shape reference coordinate system that is applied in an exposure apparatus that exposes a present layer is measured. Accordingly, the exposure apparatus that exposes the present layer only has to correct the imaging field of alignment system ALG based on the deviation amount. However, in this case, inline measurement instrument 400 needs to measure a position coordinate of the search alignment mark in an outer shape reference coordinate system that is applied in a next layer exposure apparatus. For example, in the case the next layer exposure apparatus employs a coordinate system, which is set by a center position and a rotation amount of wafer W that are obtained in a statistical method using at least four or more detection points on an edge of the wafer as datum points, as an outer shape reference coordinate system, a deviation amount of the mark has to be measured in a different method (that is, in an outer shape reference coordinate system in an exposure apparatus that is to expose wafer W from now) from the one in the embodiment above. Incidentally, in the embodiment above, the case is described where at least four points on the edge of wafer W are detected on the pre-alignment. However, the present invention is not limited to this, and a center position and a rotation amount of a wafer may be obtained by detecting at least three points.

Inline measurement instrument 400 is equipped with turntable TT for the measurement in this case. In other words, inline measurement instrument 400 rotates turntable TT at a predetermined pitch from a state shown in FIG. 8A while stopping stage unit IST, and every time turntable TT is rotated, the edge of wafer W is detected by pre-measurement sensor 410. That is, multiple edge points along a circumference of wafer W in the XY coordinate system are obtained by measuring an edge position corresponding to each rotation amount along a circumferential direction of wafer W based on detection results for each rotation amount, and expanding it in the XY coordinate system. Accordingly, an outer shape of wafer W that is a circular shape is determined using a predetermined statistical method such as the least-squares method, and a center position and a rotation amount of wafer W are computed from the determined outer shape of wafer W (including a notch position), and then based on the computation results, an outer shape reference coordinate system may be determined.

Incidentally, in the case only a position deviation of a search alignment mark due to a difference in the way to set an outer shape reference coordinate system between exposure apparatuses is focused on in this manner, the position deviation amount can be deemed to be substantially the same within a lot, and therefore the pre-measurement by inline measurement instrument 400 may be performed to only wafer W at the head of a lot, not to all wafers W in a lot. In the case a period of time for the pre-measurement is limited, the pre-measurement in this manner is effective in particular from the viewpoint of throughput.

Further, in the embodiment, in the search alignment, the case where a measurement position of each search mark is outside a predetermined range after performing position measurement of each search alignment mark on wafer W that is loaded into exposure apparatus 200 is regarded as wafer loading abnormality. Thus, in the case the position of the search mark is still deviated significantly, even when search alignment measurement is performed by the pre-measurement taking into consideration a position deviation amount of the search alignment mark in the outer shape reference coordinate system from the design position, the probability that wafer loading abnormality can be deemed to occur increases.

Further, in the embodiment, prior to the pre-alignment in the exposure apparatus, the optimal measurement conditions of an edge of wafer W are obtained beforehand by measuring the edge of the wafer W using inline measurement instrument 400 or offline measurement instrument 800. In this manner, because the pre-alignment measurement can be performed under the optimal measurement conditions at all times in the exposure apparatus, reduction in occurrence of edge detection errors and improvement in alignment accuracy can be achieved.

Further, in the embodiment, the wafer loading repeatability measurement of different wafers during the normal lot processing can be performed by subtracting position deviation amounts from design positions of the search alignment marks in the outer shape reference coordinate system of wafer W from search alignment mark measurement results.

Further, in the case a causal relation between an evaluation factor of the loading repeatability and the position of the search alignment mark can be recognized by logging the loading repeatability of the wafer W and the measurement results of the search alignment mark in storage unit 21, a fluctuation prediction equation of the position of the search alignment mark based on the causal relation is created by using a predetermined statistical method, and automatic adjustment of a measurement position of the search alignment mark during the lot processing, and the like can be performed by predicting a position of a search alignment mark of wafer W to be loaded next using the created fluctuation prediction equation. Therefore, reduction in occurrence of search false detection errors and improvement in alignment accuracy can be achieved. Further, the fluctuation prediction equation described above can be used not only for adjustment of the measurement position of the search alignment mark but also for optimization of adjustment timing of a transport system of wafer W (in the embodiment above, loading arm 36 and center table 30).

Further, there are some cases where an exposure apparatus arranged in processing system 100 directly performs wafer alignment processing without performing search alignment after wafer W is loaded. In the case exposure of wafer W is performed using such an exposure apparatus, position coordinates of not search alignment marks SYM and SθM but fine alignment marks are measured in the pre-measurement processing in inline measurement instrument 400, and after wafer W is loaded into the exposure apparatus, the measurement field of alignment system ALG may be corrected based on pre-measurement results of inline measurement instrument 400 when measuring the fine alignment marks in fine alignment.

[Imaging method of inline measurement instrument or the like]

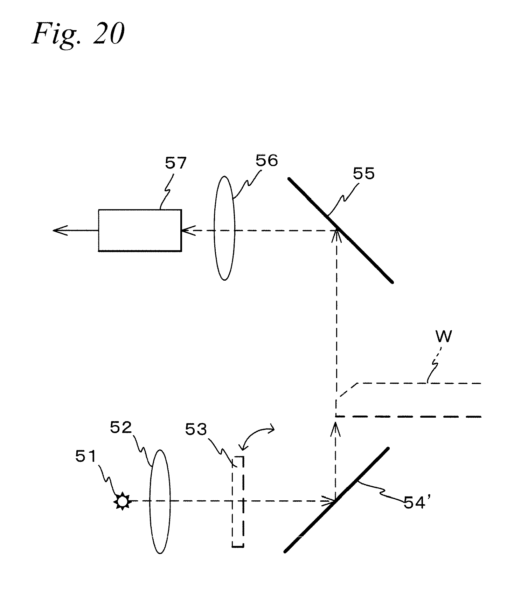

Further, in the embodiment above, an epi-illuminatzon method is employed in inline measurement instrument 400 and pre-alignment unit 32, however, an illumination method is not limited to this. For example, a transmission illumination method may be employed in which a photodetection system and an illumination system are arranged on opposite sides sandwiching in wafer W between them (the illumination system comprises a mirror 54'), as is shown in FIG. 20. When the transmission illumination method is employed, it becomes possible to decrease the effect of a shape of an end surface of wafer W on imaging results. However, due to an arrangement space and from the viewpoint of sharing one optical system so as to detect an edge of wafer W and to detect search alignment marks, an epi-illumination method as in the embodiment above is preferable.

Further, in the embodiment above, inline measurement instrument 400 is an measurement instrument that has a configuration of one pre-measurement sensor comprising a variable power optical system, and stage unit IST being movable within the XY plane, and measures three points on an edge of wafer W and the search alignment marks on wafer W using one sensor, however, the present invention is not limited to this. For example, a measurement apparatus may be employed that is equipped with a measurement unit having a configuration equivalent to pre-alignment unit 32 and a measurement unit having a configuration equivalent to alignment system ALG, and measures three points on the edge of wafer W simultaneously, or a measurement apparatus may be employed that measures the edge of wafer W and the search alignment marks on wafer W severally by different sensors. In this case, each of the sensors does not need to be equipped with a variable power optical system. The point is that a measurement apparatus only has to be capable of measuring the positions of search alignment marks in an outer shape reference coordinate system employed in an exposure apparatus. Further, instead of pre-alignment unit 32, a pre-alignment unit (a type of a unit that measures a wafer edge using a one-dimensional line sensor while rotating a wafer) having a configuration as is disclosed in, for example, Kokai (Japanese Unexamined Patent Application Publication) No. 60-218853, and the corresponding U.S. Patent No. 4,907,035 described above, may be used as a wafer edge measurement unit. Further, a measurement method is not limited to the one in which when measuring an edge of wafer W, a two-dimensional image data on the wafer edge is used, and when measuring the search alignment marks on wafer W, one-dimensional waveform data of each of the X axis and Y axis is used. Either of the two-dimensional data and the one-dimensional data may be used in wafer edge measurement and search alignment mark measurement (marK measurement within a wafer). As long as the national laws in designated states (or elected states), to which this international application is applied, permit, the above disclosures of the publication and the U.S. Patents or the U.S. Patent Application Publication are incorporated herein by reference.

Further, in the case when one optical system is not shared to detect an edge of wafer W and to detect search alignment marks, a sensor to measure the positions of marks is not limited to the one based on an image processing method. For example, a sensor may be based on an LSA (Laser Step Alignment) system or a LIA (Laser Interferometric Alignment) system. In this case, the LSA system sensor is the most versatile sensor that irradiates a laser beam to a mark and measures a mark position using the diffracted or scattered beam, and has conventionally been used for process wafers of wide range. And, the LIA system sensor is a sensor that irradiates laser beams whose frequency is slightly changed to marks in a diffraction grating arrangement from two directions, and makes two diffracted beams that are generated interfere with each other, and from the phase, detects position information of the mark, and the LIA system sensor is effectively used for a wafer having a low difference in level or a rough surface. As in the case of exposure apparatus 200, inline measurement instrument 400 preferably has two or more sensors out of these three types of sensors so that the sensors can be separately used depending on their properties and the situation. Also, a sensor, which is disclosed in Kokai (Japanese Unexamined Patent Application Publication) No. 2003-224057, and the corresponding U.S. Patent No. 6,762,111 or No. 6,833,309 and measures asymmetry of a mark to be measured, may be employed. As long as the national laws in designated states (or elected states), to which this international application is applied, permit, the above disclosures of the publication and the U.S. Patent Application Publication or the U.S. Patents are incorporated herein by reference.

Further, in the embodiment above, the wafer loading repeatability in the exposure apparatus is measured using the measurement results of the search alignment marks, however, the present invention is not limited to this. For example, the wafer loading repeatability may be measured using measurement results of fine alignment marks arranged along with shot areas for performing wafer alignment.

Further, in the embodiment above, the case is described where the present invention is applied to the pre-alignment and search alignment of a wafer, that is, the alignment of the wafer, however, it is needless to say that the present invention can be applied to a transport operation of a reticle or an alignment operation.

Incidentally, a pre-alignment unit of a wafer is not limited to the one described in the embodiment above, and various types of pre-alignment units can be used. For example, as in Kokai (Japanese Unexamined Patent Application Publication) No. 09-036202, a pre-alignment unit may have a configuration that an illumination system is arranged on wafer stage WST and pre-alignment is performed using the illumination system arranged on wafer stage WST after wafer stage WST is moved to under loading arm 36. Also, a configuration may be employed in which pre-alignment measurement can be performed to wafer W held on center table 30, on wafer holder 18 or by a transport system other than loading arm 36. In this manner, various methods can be employed for pre-alignment detection, and in either method, pre-alignment measurement can be performed in parallel with moving wafer stage WST to a wafer load position for wafer exchange and performing the unloading, after an exposure operation is completed. As long as the national laws in designated states (or elected states), to which this international application is applied, permit, the above disclosure of the publication is incorporated herein by reference.

As is described above, various types can be considered as a pre-alignment mechanism that is constituted by a pre-alignment unit of a wafer and the like. For example, center table 30 that can be protruded and withdrawn is not arranged to wafer holder 18, different from the one shown in FIG. 3C, and a pair of recessed groove sections and a pair of cutout sections through which a hook section of loading arm 36 can pass are formed, and delivery of a wafer may be performed by cooperate operations of loading arm 36 and wafer stage WST without making loading arm 36 and wafer stage WST interfere.

Incidentally, in the present description, an 'arm' means a wide concept that includes a member used for holding an object (a wafer in the embodiment above) when transporting the object. Further, in the embodiment above, a surface on a side on which shot areas are formed of wafer W, that is, an exposure surface is a 'surface to be measured of an object', however, the surface to be measured may be a back surface of wafer W. Further, an 'edge' in the present description means at least a part of an outer edge of wafer W.

Further, in inline measurement instrument 400 or offline measurement instrument 800, a holding method of wafer W when measuring a wafer outer edge is not limited to the one described in the embodiment above. For example, design of the configuration of stage unit IST can appropriately be changed and there may not be turntable TT on stage unit IST, stage unit IST may have a configuration similar to wafer stage WST, or may have a configuration so as to measure an edge of wafer W that is held on the center table or the wafer holder. Also, an edge of wafer W may be measured in a state wafer W is held by a transport system that loads the wafer on stage unit IST.

In the meantime, as a method of wafer loading repeatability measurement during normal operations of the apparatuses (during the exposure processing sequence of a process wafer), besides the method in which information obtained in the pre-measurement process of inline measurement instrument 400 is used as is described earlier, a method without using an inline measurement instrument (using only an exposure apparatus) can be considered. The method will be described below.

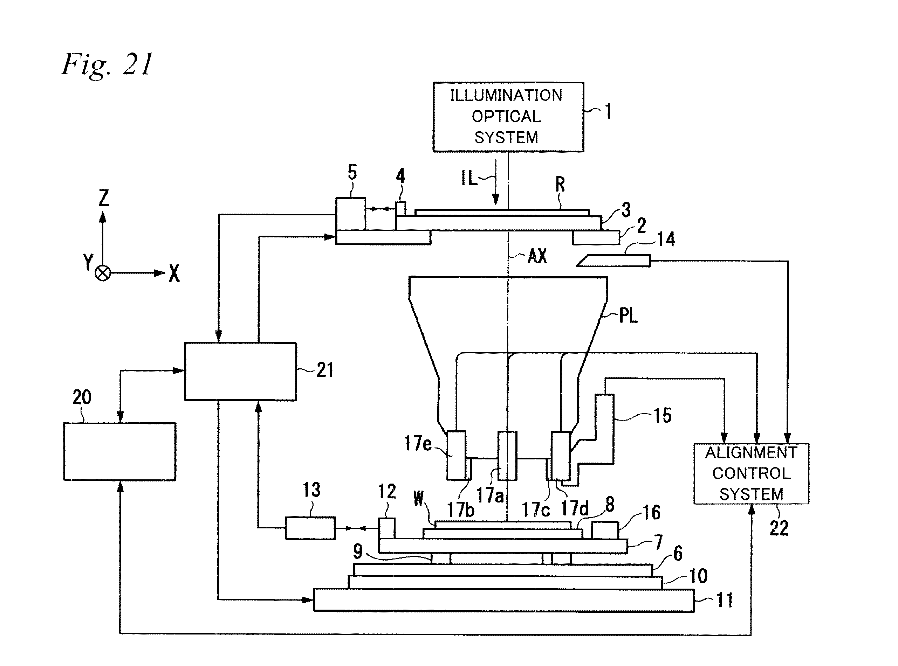

FIG. 21 shows a schematic configuration of an exposure apparatus that is suitable to perform wafer loading repeatability measurement by the exposure apparatus only. In this case, an exposure apparatus by a step-and-repeat method will be described as an exmpale. Incidentally, in the following description, an XYZ orthogonal coordinate system is set in FIG. 21, and a positional relation between respective members will be described referring to the XYZ orthogonal coordinate system. An X axis and a Y axis of the XYZ orthogonal coordinate system are set to be parallel to a wafer stage, and a Z axis is set in an orthogonal direction to the wafer stage (a direction parallel to an optical axis AX of a projection optical system PL). As for the XYZ orthogonal coordinate system in the drawing, in actual, an XY plane is set to be a plane parallel to a horizontal plane and the Z axis is set in a vertical upward direction.

In FIG. 21, an illumination optical system 1 is configured comprising a light source made up of a mercury lamp, an excimer laser or the like, a fly-eye lens, a condenser lens and the like. An illumination light IL emitted from illumination optical system 1 is irradiated to reticle R as a mask, and a pattern formed on reticle R is reduced to, for exmpale, 1/4 or 1/5, and projected and exposed on each shot area (divided area) on wafer W on which a photoresist is coated, via projection optical system PL. As illumination light IL, for exmpale, a g-line (wavelength: 436nm), an i-line (wavelength: 365nm), a KrF excimer laser light (wavelength: 248nm), an ArF excimer laser light (wavelength: 193nm), or an F2 laser light (wavelength: 157nm) is used. Further, projection optical system PL has optical elements such as a plurality of lenses, and the glass material of the optical elements is selected from optical materials such as quartz or fluorite in accordance with a wavelength of illumination light IL, and the optical elements are designed so that the residual aberration is reduced to as small as possible due to the wavelength of illumination light IL.

Reticle R is held on a reticle stage 3 mounted on a reticle frame 2. Reticle stage 3 is configured movable in a translational manner within the XY plane and rotatable in a $\theta$ direction (a rotation direction) by a reticle drive system (not shown). On an upper end portion of reticle stage 3, a movable mirror 4 is arranged in both the X direction and the Y direction, and the positions of reticle stage 3 in the X direction and the Y direction are detected at all times at a predetermined resolution with movable mirrors 4 and a laser interferometer 5 fixed on reticle frame 2, and at the same time, a rotation angle of reticle stage 3 within the XY plane is also detected. Measurement values of laser interferometer 5 are sent to stage controller 19, and based on the information, stage controller 19 controls a reticle drive system (not shown) on reticle frame 2. Further, information on the measurement values of laser interferometer 5 is supplied from stage controller 19 to main controller 20, and main controller 20 is configured to control stage controller 19 based on the information.

Wafer W is held on a wafer holder 8 by vacuum suction that is arranged on a specimen support 7 on an X stage 6. Specimen support 7 is supported by a Z tilt drive section 9 that corrects a position and a tilt (an inclination) in a direction of optical axis AX (the Z direction) of projection optical system PL, and Z tilt drive section 9 is fixed on X stage 6. Z tilt drive section 9 is made up of three actuators that are displaced in the Z direction respectively. Further, X stage 6 is mounted on a Y stage 10 and Y stage 10 is mounted on a wafer base 11, and both stages are movable in the X direction and the Y direction respectively via wafer stage drive system (not shown). Incidentally, a rotation table used to rotate specimen support 7 around the Z axis is also arranged, though it is omitted in the drawing. However, for the sake of simplification and reduction in weight of the entire configuration of the wafer stage and the like, sometimes the rotation table is omitted in order to achieve higher speed and higher accuracy of movement of wafer W.

Further, an L-shaped movable mirror 12' is fixed to an upper end portion of specimen support 7, and a coordinate in the X direction and the Y direction and a rotation angle of specimen support 7 are detected by movable mirror 12' and a laser interferometer 13' that is disposed facing movable mirror 12'. Incidentally, movable mirror 12' is made up of a flat mirror having a mirror surface perpendicular to the X axis and a flat mirror having a mirror surface perpendicular to the Y axis. Further, laser interferometer 13' is made up of two laser interferometers for X axis that irradiate a laser beam along the X-axis to movable mirror 12' and a laser interferometer for Y axis that irradiates a laser beam along the Y axis to movable mirror 12'. The coordinate in the X direction and the Y direction of specimen support 7 is measured by one laser interferometer for X-axis and one laser interferometer for Y-axis, and the rotation angle within the XY plane of specimen support 7 is measured using a difference between measurement values of two laser interferometers for X-axis.

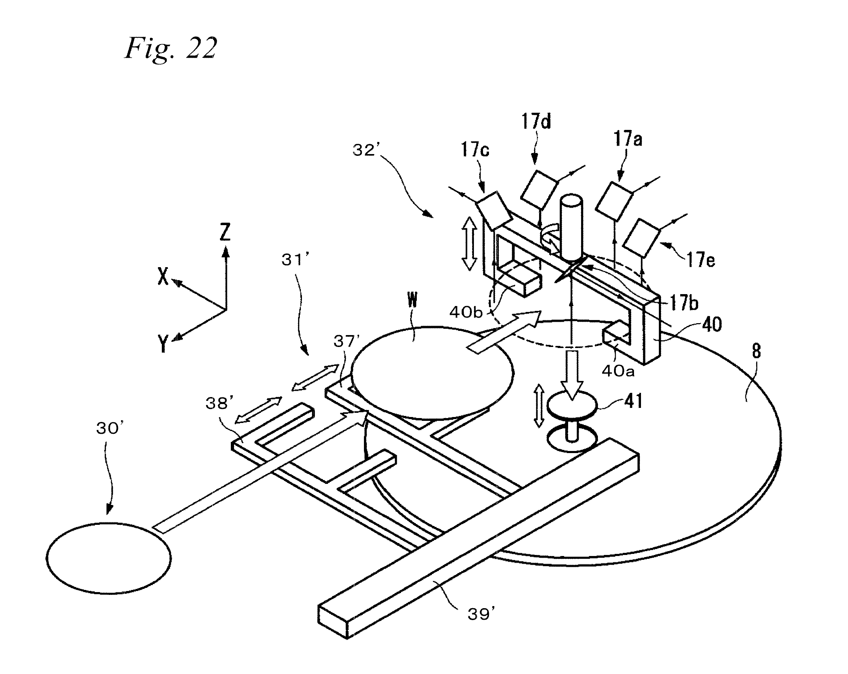

The measurement values of laser interferometer 13' are sent to stage controller 19, and based on the information, stage controller 19 controls a wafer stage control system (not shown). Further, information on the measurement values of laser interferometer 13' is supplied from stage controller 19 to main controller 20, and main controller 20 is configured to control stage controller 19 based on the information. In the vicinity of the wafer stage, a first pre-alignment unit 30' that performs rough position adjustment of wafer W, a wafer transport unit 31' and a second pre-alignment unit 32' are disposed (refer to FIG. 22).

Further, the exposure apparatus is equipped with an alignment sensor used to perform positioning of reticle R and wafer W. As the alignment sensor, for example, an alignment sensor 14' by a TTL (Through the Lens) method, an alignment sensor 15' by an off-axis method and the like are arranged. When performing alignment, a position of a mark for position measurement (an alignment mark) formed on wafer W or a position of a predetermined pattern is measured by either of alignment sensors 14' and 15', and based on the measurement results, main controller 20 controls stage controller 19 to accurately position a pattern formed in the previous step and a pattern of reticle R.

Incidentally, alignment marks (search alignment marks) used to measure rough position information of wafer W and alignment marks (fine alignment marks) used to measure precise position information of wafer W are formed on wafer W, and when performing position measurement by alignment sensor 15', fine measurement for measuring position information of the fine alignment marks is performed after search measurement for measuring position information of the search alignment marks is completed.

The measurement results from alignment sensors 14' or 15' are processed by an alignment control system 22 that is controlled by main controller 20. Alignment control system 22 performs the EGA (Enhanced Global Alignment; computation using the measurement results outputted from alignment sensors 14' or 15' and obtains an array of shot areas on wafer W. In this case, the EGA computation is to obtain with high accuracy an array of all shot areas set on wafer W by performing a statistical computation, using the measurement results that are obtained by measuring the alignment mark formed along each of several representative shot areas (3 to 9 shot areas) set on wafer W with alignment sensors 14' and 15'.

Further, a fiducial mark member 16' that has a surface of the same height as a surface of wafer W is fixed on specimen support 7, and on the surface of fiducial mark member 16', a mark (a fiducial mark) serving as a datum for alignment is formed. As is described above, the exposure apparatus has a configuration in which stage controller 19 and alignment control system 22 are controlled by main controller 20, main controller 20 performs overall control of each section of the exposure apparatus, and an exposure operation is performed in a predetermined sequence.

Further, near an end portion of projection optical system PL on a wafer W side, five two-dimensional image processors 17a to 17e by an off-axis method are arranged. Image processors 17a to 17e severally pick up an image of an edge portion of a circumference section of wafer W and an image of a characteristic portion of the surface of wafer W. Among image processors 17a to 17e, the image processors that pick up the image of the edge portion of the circumference section of wafer W are image processors 17a to 17c, and the image processors that pick up the image of the characteristic portion of the surface of wafer W are image processors 17d and 17e.

In this case, the characteristic portion of the surface of wafer W is, for example, a pattern or a mark out of patterns and marks formed on the surface of wafer W, which can be distinguished from other patterns or marks. Accordingly, for example, in the case a pattern having a characteristic shape within a shot area is located within a measurement field of image processors 17d and 17e, and the pattern formed within other shot areas is unlikely to be located within the measurement field of image processors 17d and 17e, the pattern can be a characteristic portion. Further, a characteristic portion may be a pattern that is formed on a scribe line (a street line) arranged between shot areas. An image of a characteristic portion is picked up at two different points on wafer W, in order to obtain a rotation of a pattern with respect to wafer W. Incidentally, a characteristic portion may be arranged at two or more points on wafer W.

Imaging signals from image processors 17a to 17e are supplied to alignment control system 22. Alignment control system 22 computes a position error and a rotation error of wafer W located at the delivery position and a formation error of a pattern formed on wafer W, from the supplied imaging signals. These computation results are used for adjustment of wafer W in second pre-alignment unit 32', and is also outputted to main controller 20 and used when measuring position setting repeatability of wafer W onto wafer holder 8.

Next, a wafer transport system and a wafer delivery mechanism on a wafer stage will be described with reference to FIG. 22. FIG. 22 is a perspective view showing a schematic configuration of the wafer delivery mechanism. In this case, the wafer stage is an all-inclusive term of wafer holder 8, specimen support 7, Z tilt drive section 9, X stage 6, Y stage 10 and wafer base 11 shown in FIG. 21. As is shown in FIG. 22, in a space above the wafer stage in the Y direction, first pre-alignment unit 30' used to perform rough position adjustment, wafer transport unit 31' used to perform transport and delivery of wafer W, and second pre-alignment unit 32' used to perform position adjustment when mounting wafer W that has been transported by wafer transport unit 31' onto wafer holder 8 are arranged. First, wafer W transported by a wafer transport unit (not shown) is transported to first pre-alignment unit 30' and rough position adjustment is performed to the wafer, and next the wafer is transported by wafer transport unit 31' and delivered to second pre-alignment unit 32', and then position adjustment is performed by second pre-alignment 32' and mounted on wafer holder 8.

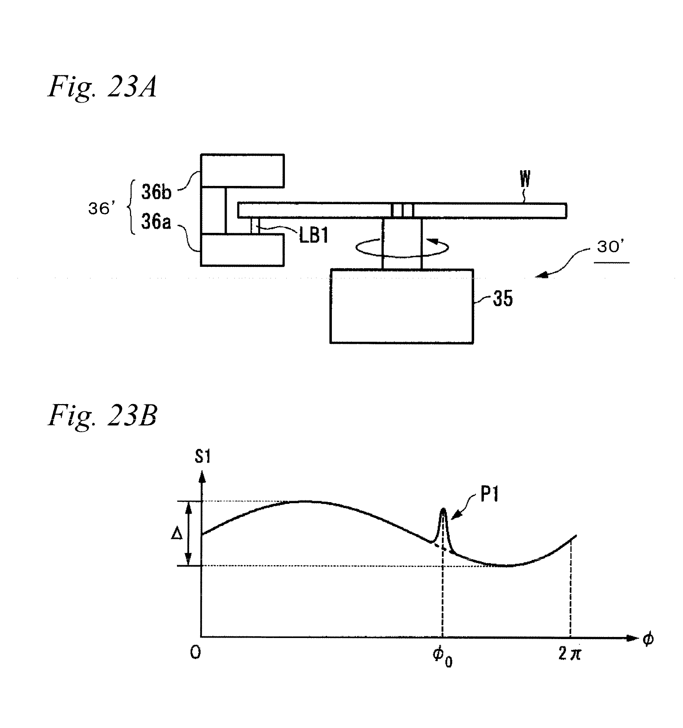

FIG. 23A is a side view showing a schematic configuration of first pre-alignment unit 30', and FIG. 23B is a view showing an example of a detection signal detected by first pre-alignment unit 30'. As is shown in FIG. 23A, first pre-alignment unit 31' is configured including a turntable 35 and an eccentricity/orientation sensor 36'. Eccentricity/orientation sensor 36' is arranged in the vicinity of turntable 35, and comprises a phototransmitting section 36a that irradiates a slit-like light beam LB1 to a circumference section of wafer W and a photodetection section 36b that receives light beam LB1 having passed through the circumference section of wafer W and photoelectrically converts light beam LB1. A detection signal S1 detected by photodetection section 36b is supplied to main controller 20.

Main controller 20 obtains a rotation amount (an orientation) and an eccentricity amount of wafer W on turntable 35 based on a change amount of detection signal S1. In other words, when turntable 35 is rotated in a state of holding wafer W by suction, a width of wafer W that passes through eccentricity sensor 36' is changed due to eccentricity of wafer W and existence of a cutout portion (an orientation flat or a notch) as an outer shape characteristic portion of the wafer, and a light amount of light beam LB1 received at photodetection section 36b changes as in FIG. 23B.

Detection signal S1 has sinusoidal shape with respect to a rotation angle $\phi$ of turntable 35 and changes so as to be a high level in a section (a section indicated by a reference mark 'P1' in FIG. 23B) corresponding to the cutout portion. Main controller 20 obtains an eccentricity amount of wafer W on turntable 35 from a change amount $\Delta$ of amplitude of detection signal S1, and also obtains a rotation angle $\phi 0$ at the time when the cutout portion is located at the center of eccentricity sensor 36' from rotation amount $\phi$ of turntable 35. Then, after rotating turntable 35 so that the cutout portion is in a predetermined direction, turntable 35 is made to be rest. Further, main controller 20 adjusts a position at the time of delivering the wafer to wafer transport unit 31' based on information on the eccentricity amount.

Referring back to FIG. 22, wafer transport unit 31' is configured of a load arm 37', an unload arm 38', a slider 39', and an arm drive system (not shown) that drives load arm 37' and unload arm' 38. Load arm 37' and unload arm 38' severally have an almost U-shaped flat plate section and wafer W is mounted on an upper surface of the flat plate. Load arm 37' is an arm that transports wafer W whose position has been adjusted by first pre-alignment unit 30' to second pre-alignment unit 32'along slider 39', and unload arm 38' is an arm that transports wafer W after exposure to first pre-alignment unit 30' along slider 39'.

Second pre-alignment unit 32' is configured including an adjustment arm 40 and image processors 17a to 17e described earlier. Adjustment arm 40 is structured movable in a vertical direction (the Z direction), and also rotatable around an axis parallel to the Z axis. Adjustment arm 40 comprises an arm sections 40a'and 40b' on which suction holes for vacuum suction (not shown) are formed, and holds wafer W that has been transported by load arm 37' on arm sections 40a' and 40b' by suction. Image processors 17a to 17e are arranged so as to have a predetermined relation with respect to wafer W held on arm sections 40a' and 40b' of adjustment arm 40. Alignment control system 22 shown in FIG. 21 calculates a rotation angle and a position in the XY plane of wafer W on adjustment arm 40 by obtaining an edge position of a detection subject of wafer W held by adjustment arm 40 from the imaging signals outputted from image processors 17a to 17e and performing a predetermined computation, and adjusts the position and the rotation of wafer W by controlling adjustment arm 40.

A center table 41 is arranged in a center portion of wafer holder 8, and wafer W whose position within the XY plane and rotation are adjusted by adjustment arm 40 is delivered to center table 41 by adjustment arm 40 moving in a downward direction (the -Z direction). Incidentally, when wafer W is delivered from adjustment arm 40 arranged in second pre-alignment unit 32' to center table 41, main controller 20 controls a wafer stage drive system (not shown) in advance to move the wafer stage so that center table 41 is located under adjustment arm 40.

Center table 41 is a member having a column shape or cylindrical shape that is supported by an expansion/contraction mechanism (not shown) arranged on X stage 6 and is fit with allowance into a through hole that is formed in a center portion of specimen support 7 and wafer holder 8, and delivers wafer W by movement in a vertical direction (the Z direction) of the extraction/contraction mechanism. On a tip of center table 41, a suction hole or a suction groove for vacuum suction is arranged, and when wafer W is delivered, the tip moves to a height at which the delivery can be performed to/from adjustment arm 40, and when the wafer is mounted on wafer holder 8, the tip moves to a lower position than a surface of wafer holder 8. Further, by the tip of center table 41 suctioning by vacuum, the wafer is not shifted when vertically moving center table 41.

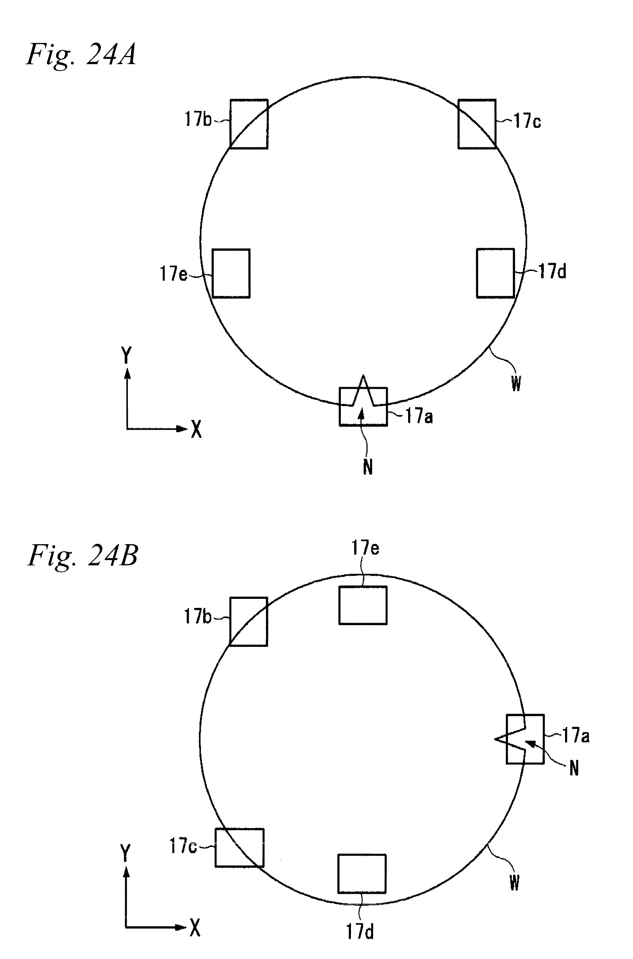

Next, the arrangement of image processors 17a to 17e will be described. FIG. 24A shows the arrangement of image processors 17a to 17e that second pre-alignment 32' comprises. As is described earlier, since the position within the XY plane and the rotation of wafer W are obtained by first pre-alignment unit 30' and the position adjustment is performed when delivering the wafer to wafer transport unit 31', a position shift at the time when wafer W is delivered to adjustment arm 40 is small (e.g., a position shift amount is several tens $\mu$m order and a rotation shift amount is several hundreds $\mu$rad order). Therefore, a positional relation between wafer W and image processors 17a to 17e is substantially a relation as shown in FIG. 24A. Incidentally, the arrangement of image processors 17a to 17e shown in FIG. 24A is the arrangement with respect to wafer W on which a notch N is formed on a part of its circumference.

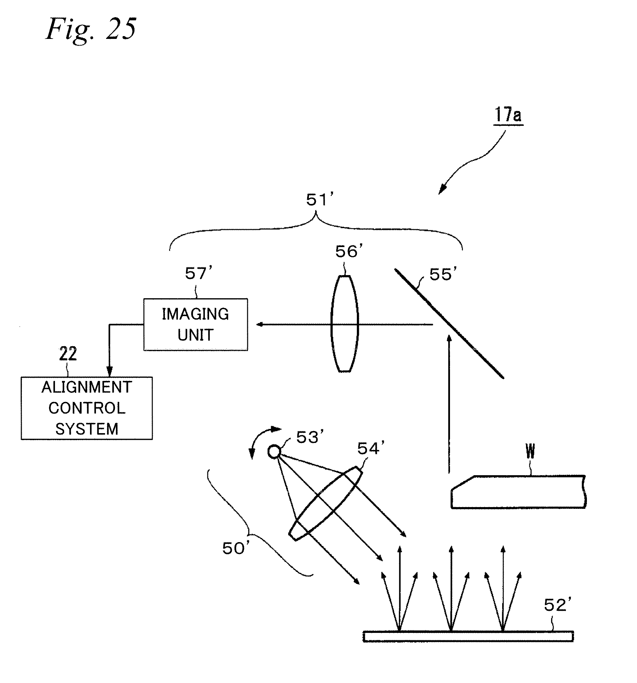

As is shown in FIG. 24A, in the case wafer W is held by arm sections 40a' and 40b' of adjustment arm 40 so that notch N faces the -Y direction, image processor 17a is located above (in the +Z direction) a position where notch N is disposed on a line that substantially passes through the center of wafer W and is parallel to the Y axis, and image processors 17b and 17c are located above positions that are different from each other on the circumference (the periphery section) of wafer W (e.g. the position at angle of almost 120 degrees away from image processor 17a with respect to the center of wafer W). Further, image processors 17d and 17e are located above arbitrary positions according to a shape of a pattern formed on a surface of wafer W. Incidentally, the positions of image processors 17d and 17e with respect to wafer W shown FIG. 24A is merely an example. A focal point of a photodetection section (refer to FIG.25) that is arranged in image processors 17a to 17e is set on wafer W held on arm sections 40a' and 40b' of adjustment arm 40.

Incidentally, as is shown FIG. 24B, in the case wafer W is held on arm sections 40a' and 40b' of adjustment arm 40 so that notch N faces the +X direction, image processor 17a is located above a position where notch N is disposed on a line that substantially passes through the center of wafer W and is parallel to the X axis, and image processors 17b and 17c are located above positions that are different from each other on the circumference (the periphery section) of wafer W (e.g. the position at angle of almost 120 degrees away from image processor 17a with respect to the center of wafer W). Also in the case of an example shown in FIG. 24B, image processors 17d and 17e are located above arbitrary positions according to a shape of a pattern formed on a surface of wafer W. Further, in the example shown in FIG. 24B, a focal point of the photodetection section arranged in image processors 17a to 17e is also set on wafer W held on arm sections 40a' and 40b' of adjustment arm 40.

Next, the configurations and the operations of image processors 17a to 17e will be described. FIG. 25 shows a side view showing a schematic configuration of image processors 17a to 17c. Incidentally, because basic configurations of image processors 17a to 17c are substantially the same, image processor 17a will be described as an example. As is shown in FIG. 25, image processor 17a is configured including an illumination system 50', a photodetection system 51' and a diffusion reflection plate 52'. Illumination system 50' is configured including a light source 53' and a collimating lens 54', and photodetection system 51' is configured including a reflection mirror 55', a condenser lens 56' and imaging unit 57'.

Light source 53' is made up of a lamp, an emission diode or the like, and emits an illumination light having a wavelength band that is less photosensitive to a photoresist coated on wafer W. Collimating lens 54' converts an illumination light emitted from light source 53' into parallel beams. Diffusion reflection plate 52' has irregularities formed on its surface, and diffuses and reflects incident beams to uniform the illuminance. Diffusion reflection plate 52' is structured movable by a drive mechanism (not shown), and is inserted and located between wafer W and wafer holder 8 in the case wafer W is held on arm sections 40a' and 40b' of adjustment arm 40 arranged in second pre-alignment 32'. Incidentally, when the image pick-up by image processors 17a to 17e is completed, diffusion reflection plate 52' is withdrawn to a position that does not block an operation at the time of mounting wafer W that has been delivered from adjustment arm 40 to center table 41 onto wafer holder 8.

Light source 53' and collimating lens 54' are disposed at a position at which an illumination light from light source ' 53 is not irradiated to an end portion of wafer W and also the illumination light can be irradiated from an oblique direction to a surface of diffusion reflection plate 52' that is inserted and located between wafer W and wafer holder 8. Illumination system 50' is structured so that the attitude (a rotation around the X axis, the Y axis and the Z axis) can be adjusted by a drive system (not shown). By adjusting the attitude of illumination system 50', an irradiation position of the illumination light with respect to diffusion reflection plate 52' can be changed. When the illumination light that has been emitted from light source 53' is irradiated to diffusion reflection plate 52' via collimating lens 54', a part of the circumference of wafer W is illuminated by the diffused and reflected light from below (from the -Z direction) with uniform illuminance.

Reflection mirror 55' is disposed above (in the +Z direction) diffusion reflection plate 52' inserted and located between wafer W and wafer holder 8 and an end portion of wafer W, and reflects the light that has diffused and reflected at diffusion reflection plate 52' and passed nearby the end portion of wafer W. Condenser lens 56' condenses the light reflected off reflection mirror 55' and forms an image on an imaging plane of imaging unit 57'. Further, condenser lens 56' makes the imaging plane of imaging unit 57' have an optically conjugate relation with the end portion of wafer W held on arm sections 40a' and 40b' of adjustment arm 40. Imaging unit 57' picks up an optical image (an optical image of a part of the circumference section of wafer W) that is formed on the imaging plane, and outputs the image signal to alignment control system 22. Since the illumination light having uniform illuminance is irradiated to the end portion of wafer W, the image of the periphery section of wafer W is clearly picked up.

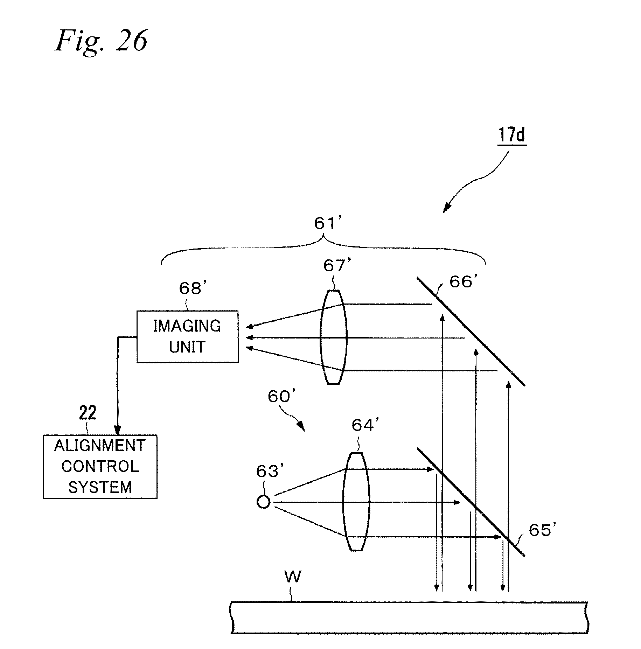

FIG. 26 is a side view showing a schematic configuration of image processors 17d and 17e. Incidentally, because basic configurations of image processors 17d and 17e are substantially the same, image processor 17d will be described as an example. As is shown in FIG. 26, image processor 17d is configured including an illumination system 60' and a photodetection system 61'. Illumination system 60' is configured including a light source 63', a condenser lens 64' and a half mirror 65', and photodetection system 61' is configured including a reflection mirror 66', a condenser lens 67' and imaging unit 68'. Light source 63' arranged in illumination system 60' is similar to illumination source 53' shown in FIG. 25, and condenser lens 64' makes an illumination light emitted from light source 63' be parallel beams.

A half mirror 65' illuminates a surface of wafer W by an epi-illumination method, by reflecting the illumination light, which has been emitted from light source 63' and made to be parallel beams by condenser lens 64', downward (in the -Z direction). Reflection mirror 66', condenser lens 67' and imaging unit 68' are respectively similar to reflection mirror 55', condenser lens 56' and imaging unit 57' shown in FIG. 25. The end portion of wafer W is illuminated in a transmission illumination method using diffusion reflection plate 52' in FIG. 25, while the inside portion of wafer W is illuminated by an epi-illumination method using condenser lens 64' in FIG. 26.

Next, a measurement method of loading repeatability of wafer W performed in main controller 20 will be described. In this case, loading repeatability of wafer W is measured by measuring position information of a mark (a search alignment mark) formed on wafer W whose position is set at a predetermined position (a predetermined datum position) on wafer holder 8 via center table 41 from second pre-alignment unit 32', using an alignment sensor 15' by an off-axis method that is arranged lateral to projection optical system PL.

Position measurement of a search alignment mark by alignment sensor 15' is processing that is normally performed as one of exposure processing to wafer W mounted on wafer holder 8, and that is necessarily performed to each of wafers W. Further, in measurement of position setting repeatability of wafer W, a plurality of wafers W are sequentially disposed on wafer holder 8 and position information thereof needs to be measured, while normal exposure processing is performed to a lot consisting of a plurality of wafers W as a unit. Therefore, in the embodiment, position setting repeatability of wafer W can be measured without suspending the exposure processing and decreasing the throughput (the number of wafers W to which the exposure processing can be performed in a unit time).

However, in the case the wafer position setting repeatability using a wafer (a process wafer) on which a device pattern is actually transferred, without using a datum wafer as in the conventional method, an outer shape and a deformation state of a wafer, a break state of a mark (a pattern) formed on a wafer and the like are not always the same even in the same lot, and they are often different depending on wafers. Therefore, since measurement results of the wafer position setting repeatability necessarily include error components due to these causes, and variations occur in position setting repeatability remeasurement results due to these error components, the error components need to be removed. Thus, in the embodiment, as main error causes, the following two error causes are normalized as described below,.

(A) Normalization of difference between wafers in a relation between a wafer outer shape and a position of a pattern formed on a wafer

Because an outer shape of each process wafer (wafer W) has an error, an outer shape difference between wafers W becomes an error cause in the wafer position setting repeatability measurement. In order to remove the error cause, in the embodiment, imaging signals from image processors 17a to 17e are used. First, an outer shape reference coordinate system is set. The 'outer shape reference coordinate system' is a coordinate system that is based an outer shape of a wafer (a substrate) as a datum, and is, for example, a two-dimensional coordinate system that is substantially parallel to a surface of wafer W and is set by at least one datum point (e.g. a notch) on the outer edge (the contour) of the wafer. Specifically, the outer shape reference coordinate system is a coordinate system that is set by a center (a position within the XY plane) and a rotation angle of wafer W that are obtained based on the imaging signals from image processors 17a to 17c at the time when wafer W is held on arm sections 40a' and 40b' of adjustment arm 40.

Next, based on the imaging signals by image processors 17d and 17e, from results of picking up an image of a characteristic portion of an exposure pattern formed on wafer W, a position of the characteristic portion on wafer W is obtained, and based on the position, a position and an inclination of the exposure pattern in the outer shape reference system are computed. Then, by correcting measurement results (Y, θ, X) of the search mark by alignment sensor 15' using the differences of the position and the inclination of the exposure pattern between wafers W, variations between wafers W in the measurement results of the position setting repeatability due to the wafer outer shape difference can be normalized.

To be more specific, this correction is performed by converting the difference in a position and an inclination of an exposure pattern of each of the second and succeeding wafers of the lot processing, which is obtained when using a position and an inclination of an exposure pattern of a wafer at the head (hereinafter sometimes referred to as a 'first wafer') of the lot processing as a datum, into a deviation amount in the measurement result of the search mark, and subtracting the deviation amount from the measurement result of the search mark of each wafer. Incidentally, it is preferable that the characteristic portions of the exposure pattern whose images are picked up by image processors 17d and 17e are located at two points that have the same coordinates in a first axis direction (e.g. the Y direction) and are spaced apart to some extent in a second axis direction (e.g. the X direction) orthogonal to the first axis direction. Normally, the two points are selected from the points on a scribe line or near an exposure shot map, and patterns that are unique within the measurement fields of image processors 17d and 17e are used.

(B) Normalization of difference between wafers due to a deformation component of a wafer and a deformation component of a mark used for search measurement

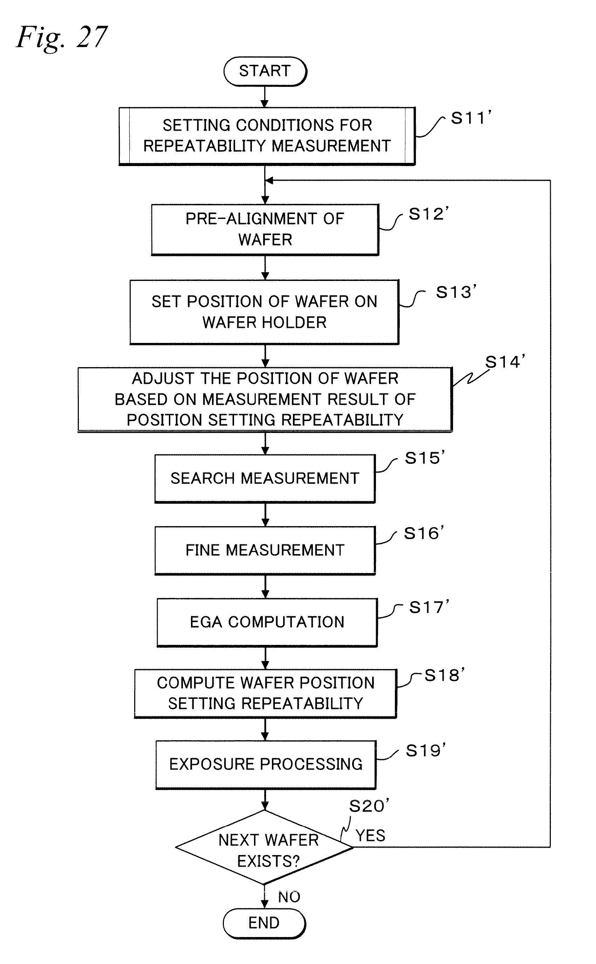

An exposure pattern or a mark formed on a process wafer is sometimes linearly or nonlinearly deformed even on the wafers in the same lot due to various causes such as a suction state on exposure of each wafer or an exposure state. For the reason, there are some cases where a position or a shape of a search mark is different between wafers W and such difference in the deformation components between wafers W become error causes in the wafer position setting repeatability measurement, and therefore the error causes need to be removed. The deformation components correspond to differences between wafers of an array coordinate system of a plurality of shot areas that are formed in an array on wafer W that are obtained by alignment processing (refer to S16' and S17' in FIG. 27), with respect to the outer shape reference coordinate system described earlier. Accordingly, by correcting position information of a search alignment mark that is measured in search measurement (refer to S15' in FIG. 27), using an alignment correction amount computed in this alignment processing, variations between wafers W in measurement results of position setting repeatability due to the deformation components can be normalized.

In the alignment processing, when premising that the computation with six parameters (rotation Θ, offsets Ox and Oy, an orthogonality degree Ω, and magnifications Γx and Γy of a shot array) is used as the EGA computation, as the alignment correction amount used in the normalization in the above (B), an offset component and a rotation component are not used since the offset component and the rotation component are substantially corrected in the case the normalization in the above (A) is implemented, at least one of a magnification component and an orthogonality degree component is used. Further, in the case the computation with ten parameters (besides the six parameters described above, rotation θ, an orthogonality degree ω, magnifications γx and γy of shot areas) is used as the EGA computation, a correction amount related to shots may be used, and whether or not to use the correction amount related to shots can preferably be selected and designated. Moreover, in the case the EGA computation of a high order is implemented taking into consideration not only the linear components described above but also a non-linear component (a random component), the linear and non-linear components may be used in accordance with the selection. In this case, as the alignment correction amount, the magnification component, the orthogonality degree component and the random component are to be used.

More specifically, this correction is performed by converting the difference in an alignment correction amount (the magnification component, the orthogonality degree component and the random component) of each wafer of the second and succeeding wafers of the lot processing, which is obtained when using an alignment correction amount (the magnification component, the orthogonality degree component and the random component) in the position of the search mark with respect to a wafer at the head (hereinafter sometimes referred to as a 'first wafer') of the lot processing as a datum, into a deviation amount in the position of the search mark, and subtracting the deviation amount from the measurement result of the search mark of each wafer. Incidentally, in most cases, the random component is small enough to be ignored compared with the accuracy of the wafer position setting repeatability, and in such cases the random component may be omitted accordingly. However, it is preferable to use the random component for judging the adequacy of measurement data of a wafer when the measurement data is used in the position setting repeatability measurement of the wafer. For example, a threshold value is set in advance and in the case a random component exceeds the threshold value, a wafer is judged to be an abnormal wafer, and the measurement data related to the abnormal wafer is preferably not used in the measurement of the wafer position setting repeatability.

The evaluation factors of the wafer position setting repeatability will be described as follows. Main controller 20 performs evaluation of the measured position setting repeatability of wafer W using the following twelve evaluation values.

(1) Y(3σ) [μm]
(2) Y(Max-Min) [μm]
(3) Y(Mean) [μm]
(4) θ(3σ) [μm]
(5) θ(Max-Min) [μm]
(6) θ(Mean) [μm]
(7) Y-θ(3σ) [μm]
(8) Y-θ(Max-Min) [μm]
(9) Y-θ(Mean) [μm]
(10) X(3σ) [μm]
(11) X(Max-Min) [μm]
(12) X(Mean) [μm]

The above (1) to (3) are evaluation values used to evaluate variation in the position of wafer W in a search y mark, the above (4) to (6) are evaluation values used to evaluate variation in the position of wafer W in a search θ mark, the above (7) to (9) are evaluation values used to evaluate variation in a difference of a detection position in a y direction between the search y mark and the search θ mark, and the above (10) to (12) are evaluation values used to evaluate variation in the position of wafer W in a search x mark. In this case, design coordinates in the y direction of the search y mark and the search θ mark are the same. In the search measurement, from detection y coordinates of the search y mark and the search θ mark that are spaced apart a predetermined distance in an x direction, a rotation amount of a wafer and a wafer center y position are obtained, and from a detection x coordinate of the search x mark, a wafer center x position is obtained. Each of the variations is evaluated using 3σ(σ is standard deviation), a difference between the maximum value (Max) and the minimum value (Min), and a mean value.

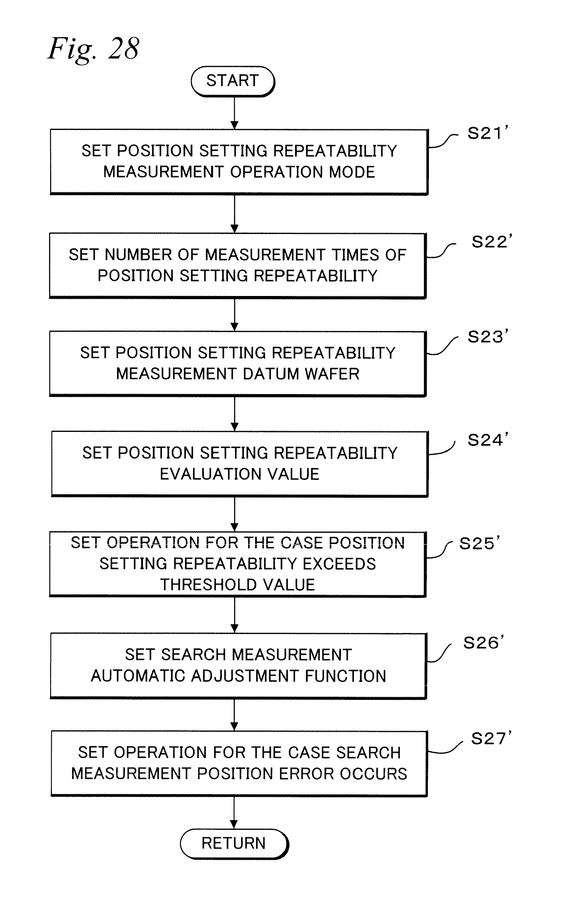

Next, a series of exposure processing performed by the exposure apparatus will be described with reference to a flowchart shown in FIG. 27. When the exposure processing starts, first, condition setting related to position setting repeatability measurement of wafer W is performed (step S11'). In this processing, main controller 20 displays setting items on the screen of a display operation panel or a computer (not shown), and an operator performs an operation of selecting or inputting necessary setting items. FIG. 28 shows a flowchart of condition setting processing related to the position setting repeatability of wafer W.

When the processing starts, first, setting processing of an operation mode of the position setting repeatability measurement of wafer W is performed (step 21'). In this processing, the operator performs the setting of presence/absence of execution of the position setting repeatability measurement of wafer W, presence/absence of execution termination conditions, and the number of lots or wafers W to which the position setting repeatability measurement of wafer W is performed. Incidentally, presence/absence of the execution termination conditions is set only in the case execution of the position setting repeatability measurement is set to the presence, and the number of lots or wafers W to which the position setting repeatability measurement of wafer W is performed is set only in the case the execution termination conditions are set to the presence. In the setting of the number of wafers W, the setting as to whether or not the wafers can be of different lots is also performed. In this case, since the variation between wafers W are normalized as is described above, the position setting repeatability can be measured even when wafers W are of different lots as far as the same process processing is performed to the wafers.

Next, the setting processing of the number of measurement times of the position setting repeatability is performed (step S22'). In this processing, the operator performs the setting of the number of wafers W to be used for the position setting repeatability measurement. In order to stabilize the value of 3σ, normally the number that is equal to or greater than 10 and equal to or smaller than the number of wafers W included in one lot (e.g. 25 wafers) is set. Incidentally, in the case the number of wafers W that are actually measured exceeds the set number of wafers W when measuring the position setting repeatability, the position setting repeatability is measured, sequentially using new measurement results while discarding the old measurement results in terms of time.

Then, the setting processing of a position setting repeatability measurement datum wafer is performed (step S23'). In this case, the datum wafer is a wafer that is used as a datum when normalizing variation in a shape error of a pattern between wafers W, and is quite different from a datum wafer that has been used in the conventional technology. Normally, wafer W at the head of a lot is set as a datum wafer, however, in the embodiment, since the position setting repeatability measurement can be performed not only per lot, but also with respect to the designated number of wafers, there is the processing to set a datum wafer. However, in the case a datum wafer is updated, the number of measurement times of the position setting repeatability is reset.

Next, the setting of position setting repeatability evaluation values is performed (step S24'). In this processing, the operator performs the setting of evaluation values used to evaluate the measured position setting repeatability of wafer W. From among twelve evaluation values described earlier, (1), (2), (4), (5), (10) and (11) are to be designated. Further, in this case, an abnormality judgment threshold value with respect to each designated evaluation value is also set. Normally, a threshold value is determined based on a size of a measurement field used for search measurement, a size of a search mark and the like, and for example, about 15 [μm] is set with respect to 3σ, about 30 [μm] is set with respect to a difference between the maximum value (Max) and the minimum value (Min).

Then, the setting for the case of exceeding the position setting repeatability threshold value is performed (step S25'). In this processing, the operator performs the setting of an operation to be performed by the exposure apparatus when the evaluation value set in the above step S24' exceeds the threshold value set in the same step. For example, presence/absence of display of an error message, presence/absence of an error report notice, presence/absence of continuous execution of exposure processing to the lot, presence/absence of switching to a maintenance mode, and the lie are set.

Next, the setting of search measurement automatic adjustment function is performed (step S26'). In this processing, the operator performs the setting as to whether or not to automatically adjust a search measurement position in accordance with evaluation results of the measured position setting repeatability of wafer W. In other words, in the case the position of wafer W is not set with a predetermined repeatability, a search mark formed on wafer W is located outside a measurement field of an alignment sensor when measuring position information of the search mark, and a measurement error occurs. Therefore, the measurement error is prevented from occurring, by adjusting the position of wafer W in advance in accordance with tendency of the position setting repeatability of wafer W.

Finally, the setting for the case of search measurement position error occurring is performed (step S27'). In this processing, the operator performs the setting of an operation to be performed by the exposure apparatus when a search measurement position error occurs. For example, presence/absence of display of an error message, presence/absence of an error report notice, presence/absence of continuous execution of exposure processing to the lot, presence/absence of switching to a maintenance mode, presence/absence of execution of an automatic retry function, presence/absence of automatic switching to 'ON' in the case the set search measurement automatic adjustment function is 'OFF', presence/absence of automatic correction of search measurement automatic adjustment parameter in the case the search measurement automatic adjustment function is 'ON', and the like are set.

In this case, the automatic correction of the search measurement automatic adjustment parameter is to automatically correct a search measurement position or a search measurement range from the measurement results of the position setting repeatability. In the automatic correction, based on the least-squares method from a mean value of the position setting repeatability of wafer W that is measured most recently or from each measurement result, a search measurement position of a search mark to which search measurement is to be performed is predicted, and the search measurement position is corrected using the predicted value. Further, from the measurement result of the position setting repeatability of wafer W that is measured most recently, a search measurement range of a search mark to which search measurement is to be performed is predicted, and the search measurement range is corrected using the predicted value. As is described so far, the condition setting related to the position setting repeatability of wafer W is completed. Incidentally, in the embodiment, the search measurement automatic adjustment function is assumed to be set to 'ON'.

When the condition setting is completed, for example, wafer W at the head of a lot is taken out of, for example, a wafer cassette (not shown) housing wafers of one lot, and the wafer is transported to first pre-alignment unit 30' by a wafer transport unit (not shown). First pre-alignment unit 30' outputs detection signal S1 (refer to FIG. 23B) outputted from eccentricity sensor '36 to main controller 20, while rotating turntable 35. Main controller 20 obtains an eccentricity amount and a rotation amount of wafer W based on a change amount of detection signal S1. Then, by rotating turntable 35 based on the obtained eccentricity amount and rotation amount so that notch N formed on wafer W is in a predetermined direction, a rotation amount of wafer W is corrected on turntable 35.

Wafer W to which the above-described processing is completed is delivered from first pre-alignment unit 30' to load arm 37' of wafer transport unit 31'. At this point of time, wafer W is delivered to load arm 37' of wafer transport unit 31' after main controller 20 performs position adjustment of wafer W based on information on the eccentricity amount obtained by the processing above. Wafer W is transported to second pre-alignment unit 32' by load arm 37' moving along slider 39'.

The position of adjustment arm 40 arranged at second pre-alignment unit 32' is set to a position of predetermined height, and load arm 37' transports wafer W until wafer W is located to a predetermined position above arm sections 40a' and 40b' arranged at adjustment arm 40. When adjustment arm 40 moves upward (in the +Z direction) at the time when the transportation by load arm 37' is completed, wafer W is held by suction on arm sections 40a' and 40b' of adjustment arm 40 and also adjustment arm 40 moves away from load arm 37', thereby wafer W is delivered to adjustment arm 40.

When wafer W is delivered onto adjustment arm 40, image processors 17a to 17c pick up images of three points that are different from each other on the circumference (the periphery section) of wafer W shown in FIG. 24A or FIG. 24B, and the image signals are outputted to alignment control system 22. Alignment control system 22 obtains edge positions of detection subjects of wafer W held on adjustment arm 40 from the image signals, performs a predetermined computation processing, and calculates a rotation angle and a position within the XY plane of wafer W on adjustment arm 40. The rotation angle of wafer W is adjusted by alignment control system 22 rotating adjustment arm 40 around the Z axis.

Position information that indicates the position of wafer W within the XY plane is outputted from alignment control system 22 to main controller 20, and a relative positional relation of center table 41 with respect to wafer W is finely adjusted by main controller 20 adjusting the position of the wafer stage within the XY plane. With this operation, a position deviation within the XY plane of wafer W on adjustment arm 40 is eliminated by delivering wafer W to center table 41, even when the position deviation within the XY plane of wafer W is generated on adjustment arm 40. Further, image processors 17d and 17e pick up images of characteristic portions on a surface of wafer W and the image signals are outputted to alignment control system 22, and the positions of the characteristic portions on wafer W are obtained. Position information that indicates the positions of the characteristic portions is outputted to main controller 20. With the processing described above, the pre-alignment of wafer W is completed (step 12').

When the pre-alignment of wafer W is completed, the processing of setting a position of wafer W, which has been delivered from adjustment arm 40 to center table 41, on wafer holder 8 (step S13'). Next, an operation of delivering wafer W from adjustment arm 40 to center table 41 and an operation of setting a position of wafer W on center table 41 onto wafer holder 8 will be described in detail.

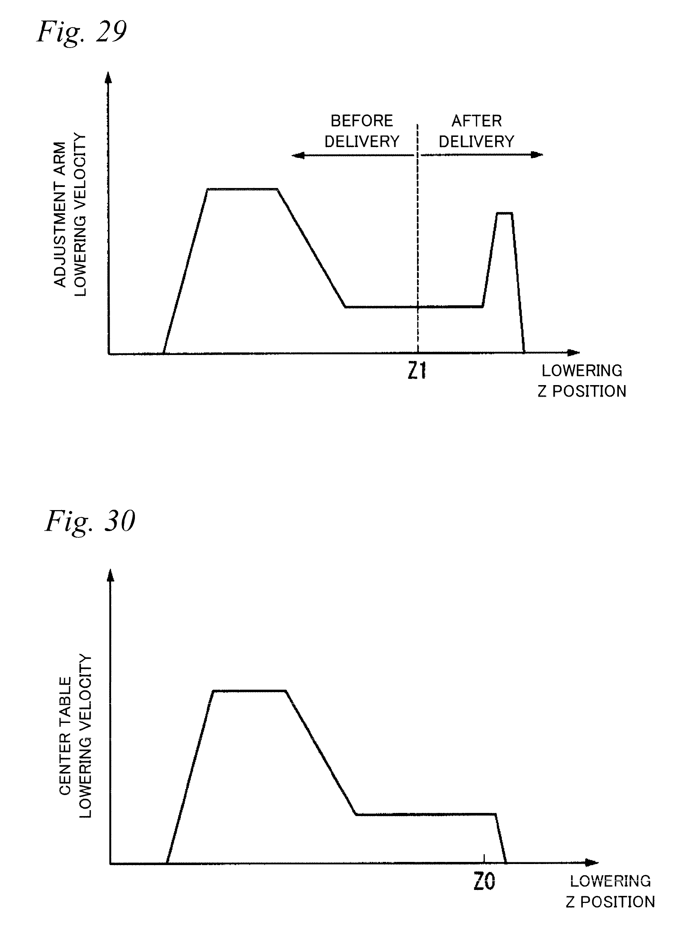

FIG. 29 is a view that shows an example of a lowering operation of adjustment arm 40 when delivering wafer W from adjustment arm '40 to center table 41. Incidentally, a graph shown in FIG. 29 has a vertical axis showing a lowering speed of adjustment arm 40 and a horizontal axis showing a lowering Z position of adjustment arm 40. In this case, the lowering Z position is a position in the Z direction when adjustment arm 40 is lowered, and nearing to the right side along the horizontal axis means that adjustment arm 40 is being lowered.

When delivering wafer W from adjustment arm 40 to center table 41, center table 41 is moved in an upper direction (the +Z direction) in advance and is arranged at a top dead center (a position to which center table 41 can be moved the most in an upper direction). Center table 41 is disposed at the top dead center because the stability is taken into consideration. In FIG. 29, a position Z1 is a delivery position of wafer W from adjustment arm 40 to center table 41. As is shown in FIG. 29, a lowering speed is increased and adjustment arm 40 is lowered with a high speed before the delivery of wafer W.

When the lowering Z position of adjustment arm 40 comes closed to delivery position Z1, the lowering speed is decreased and adjustment arm 40 is lowered with a low speed. When adjustment arm 40 reaches delivery position Z1, suction by center table 41 is started and holding by suction of adjustment arm is released, thereby wafer W is delivered from adjustment arm 40 to center table 41. After that, in order to shorten a period of time required for the delivery as much as possible, the lowering speed of adjustment arm 40 is increased again.

FIG. 30 is a view that shows an example of a lowering operation of center table 41 when delivering wafer W from center table 41 to wafer holder 8. Incidentally, a graph shown in FIG. 30 has a vertical axis showing a lowering speed of center table 41 and a horizontal axis showing a lowering Z position of center table 41. In FIG. 30, a position Z0 is a height position of wafer holder 8. When delivering wafer W from center table 41 to wafer holder 8, a lowering speed is increased and center table 41 is lowered with a high speed as is shown in FIG. 30.

When the lowering Z position of center table 41 comes close to height position Z0 of wafer holder 8, the lowering speed is decreased and center table 41 is lowered with a low speed, and when center table 41 reaches height position Z1 of wafer holder 8, suction by wafer holder 8 is started and holding by suction of center table 41 is released, thereby wafer W is delivered from center table 41 to wafer holder 8. When the delivery of wafer W is completed, the speed of center table 41 is decelerated and the lowering is stopped. With the operation described above, a position of wafer W is set on the wafer holder.

Referring back to FIG. 27, when the position setting of wafer W on wafer holder 8 is completed, processing of adjusting a position of wafer W based on position setting repeatability measurement results is performed (step S14'). In this case, since the position setting repeatability measurement has not been performed yet, this processing is omitted and search measurement is performed (step S15'). In the search measurement, position information of a search mark formed on wafer W is measured by alignment sensor 15'. The measurement results are outputted to main controller 20 and used to obtain a rough position of wafer W whose position is set on wafer holder 8, and also used for position setting repeatability measurement of wafer W whose position is set on wafer holder 8.

When the search measurement is completed, fine measurement is performed next (step S16'). In the fine alignment, by using alignment sensor 15', alignment marks (fine alignment marks) that are formed along with the predetermined number (three to nine) of shot areas from among a plurality of shot areas set on wafer W are measured, and the measurement results are outputted to alignment control system 22. Then, an array of the shot areas set on wafer W is accurately obtained by alignment control system 22 performing the EGA computation using the measurement results of the fine measurement. Information indicating an array of the shot areas and information indicating an array error of shot areas obtained on the EGA computation and the like are outputted to main controller 20 (step S17').

Then, main controller 20 computes the position setting repeatability of wafer W whose position is set on wafer holder 8 (step S18'). In this processing, the position setting repeatability of wafer W is computed using measurement results by the search measurement performed in step S15'. In this case, as is described earlier, in order to normalize differences between wafers, main controller 20 performs normalization processing of the (A) and (B) described earlier from the search measurement results.

When the processing described above is completed, based on results of the EGA computation performed in step S17', a position of one of shot areas set on wafer W is set at an exposure position (a position where a pattern of reticle R is projected), and a pattern of reticle R is transferred onto wafer W via projection optical system PL. After transferring the pattern on one shot area, a shot area to be exposed next is located at the exposure position and a pattern is transferred. Likewise, all the shot areas set on wafer W are sequentially exposed.

When the exposure processing to all the shot areas on wafer W is completed, holding by suction of wafer W by wafer holder 8 is released and center table 41 is raised, and wafer W after the processing is delivered to unload arm 38' to be taken out. Main controller 20 judges whether or not wafer W to which the exposure processing is to be performed next exists (step S20'), and in the case the judgment is made that such wafer W exists (the judgment result is 'YES'), the processing in step S12' and the subsequent steps is repeated. Incidentally, though FIG. 27 shows that pre-alignment of a wafer to which the exposure processing is to be performed next is performed after the previous exposure processing is completed for the sake of convenience, in actual, pre-alignment of the next wafer is performed in the middle of performing the exposure processing to the previous wafer.

When pre-alignment of next wafer W is performed (step 12') and a position of the wafer is set on wafer holder 8 (step S13'), the processing of adjusting the position of wafer W is performed based on the position setting repeatability measurement results (step S18'). In this processing, the position of wafer W is adjusted in accordance with tendency of the position setting repeatability of wafer W obtained from the position setting repeatability measurement. Such adjustment makes it possible to reduce occurrence of measurement errors using alignment sensor 15'.

When the processing described above is completed, after sequentially performing the search measurement (step S15'), the fine measurement (step S16') and the EGA computation (step S18'), the wafer position setting repeatability is computed (step S18'). In this case, because wafer W whose position is set on wafer holder 8 is not wafer W at the head of a lot, the normalization is performed using wafer W at the head of the lot as a datum. When the processing above is sequentially repeated, wafer W to be exposed next does not exist and the judgment result in step S20' becomes 'NO', a series of exposure processing is completed.

As is described so far, in the embodiment, since the position setting repeatability of wafer W is measured using the measurement results of the search measurement that is normally performed during the exposure processing, it is not necessary to stop the exposure processing and separately perform wafer position setting repeatability check, and therefore, the position setting repeatability of wafer W can be measured without decreasing exposure processing efficiency. Further, because errors caused by variation in the outer shape or deformation between wafers W are excluded, the position setting repeatability of wafer W can be measured with good accuracy. Moreover, since the measurement of the wafer position setting repeatability can be performed at all times during operation of the exposure apparatus, a maintenance timing of a transport system of wafer W or the like can be predicted in the case the position setting repeatability is lowered (deteriorated), and accordingly sudden breakdown of the apparatus due to deterioration of the repeatability can be avoided. In addition, since the measurement position of a search alignment mark in the search measurement can be automatically adjusted in accordance with tendency of the wafer position setting repeatability, the occurrence of measurement errors can be suppressed. In the case such automatic adjustment is carried out, it is also possible that the search alignment is omitted and the fine alignment is implemented in the case the position setting repeatability of wafer W can be maintained to a sufficiently good level.

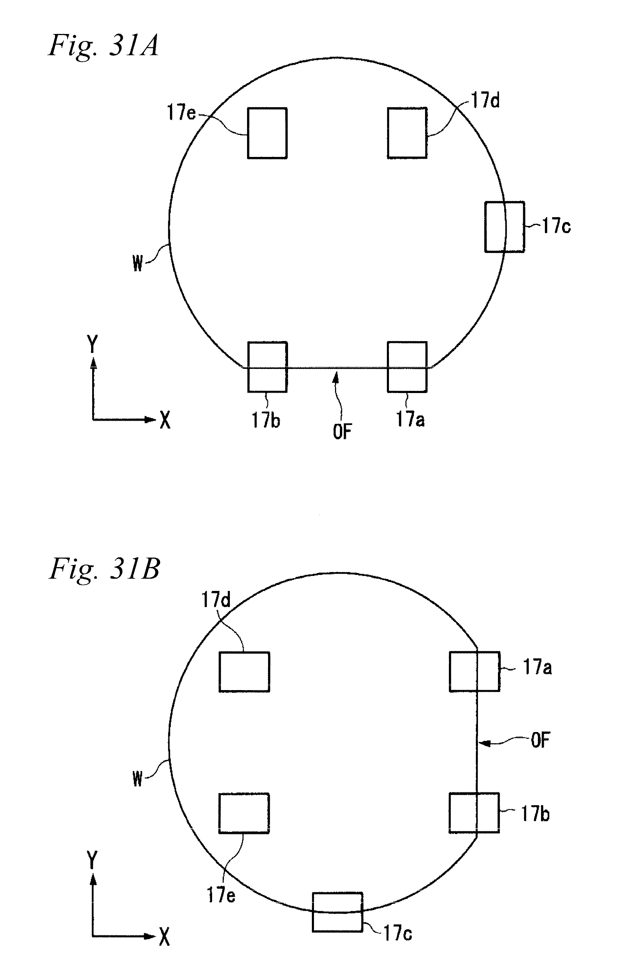

Next, the modified example of the embodiment of the present invention will be described. FIGS. 31A and 31B are views that show other arrangements of image processors 17a to 17e that second pre-alignment unit 32' comprises. The arrangement shown in FIG. 31A is an arrangement in the case orientation flat OF is formed on wafer W. As is shown in FIG. 31A, in the case wafer W is held on arm sections 40a' and 40b' of adjustment arm 40 so that orientation flat OF faces the -Y direction, image processors 17a and 17b are located at positions where image processors 17a and 17b pick up images of both end portions of orientation flat OF located in the -Y direction with respect to wafer W, and image processors 17c is located at a position where image processors 17c picks up an image of an edge portion (an edge portion in the +X direction of wafer W in the example shown in FIG. 31A) of wafer W other than orientation flat OF.

Further, image processors 17d and 17e are located above arbitrary positions according to a shape of a pattern formed on a surface of wafer W. The positions of image processors 17d and 17e with respect to wafer W shown in FIG. 31A are merely examples. Focal points of photodetection sections (refer to FIG. 25) arranged in image processors 17a to 17e are set on wafer W held on arm sections 40a' and 40b' of adjustment arm 40.

As is shown in FIG. 31B, in the case wafer W is held on arm sections 40a' and 40b' of adjustment arm 40 so that orientation flat OF faces the +X direction, image processors 17a ad 17b are located at positions where image processors 17a ad 17b pick up images of both end portions of orientation flat OF located in the +X direction with respect to wafer W, and image processor 17c is located at a position where image processor 17c picks up an image of an edge portion (an edge portion in the -Y direction of wafer W in the example shown in FIG. 31B) of wafer W other than orientation flat OF. Also in the example shown in FIG 31B, image processors 17d and 17e are located above arbitrary positions according to a shape of a pattern formed on a surface of wafer W. Further, in the example shown in FIG. 31B, focal points of photodetection sections arranged in image processors 17a to 17e are also set on wafer W held on arm sections 40a' and 40b' of adjustment arm 40.

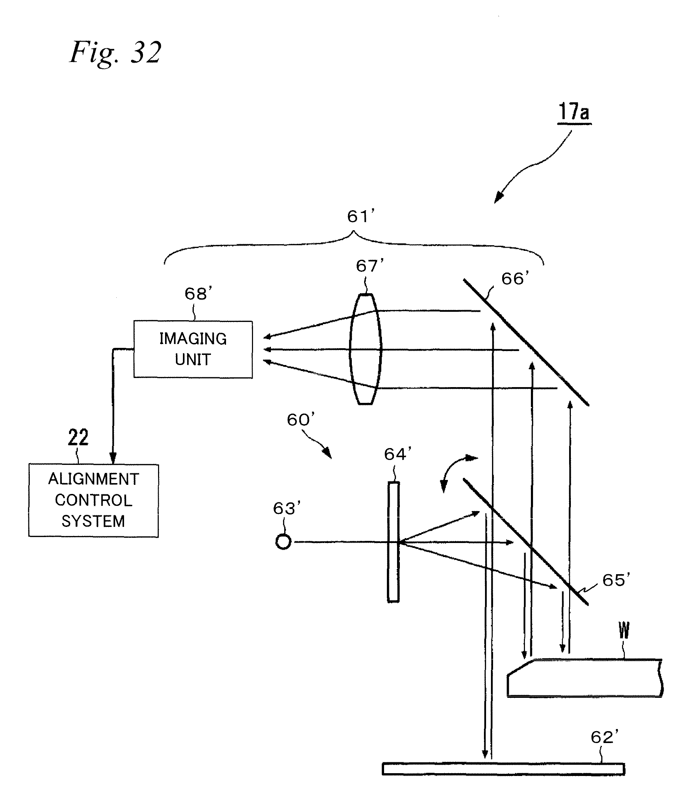

Incidentally, image processor 17d having the configuration shown FIG. 26 is modified to a configuration in FIG. 32 and can also be used as image processors 17a to 17c that pick up an image of the circumference section of wafer W. FIG. 32 is a side view that shows another schematic configuration of image processors 17a to 17c. Incidentally, since basic configurations of image processors 17a to 17c are substantially the same, image processor 17a will be described as an example here. As is shown in FIG. 32, image processor 17a has a photodetection system 61' that has the same structure as image processors 17d shown in FIG. 26. However, in order to pick up an image of a reflected light from an end portion of wafer W, image processor 17a shown in FIG. 32 is different from image processors 17d shown in FIG. 26 in a structure of diffusion plate 64' and a driven type mirror 65' of illumination system 60' and in comprising a background plate 62'.

Background plate 62' is formed of a member having a low reflectance such as black ceramic and is structured movable by a drive mechanism (not shown) as diffusion reflection plate 52', and is inserted and located between wafer W and wafer holder 8 in the case wafer W is held on arm sections 40a' and 40b' of adjustment arm 40 that is arranged in second pre-alignment unit 32'. When the image pick-up by image processors 17a to 17e is completed, background plate 62' is withdrawn to a position that does not block an operation when mounting wafer W, which has been delivered from adjustment arm 40 to center table 41, onto wafer holder 8. Image processor 17a shown in FIG. 32 can irradiate an illumination light to across a wide range of an end portion of wafer W by diffusing the illumination light from light source 63' with diffusion plate 64' and further by making an incident angle of the illumination light adjustable with driven type mirror 65'. Further, by arranging background 62' having a low reflectance, contrast of the end portion of wafer W can be improved.

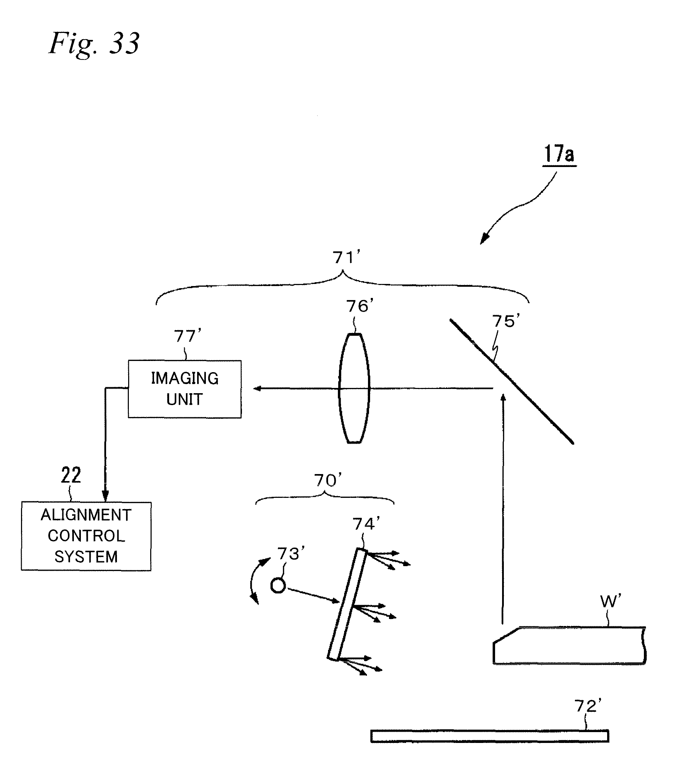

FIG. 33 is a side view that shows yet another schematic configuration of image processors 17a to 17c. Incidentally, since basic configurations of image processors 17a to 17c are substantially the same, image processor 17a will be described as an example here. As is shown in FIG. 33, image processor 17a is configured including an illumination system 70', a photodetection system 71' and a background plate 72'. Illumination system 70' is configured including a light source 73' and a diffusion plate 74', and photodetection system 71' is configured including a reflection mirror 75', a condenser lens 76' and imaging unit 77'. Light source 73' arranged in illumination system 70' is similar to light source 53' shown in FIG. 25, and diffusion plate 74' diffuses an illumination light emitted from light source 73'. Diffusion plate 74' is arranged in order to widen a uniform illumination area on wafer W.

Background plate 72' is formed of a member having a low reflectance such as black ceramic similarly to background plate 62' shown in FIG. 32, and is structured movable by a drive mechanism (not shown) similarly to diffusion reflection plate 52' shown in FIG. 25, and is inserted and located between wafer W and wafer holder 8 in the case wafer W is held on arm sections 40a' and 40b' of adjustment arm 40 arranged in second pre-alignment unit 32'. Incidentally, similarly to back ground plate 62' shown in FIG. 32, when the image pick-up by image processors 17a to 17e is completed, background plate 72' is withdrawn to a position that does not block an operation when mounting wafer W, which has been delivered from adjustment arm 40 to center table 41, on wafer holder 8.

Light source 73' and diffusion plate 74' are disposed at positions where an illumination light from light source 73' is irradiated to an end portion of wafer W from an oblique direction. Illumination system 70' is configured so that an attitude (a rotation around the X axis, the Y axis and the Z axis) can be adjusted by a drive system (not shown). By adjusting the attitude of illumination system 70', an irradiation position of the illumination light to the end portion of wafer W can be changed. Reflection mirror 75', condenser lens 76' and imaging unit 77' are similar to reflection mirror 55', condenser lens 56' and imaging unit 57' shown in FIG. 25, respectively.

Incidentally, the embodiment explained above is described in order to facilitate the understanding of the present invention, but not to limit the present invention. Accordingly, each element disclosed in the embodiment above includes all design changes or equivalents that belong to the technical scope of the present invention. For example, in the embodiment above, images of an end portion and a characteristic portion of wafer W are picked up on adjustment arm 40 arranged in second pre-alignment unit 32', however, with the configuration in which adjustment arm 40 is omitted, the images of an end portion of wafer W held on center table 41 and a characteristic portion of a surface of wafer W may be picked up. In the case of this configuration, only one image processor to pick of an image of a characteristic portion of a surface of wafer W is arranged, and the image of a characteristic portion may be picked up at two different points by moving the wafer stage within the XY plane.

Further, in the embodiment above, though the images of an end portion and a characteristic portion of wafer W are picked up on adjustment arm 40 arranged in second pre-alignment unit 32', the images of an end portion and a characteristic portion of wafer W mounted on wafer holder 8 may be picked up. In this case, only one image processor to pick up an image of the circumference of wafer W is arranged, and the image of the circumference section may be picked up at three different points by moving the wafer stage within the XY plane. Further, also only one image processor to pick of an image of a characteristic portion of a surface of wafer W is arranged, and the image of a characteristic portion may be picked up at two different points by moving the wafer stage within the XY plane. Still further, likewise, the image pick-up of the circumference section of the wafer at three points and the image pick-up of the characteristic portion at two points may be performed by a single image processor. Since the position of the wafer stage is controlled by interferometer 13 with high precision, such measurement is possible.

In the embodiment above, position information of search alignment marks and fine alignment marks formed on wafer W is measured using alignment sensor 15' arranged lateral to projection optical system PL, however, position information of these marks may be measured using alignment sensor 14' via projection optical system PL.

Further, in the embodiment above, the case is described where a KrF excimer laser light (248nm), an ArF excimer laser light (193nm), a g-line (436nm), an i-line (365nm), an $F_2$ laser light (157nm) or the like is used as an illumination light for exposure. However, the illumination light for exposure is not limited to them, and an $Ar_2$ excimer laser (126nm), a harmonic wave such as a copper vapor laser, a YAG laser or a semiconductor laser, or the like can be used as an illumination light for exposure. Further, as is disclosed in, for exmpale, the pamphlet of International Publication No. WO 99/46835, as the illumination light, a harmonic wave may be used that is obtained by amplifying a single-wavelength laser beam in the infrared or visible range emitted by a DFB semiconductor laser or fiber laser, with a fiber amplifier doped with, for example, erbium (or both erbium and ytteribium), and by converting the wavelength into ultraviolet light using a nonlinear optical crystal.

Further, in the exposure of the embodiment above, as the projection optical system, any of a reduction system, and an equal magnification or a magnifying system may be used, and the projection optical system may be any of a dioptric system, a catadioptric system and a catoptric system. Incidentally, a projection optical system composed of a plurality of lenses is incorporated into the exposure apparatus main body. Then, optical adjustment is performed, and also the reticle stage and the wafer stage made up of multiple mechanical parts are attached to the exposure apparatus main body and the wiring and piping are connected, and further total adjustment (such as electrical adjustment and operation check) is performed, which completes the making of the exposure apparatus of the embodiment above. Incidentally, the exposure apparatus is preferably built in a clean room where the temperature, the degree of cleanliness and the like are controlled.

Incidentally, in the embodiment above, the projection exposure apparatus by a step-and-scan method or a step-and-repeat method is described, however, besides these projection exposure apparatuses, it is needless to say that the present invention can also be applied to other exposure apparatuses such as an exposure apparatus by a proximity method. Further, the present invention can also be suitably applied to a reduction projection exposure apparatus by a step-and-stitch method that combines shot areas. Furthermore, the present invention can also be applied to a twin-stage type exposure apparatus that has two wafer stages, as is disclosed in, for example, the pamphlets of International Publication Nos. WO 98/24115 and WO 98/40791. Moreover, it is matter of course that the present invention can also be applied to an exposure apparatus that uses an immersion method as disclosed in, for example, the pamphlet of International Publication No. WO 99/49504.

The usage of the present invention is not limited to the exposure apparatus for manufacturing semiconductors, and the present invention can also be applied to the exposure apparatus such as an exposure apparatus used for manufacturing displays including liquid crystal display devices that transfers a device pattern onto a glass plate, an exposure apparatus used for manufacturing thin-film magnetic heads that transfers a device pattern onto a ceramic wafer, and an exposure apparatus used for manufacturing imaging devices (such as CCD), micromachines, organic EL, DNA chips or the like. Furthermore, the present invention may be applied to an exposure apparatus that uses, as an exposure beam, an EUV light (the oscillation spectrum being 5 to 15 nm (a soft X ray region)), an X-ray, or a charged particle beam such as an electron beam that uses thermal electron emission type lanthanum hexaboride ($LaB_6$) or tantalum (Ta) as an electron gun or an ion beam.

In addition, the present invention can also be applied to an exposure apparatus that transfers a circuit pattern onto a glass substrate or a silicon wafer not only when producing microdevices such as semiconductors, but also when producing a reticle or a mask used in exposure apparatuses such as an optical exposure apparatus, an EUV exposure apparatus, an X-ray exposure apparatus, or an electron beam exposure apparatus. In general, in the exposure apparatus that uses DUV (far ultraviolet) light or VUV (vacuum ultraviolet) light, a transmittance type reticle is used, and as the reticle substrate, materials such as silica glass, fluorine-doped silica glass, fluorite, magnesium fluoride, or crystal are used. In the exposure apparatus by a proximity method or the electron beam exposure apparatus, a transmittance type mask (a stencil mask or membrane mask) is used, and as a mask substrate, a silicon wafer or the like is used.

Further, in the embodiment above, the case is described where the present invention is applied to the processing system. However, the present invention can be applied to a transport apparatus, a measurement apparatus, an inspection apparatus, a test apparatus, and all of other apparatuses that perform positioning of objects. For example, in the case of a measurement apparatus (offline measurement instrument 800), an inspection apparatus, a test apparatus, a laser repair apparatus and the like as is described above, while the positioning of a wafer (a wafer to which exposure processing has been performed in an exposure apparatus and on which a pattern has been formed, a wafer after exposure) loaded into these apparatuses (hereinafter referred to as processing apparatuses) is performed by a positioning unit arranged in each of the processing apparatuses, various processing (measurement processing, inspection processing, test processing or repair processing) is performed.

In the processing apparatus, normally, an orientation (a rotation) and a loading position of a wafer when loading the wafer into the processing apparatus are controlled based on results of measuring an outer shape of the wafer. Then, by moving the wafer loaded into the processing apparatus based on design values (position information in design related to a mark arrangement or a pattern arrangement on the wafer), the processing apparatus sets the position of a desired position on the wafer at a predetermined processing position within the processing apparatus (a place where the processing is performed within the apparatus). Thus, in the case the wafer position setting is performed in the processing apparatus, by performing the processing as is described in the embodiment above, the position setting accuracy when setting the position of a desired position on the wafer at a predetermined processing position within the processing apparatus can be improved.

More specifically, pre-measurement results (such as off-set information between a mark position in design and an actual mark position taking wafer outer shape information into consideration of a mark formed on the wafer), which have been measured by pre-measurement instrument 400 before the wafer is loaded into the exposure apparatus, are conveyed to each of the processing apparatuses above (such as offline measurement instrument 800), and the processing apparatus performs the position setting processing after adding the conveyed off-set information to the design values above, which makes it possible to perform the position setting with higher accuracy and a higher speed. In this case, a new pre-measurement instrument is not arranged for the processing apparatuses, but the pre-measurement results of pre-measurement instrument 400 described above are reused (after being used in the exposure apparatus, also used in other processing apparatuses), and therefore, an efficient system can be achieved in terms of cost and also of throughput.

In addition, when the processing apparatuses are configured so that loading repeatability measurement is performed in the similar manner to the one described in the embodiment above, the processing apparatuses (the processing systems) can be achieved that are not affected by decrease in the wafer loading repeatability according to changes with time.

Incidentally, as the reuse of the pre-measurement results described above, the following reuse method can also be considered. The reuse method will be described, citing the processing system explained in the embodiment above, as an example.

Pre-measurement information that is obtained by pre-measuring a wafer on which a resist for exposing the $N^{th}$ layer is coated by pre-measurement instrument 400 is stored in a storage unit (such as a memory (not shown) arranged inside exposure apparatus 200 or analytical system 600) together with ID (identification) information on the pre-measured wafer (hereinafter referred to as the 'wafer after pre-measurement'). Then, the wafer after pre-measurement is taken out of the exposure apparatus after exposure processing to the $N^{th}$ layer of the wafer is performed in the exposure apparatus, and the processing is carried out to the wafer in the various processing apparatuses (such as the C/D apparatus and the offline measurement instrument). Normally, since the device is formed by overlaying a plurality of layers to one wafer (by repeating C/D processing→exposure processing→C/D processing→exposure processing...), the wafer after pre-measurement is to be subject to exposure processing again in the exposure apparatus after a resist for the $N+1^{th}$ layer is coated on the wafer. When loading the wafer after pre-measurement into the exposure apparatus for exposing the $N+1^{th}$ layer, pre-measurement instrument 400 described above does not perform (passes on) an pre-measurement operation, and instead the pre-measurement information (the pre-measurement information on the $N^{th}$ layer) that has been measured on the exposure of the $N^{th}$ layer and stored in the storage unit described above is read out. Then, the $N+1^{th}$ layer is exposed while performing position setting of the wafer using the read out information.

To be more specific, when exposing the first layer, position information of a search alignment mark formed in the first layer based on a wafer outer shape as a datum (a position coordinate of the search alignment mark in the outer shape reference coordinate system) is pre-measured, and stored in the storage unit described above. Next, in the case the judgment is made from information such as the recipe that the wafer is loaded again into the exposure apparatus for exposing the second layer, by using pre-measurement results of the search alignment mark of the first layer (which are stored in the storage unit described above) without performing pre-measurement of a search alignment mark formed on the second layer, the loading position of the wafer after pre-measurement is determined (the position of the search alignment mark of the second layer is set within a measurement field of a measurement unit). By reusing the pre-measurement information in this manner, a period of time required for pre-measurement can be shortened, and the throughput can be improved in the entire device manufacturing processes. Incidentally, when using this method practically, it is premised that a position deviation error between a fine alignment mark of the $N+1^{th}$ layer and a search alignment mark of the $N^{th}$ layer is within a permissible error range required in terms of accuracy. Information as to whether or not such position deviation error between layers (processes) is within a permissible range is preferably prepared as a data table by obtaining position deviation errors between respective layers (processes) beforehand in experiments (actual measurements), simulations or the like. And, only in the case of the layer whose error is within a permissible range in the data table, the reuse method of the pre-measurement information as described above may be employed.

The exposure apparatus of the embodiment described above can be made by incorporating the illumination optical system and the projection optical system that are made up of a plurality of lenses into the exposure apparatus main body and performing the optical adjustment thereof, and also attaching the reticle stage and the substrate stage made up of multiple mechanical parts to the exposure apparatus main body and the wiring and piping connected, further by performing total adjustment (such as electrical adjustment and operation check). Incidentally, the exposure apparatus is preferably built in a clean room where the temperature, the degree of cleanliness and the like are controlled.

A semiconductor device is manufactured through the following steps: a step of performing function and performance design of device, a step of manufacturing a reticle based on the design step, a step of manufacturing a wafer using silicon materials, a step of transferring a pattern of the reticle to the wafer by the exposure apparatus in the embodiment described above, a step of assembling the device (including the dicing process, the bonding process, and the packaging process), an inspection step, and the like.

The positioning method, the processing system, the position setting repeatability measurement method, the position measurement method, the exposure method, the substrate processing apparatus, the measurement method, and the measurement apparatus are suitable for photolithography processes for manufacturing semiconductor devices, liquid crystal display devices, imaging devices, thin film magnetic heads and the like.

## Claims

1. A positioning method, comprising:

   a pre-measurement process in which before an object that has at least two marks formed on a surface to be measured thereof is loaded into a processing apparatus that performs predetermined processing to the object, at least a part of an outer edge of a surface to be measured of the object and each of the marks are detected, and a position coordinate of each of the marks in an outer shape reference coordinate system that is a two-dimensional coordinate system substantially parallel to the surface to be measured and is set by at least one datum point on the outer edge is measured based on the detection results;

   a main measurement process in which at least a part of the outer edge of the surface to be measured of the object is detected, and position information of the object in the outer shape reference coordinate system is measured based on the detection results, in order to perform positioning of the object on loading of the object into the processing apparatus; and

an adjustment process in which a relative positional relation in the two-dimensional coordinate system of the object to be loaded into the processing apparatus based on the measurement results of the main measurement process with respect to a measurement field of a mark measurement unit that is arranged within the processing apparatus and measures a position of each of the marks on the object is adjusted, based on measurement results in the pre-measurement process.

2. The positioning method of Claim 1 wherein
a shape of the outer edge of the surface to be measured of the object is a substantially circular shape,
the outer shape reference coordinate system is one of a coordinate system that is set by a center position and a rotation amount of the object obtained when using at least one specific point corresponding to an outer shape characteristic portion on the outer edge of the object as a datum point, and a coordinate system that is set by a center position and a rotation amount of the object obtained using at least three points on the outer edge of the object as datum points, and
in the pre-measurement process, measurement of the position coordinate of each of the marks in the outer shape reference coordinate system that is applied to the main measurement process is performed.

3. The positioning method of Claim 1, further comprising:

a mark measurement process in which position measurement of each of the marks on the object loaded into the processing apparatus is performed; and
a post-loading judgment process in which based on the measurement results in the mark measurement process, the judgment is made of whether or not predetermined processing to the object can normally be performed.

4. The positioning method of Claim 1, further comprising:

an evaluation process in which prior to the main measurement process, the detection results of at least a part of the outer edge of the surface to be measured of the object in the pre-measurement process is evaluated; and
an optimization process in which measurement conditions in the main measurement process are optimized, based on at least one of the detection results of at least a part of the outer edge of the surface to be measured of the object in the pre-measurement process and evaluation results in the evaluation process.

5. The positioning method of Claim 4 wherein
in the evaluation process, the detection results are evaluated in a score form according to a predetermined evaluation criterion.

6. The positioning method of Claim 5 wherein
in the evaluation process, the weighting sum of the plurality of characteristic amounts are computed as an evaluation result, using a plurality of characteristic amounts related to a detection state of the outer edge of the object in the detection results as the predetermined evaluation criterion.

7. The positioning method of Claim 6 wherein
the plurality of characteristics amounts include at least one of contrast between a bright portion and a dark portion near the outer edge of the surface to be measured of the object that is obtained from the detection results, variation in the contrast, a curvature of the outer edge of the object that is obtained from the detection results, and variation between the outer edge and an approximate curve of the outer edge that is obtained from the detection results.

8. The positioning method of Claim 4, further comprising:

a pre-optimization judgment process in which prior to the main measurement process, the judgment is made of whether or not detection of the outer edge of the object has normally been performed based on the scores of the detection results, and wherein
in the optimization process, in the case the judgment is denied, optimization of the measurement conditions is performed based on the detection results of at least a part of the outer edge of the surface to be measured of the object in the pre-measurement process.

9. The positioning method of Claim 8, further comprising:

a post-optimization judgment process in which after performing the optimization process, the detection results of at least a part of the outer edge of the surface to be measured of the object to be loaded into the processing apparatus are evaluated again, and based on the evaluation results, the judgment is made of whether or not predetermined processing to the object can normally be performed.

**10.** The positioning method of Claim 9 wherein
each of the processes is sequentially performed to each of objects included in an object group that is made up of a plurality of the objects, and
the positioning method further comprising:

an exclusion process in which all the objects included in the object group are excluded in the case the number of the objects to which the judgment is made that predetermined processing cannot be performed in the post-optimization judgment process exceeds a predetermined number.

**11.** The positioning method of Claim 4, further comprising:

a consistency process in which the evaluation results with respect to the detection results of at least a part of the outer edge of the surface to be measured of the object in the pre-measurement process are made to be consistent with the evaluation results with respect to the detection results of at least a part of the outer edge of the surface to be measured of the object in the main measurement process.

**12.** The positioning method of Claim 4 wherein
the optimization process is performed by at least one of the processing apparatus and an analytical apparatus that operates independently of the processing apparatus.

**13.** The positioning method of Claim 4 wherein
the measurement conditions include at least one of an illumination condition at the time of measurement, the number of repeated measurement times, an imaging magnification of an imaging unit used for measurement and a position measurement algorithm.

**14.** The positioning method of Claim 1 wherein
each of the processes is sequentially performed to each of a plurality of different objects, and
the positioning method further comprising:

a normalization process in which the position measurement results in the mark measurement process are normalized, based on the position coordinate of each of the marks in the outer shape reference coordinate system in the pre-measurement process; and
a repeatability measurement process in which repeatability of a relative positional relation of the object loaded into the processing apparatus with respect to the measurement field of the mark measurement unit is measured, based on the normalized position measurement results.

**15.** The positioning method of Claim 14 wherein
on the object, a plurality of divided areas formed in a matrix arrangement, fine alignment marks arranged along with the respective divided areas and search alignment marks used to search the fine alignment marks are formed, and the positioning method further comprising:

a detection process in which each of the marks measured in the pre-measurement process is used as the search alignment mark, and an array coordinate system that is set by an array of the plurality of divided areas on the object is detected using a predetermined statistical method, based on position measurement results of at least three fine alignment marks that are noncollinear and formed on the object loaded into the processing apparatus, and wherein
in the normalization process, the measurement results in the mark measurement process are further normalized based on at least one of a magnification component and an orthogonal component of the array coordinate system with respect to the outer shape reference coordinate system.

**16.** The positioning method of Claim 15 wherein
in the detection process, a random component of the position measurement result of each of the search alignment marks with respect to the array coordinate system is obtained, and
in the normalization process, the measurement results in the mark measurement process are further normalized based on the random component.

17. The positioning method of Claim 16, further comprising:

a repeatability measurement judgment process in which based on magnitude of the random component, the judgment is made of whether or not the position measurement result of each of the marks is used for repeatability measurement.

18. The positioning method of Claim 14, further comprising:

a derivation process in which a fluctuation prediction equation that is used to predict fluctuation in a center position and a rotation amount of the object based on variation in the normalized position measurement results in the mark measurement process is derived, and wherein
in the adjustment process, a relative positional relation between the object to be loaded into the processing apparatus and the measurement field of the mark measurement unit that measures a position of each of the marks on the object is adjusted, based on calculation results of the fluctuation prediction equation.

19. The positioning method of Claim 14 wherein
in the repeatability measurement process, as an evaluation factor of the repeatability, information related to standard deviation, a range and a mean of a center position and a rotation amount of the object after loading is used.

20. The positioning method of Claim 19, further comprising:

a judgment process in which based on a value of the evaluation factor, the judgment is made of whether or not a predetermined processing can normally be performed to the object.

21. The positioning method of Claim 1 wherein
the pre-measurement process is performed after the object is coated with a photosensitive agent.

22. The positioning method of Claim 21 wherein
a timing of performing the pre-measurement process is made to be different from a timing of performing measurement of a pattern on the object to which predetermined processing and development are completed.

23. The positioning method of Claim 1 wherein
the processing apparatus is an exposure apparatus that exposes a photosensitive substrate as the object,
a measurement apparatus that performs the pre-measurement process is inline connected to the exposure apparatus.

24. The positioning method of Claim 23 wherein
the processing apparatus further includes at least one of a measurement apparatus that performs measurement processing to a photosensitive substrate after exposure that has been through exposure processing in the exposure apparatus, an inspection apparatus that picks up an image of the photosensitive substrate after exposure and performs inspection processing on the image, a test apparatus that performs test processing to the photosensitive substrate after exposure, and a laser repair apparatus that performs repair processing to the photosensitive substrate after exposure.

25. A processing system, comprising:

a processing apparatus that performs predetermined processing to an object;
a mark measurement unit that performs position measurement of at least two marks formed on the object loaded into the processing apparatus;
a pre-measurement apparatus that, before the object that has at least two marks formed on a surface to be measured thereof is loaded into the processing apparatus, detects at least a part of an outer edge of the surface to be measured of the object and each of the marks, and measures a position coordinate of each of the marks in an outer shape reference coordinate system that is a two-dimensional coordinate system substantially parallel to the surface to be measured and is set by at least one datum point on the outer edge of the object, based on the detection results;
an outer edge measurement unit that detects at least a part of the outer edge of the surface to be measured of the object, and measures position information of the object in the outer shape reference coordinate system based on the detection results, in order to perform positioning of the object on loading of the object into the processing apparatus; and

an adjustment unit that adjusts a relative positional relation in the two-dimensional coordinate system of the object to be loaded into the processing apparatus based on the measurement results of the outer edge measurement unit with respect to a measurement field of the mark measurement unit, based on measurement results of the pre-measurement apparatus.

26. The processing system of Claim 25, further comprising:

an evaluation apparatus that evaluates the detection results of at least a part of the outer edge of the surface to be measured of the object by the pre-measurement apparatus; and

an optimization apparatus that optimizes measurement conditions in the outer edge measurement unit based on at least one of the detection results of at least a part of the outer edge of the surface to be measured of the object by the pre-measurement apparatus and evaluation results by the evaluation apparatus.

27. The processing system of Claim 26, further comprising:

a normalization unit that normalizes the position measurement results of the mark measurement unit based on the position coordinate of each of the marks in the outer shape reference coordinate system in the pre-measurement apparatus; and

a repeatability measurement unit that measures repeatability of positioning of the object loaded into the processing apparatus, based on the normalized position measurement results.

28. The processing system of Claim 25, further comprising:

a derivation unit that derives a fluctuation prediction equation used to predict fluctuation in a center position and a rotation amount of the object based on variation in the normalized position measurement results of the mark measurement unit, and wherein

the adjustment unit adjusts a relative positional relation of the object to be loaded into the processing apparatus with respect to a measurement field of a measurement unit that measures a position of each of the marks on the object, based on calculation results of the fluctuation prediction equation.

29. The processing system of Claim 25 wherein
the processing apparatus is an exposure apparatus that exposes a photosensitive substrate as the object,
the pre-measurement apparatus is inline connected to the exposure apparatus.

30. The processing system of Claim 29 wherein
the processing apparatus further includes at least one of a measurement apparatus that performs measurement processing to a photosensitive substrate after exposure that has been through exposure processing in the exposure apparatus, an inspection apparatus that picks up an image of the photosensitive substrate after exposure and performs inspection processing on the image, a test apparatus that performs test processing to the photosensitive substrate after exposure, and a laser repair apparatus that performs repair processing to the photosensitive substrate after exposure.

31. A measurement method of substrate loading repeatability in which repeatability of a loading position of a substrate that is loaded to a datum position arranged within a substrate processing apparatus, the method comprising:

a position setting process in which positions of a plurality of the substrates on which a device pattern is to be sequentially transferred are sequentially set to the datum position;
a measurement process in which position information of a mark that is formed on the substrate loaded to the datum position is sequentially measured by a measurement instrument arranged within the substrate processing apparatus; and
a computation process in which the loading repeatability is computed based on measurement results of the measurement process.

32. The measurement method of substrate loading repeatability of Claim 31, further comprising:

a normalization process in which variation in the measurement results of the measurement process based on a difference of an outer shape of each substrate between the plurality of substrates is normalized, and wherein based on normalization results in the normalization process, the loading repeatability is computed.

**33.** The measurement method of substrate loading repeatability of Claim 32 wherein
the mark is arranged in plural on the substrate, and
the normalization process includes:

a process in which a contour of the substrate is measured, and based on the measurement result, an outer shape reference coordinate system that is a two-dimensional coordinate system substantially parallel to a surface of the substrate and is set by at least one datum point on the contour is set, and
a process in which position information of the plurality of marks in the outer shape reference coordinate system is measured, and

in the normalization process, variation in a measurement result of each of the plurality of marks is normalized based on the position information of each of the plurality of marks in the outer shape reference coordinate system, and
in the computation process, the loading repeatability is computed based on the normalized position information.

**34.** The measurement method of substrate loading repeatability of Claim 31, further comprising:

a normalization process in which variation in the measurement results of the measurement process based on a difference of a deformation component of each substrate itself between the plurality of substrates is normalized, and wherein
the loading repeatability is computed based on normalization results in the normalization process.

**35.** The measurement method of substrate loading repeatability of Claim 34 wherein
on the substrate, a plurality of divided areas formed in a matrix arrangement, fine alignment marks arranged along with the respective divided areas and search alignment marks used to search the fine alignment marks are formed, and
the measurement method of loading repeatability further comprising:

a detection process in which an array coordinate system that is set by an array of the plurality of divided areas on the substrate is detected using a predetermined statistical method, based on position measurement results of the fine alignment marks in at least two different points or at least three noncollinear points that are formed on the substrate loaded into the substrate processing apparatus, and wherein
the normalization process includes:

a process in which a contour of the substrate is measured, and based on the measurement result, an outer shape reference coordinate system that is a two-dimensional coordinate system substantially parallel to a surface of the substrate and is set by at least one datum point on the contour is set, and
a process in which position information of the plurality of search alignment marks in the outer shape reference coordinate system is measured, and

in the normalization process, variation in the measurement results of the measurement process are further normalized, based on at least one of a magnification component and an orthogonal component of the array coordinate system with respect to the outer shape reference coordinate system.

**36.** The measurement method of substrate loading repeatability of Claim 35 wherein
in the detection process, a random component of the position measurement result of each of the marks with respect to the array coordinate system is obtained, and
in the normalization process, the measurement results of the measurement process are further normalized based on magnitude of the random component.

**37.** A position measurement method in which position information that indicates a position of a substrate whose position is set to a predetermined datum position is measured, the method comprising:

a process in which loading repeatability of the substrate disposed at the datum position is measured using the measurement method of substrate loading repeatability according to any one of Claims 31 to 36; and

53

a process in which the position of the substrate is adjusted in accordance with tendency of the loading repeatability, and position information of a mark formed on the substrate is measured.

**38.** An exposure method in which a predetermined pattern is transferred onto a substrate, the method comprising:

a substrate measurement process in which position information that indicates a position of the substrate is obtained using the position measurement method according to Claim 37; and
a transfer process in which position control of the substrate is performed based on the position information of the substrate obtained in the substrate measurement process, and the pattern is transferred onto the substrate.

**39.** A substrate processing apparatus that sequentially processes a plurality of substrates, the apparatus comprising:

position setting means that sequentially sets positions of the substrates to a predetermined datum position;
measurement means that measures position information of a mark formed on the substrate whose position is set to the datum position; and
computation means that computes loading repeatability of the substrate based on measurement results of the measurement means.

**40.** The substrate processing apparatus of Claim 39, further comprising:

normalization means that normalizes variation in the measurement results of the measurement means based on a difference of an outer shape of each substrate or a difference of a deformation component of each substrate itself between the plurality of substrates, and wherein
the loading repeatability is computed based on normalization results of the normalization means.

**41.** A measurement method, comprising:

a first process in which at least a part of an outer edge of a surface to be measured of an object that has a mark formed on the surface to be measured thereof is measured;
a second process in which the mark is measured; and
a third process in which position information of the mark in an outer shape reference coordinate system that is a two-dimensional coordinate system substantially parallel to the surface to be measured and is set by at least one datum point on the outer edge is obtained based on measurement results of the first and second processes.

**42.** The measurement method of Claim 41 wherein
at least the first process and the second process are performed before the object is loaded into a processing apparatus that performs predetermined processing to the object.

**43.** The measurement method of Claim 42 wherein
at least one information from among the position information of the mark computed in the third process, the measurement results of the first process, and evaluation results obtained by evaluating the measurement results of the first process in a predetermined evaluation method is sent to the processing apparatus.

**44.** The measurement method in any one of Claims 41 to 43 wherein
the first process and the second process are performed substantially at the same time.

**45.** A measurement method, comprising:

a first process in which at least a part of an outer edge of an object is measured before the object is loaded into a processing apparatus that performs predetermined processing to the object; and
a second process in which measurement results of the first process and/or evaluation results obtained by evaluating the measurement results of the first process in a predetermined evaluation method are/is sent to the processing apparatus.

**46.** A measurement apparatus, comprising:

a first measurement sensor that measures at least a part of an outer edge of a surface to be measured of an object that has a mark formed on the surface to be measured thereof;

a second measurement sensor that measures the mark; and

a computation unit that obtains position information of the mark in an outer shape reference coordinate system that is a two-dimensional coordinate system substantially parallel to the surface to be measured and is set by at least one datum point on the outer edge, based on measurement results of the first and second sensors.

47. The measurement apparatus of Claim 46 wherein

the measurement apparatus is arranged outside a processing apparatus that performs predetermined processing to the object, and

the measurement apparatus further comprises:

a transmission unit that sends at least one of the position information of the mark, the measurement results of the first measurement sensor, and evaluation results obtained by evaluating the measurement results of the first measurement sensor in a predetermined evaluation method to the processing apparatus.

48. A measurement apparatus, comprising:

a sensor that is disposed outside a processing apparatus that performs predetermined processing to an object and measures at least a part of an outer edge of the object before the object is loaded into the processing apparatus; and

a transmission unit that sends measurement results of the sensor and/or evaluation results obtained by evaluating the measurement results of the sensor in a predetermined evaluation method to the processing apparatus.

49. The measurement method of Claim 45 wherein

the processing apparatus includes an exposure apparatus that exposes a photosensitive substrate as the object.

50. The measurement method of Claim 49 wherein

the processing apparatus further includes at least one of a measurement apparatus that performs measurement processing to a photosensitive substrate after exposure that has been through exposure processing in the exposure apparatus, an inspection apparatus that picks up an image of the photosensitive substrate after exposure and performs inspection processing on the image, a test apparatus that performs test processing to the photosensitive substrate after exposure, and a laser repair apparatus that performs repair processing to the photosensitive substrate after exposure.

51. The measurement apparatus of Claim 47 wherein

the processing apparatus includes an exposure apparatus that exposes a photosensitive substrate as the object.

52. The measurement apparatus of Claim 51 wherein

the processing apparatus further includes at least one of a measurement apparatus that performs measurement processing to a photosensitive substrate after exposure that has been through exposure processing in the exposure apparatus, an inspection apparatus that picks up an image of the photosensitive substrate after exposure and performs inspection processing on the image, a test apparatus that performs test processing to the photosensitive substrate after exposure, and a laser repair apparatus that performs repair processing to the photosensitive substrate after exposure.

*Fig. 1*

100

700

IN-HOUSE PRODUCTION CONTROL HOST SYSTEM

EXPOSURE PROCESS
CONTROL CONTROLLER

500

OFFLINE
MEASUREMENT
INSTRUMENT

800

ANALYTICAL
SYSTEM

600

EXPOSURE APPARATUS

LASER

200

TRACK

INLINE
MEASUREMENT
INSTRUMENT

300

400

*Fig. 2*

*Fig. 3A*

18
30

Z
Y
X

WST

*Fig. 3B*

18
WST
30

Y
Z X

30 30a 18

*Fig. 3C*

WST

Z
Y X

*Fig. 4*

EP 1 791 169 A1

*Fig. 5*

*Fig. 6A*

*Fig. 6B*

## Fig. 7

*Fig. 8A*

410

Z
Y
X

W

IST

420

*Fig. 8B*

410

Z
Y⊗ →X

W

420

450

424

TT

IST

415

*Fig. 9*

```
        ┌─────────┐
        │  START  │
        └─────────┘
             │
  ┌──────────────────────┐
  │  RESIST PROCESSING    │        ⌇ S10
  └──────────────────────┘
             │
  ┌──────────────────────┐
  │       INLINE          │        ⌇ S11
  │  PRE-MEASUREMENT      │
  └──────────────────────┘
             │
  ┌──────────────────────┐
  │   DERIVATION OF       │        ⌇ S12
  │  OPTIMAL CONDITIONS   │
  └──────────────────────┘
             │
  ┌──────────────────────┐
  │    PRE-ALIGNMENT      │        ⌇ S13
  └──────────────────────┘
             │
  ┌──────────────────────┐
  │     WAFER LOAD        │        ⌇ S14
  └──────────────────────┘
             │
  ┌──────────────────────┐
  │   SEARCH ALIGNMENT    │        ⌇ S15
  └──────────────────────┘
             │
  ┌──────────────────────┐
  │    FINE ALIGNMENT     │        ⌇ S16
  └──────────────────────┘
             │
  ┌──────────────────────┐
  │      EXPOSURE         │        ⌇ S17
  │     PROCESSING        │
  └──────────────────────┘
             │
  ┌──────────────────────┐
  │    WAFER UNLOAD       │        ⌇ S18
  └──────────────────────┘
             │
  ┌──────────────────────┐
  │     DEVELOPMENT       │        ⌇ S19
  └──────────────────────┘
             │
  ┌──────────────────────┐
  │       ETCHING         │        ⌇ S20
  └──────────────────────┘
             │
  ┌──────────────────────┐
  │   RESIST SEPARATION   │        ⌇ S21
  └──────────────────────┘
             │
        ┌─────────┐
        │   END   │
        └─────────┘
```

EP 1 791 169 A1

*Fig. 10*

65

## Fig. 11

START

ROTATION AMOUNT $\theta \leftarrow 0$, $R \leftarrow R_0$ — 520

DETECT NOTCH POSITION $P_N$ — 522

TENTATIVELY DETERMINE MIDPOINT $\underline{P_M}$ OF $P_1$, $P_2$ — 524

DETERMINE STRAIGHT LINE ORTHOGONAL TO LINE SEGMENT $\underline{P_M}P_N$ — 526

TENTATIVELY DETERMINE EDGE POINTS $P_1$, $P_2$ — 528

COMPUTE MIDPOINT $P_M'$ OF $P_1$, $P_2$ — 530

CORRECT ROTATION AMOUNT $\theta$ — 532

COMPUTE DISTANCE D BETWEEN POINT P1 AND POINT P2 — 534

CORRECT R — 536

COMPUTE VIRTUAL CENTER $P_C(X_C, Y_C)$ — 538

FIRST TIME? — 540

Y / N

ADJUST ROTATION AMOUNT $\theta$ — 542

FINALLY DETERMINE WAFER CENTER — 544

END

*Fig. 12A*

LOADING ARM LOWERING Z POSITION

*Fig. 12B*

CENTER TABLE LOWERING Z POSITION

*Fig. 13*

*Fig. 14*

*Fig. 15A*

```
                        (START)
                           |
              LOAD WAFER W          ~ 620
                           |
   INLINE MEASUREMENT INSTRUMENT OBTAINS WAFER OUTER
   SHAPE MEASUREMENT PARAMETER, SEARCH ALIGNMENT       ~ 622
   MARK DESIGN POSITION AND MARK DETECTION PARAMETER
        FROM EXPOSURE APPARATUS OR THE LIKE
                           |
 (B) ─────────────────────>
                           |
        INLINE MEASUREMENT INSTRUMENT MEASURES
              WAFER OUTER SHAPE EDGE                    ~ 624
   (NORMALLY, AT THREE POINTS INCLUDING NOTCH/OF)
                           |
        COMPUTE CENTER POSITION AND        ~ 626
           ROTATION AMOUNT OF WAFER
                           |
       INLINE MEASUREMENT INSTRUMENT COMPUTES          ~ 628
   WAFER OUTER SHAPE EDGE DETECTION RESULT SCORE
                           |
        INLINE MEASUREMENT INSTRUMENT SENDS
   DETECTION RESULT OF WAFER OUTER SHAPE EDGE AND      ~ 630
   WAFER OUTER SHAPE EDGE DETECTION RESULT SCORE
      TO EXPOSURE APPARATUS OR ANALYTICAL SYSTEM
                           |
                          (A)
```

*Fig. 15B*

```
                          (C)
                           |
        INLINE MEASUREMENT INSTRUMENT MEASURES         ~ 632
            SEARCH ALIGNMENT MARK BASED ON
   WAFER OUTER SHAPE REFERENCE COORDINATE SYSTEM
                           |
       INLINE MEASUREMENT INSTRUMENT COMPUTES          ~ 634
   DEVIATION AMOUNT OF SEARCH ALIGNMENT MARK IN
   WAFER OUTER SHAPE REFERENCE COORDINATE SYSTEM
                           |
       INLINE MEASUREMENT INSTRUMENT COMPUTES          ~ 636
            MARK DETECTION RESULT SCORE
                           |
                                                        638
        INLINE MEASUREMENT INSTRUMENT SENDS
   MARK DETECTION RESULT, DETECTION SCORE AND DEVIATION
   AMOUNT TO EXPOSURE APPARATUS OR ANALYTICAL SYSTEM
                           |
                          (D)
```

## Fig. 16

(A)

640

N ◇ EDGE DETECTION ERROR?

↓ Y

OPTIMIZE WAFER OUTER SHAPE DETECTION PARAMETER BASED ON OBTAINED EDGE IMAGE DATA — 642

644

N ◇ EDGE DETECTION ERROR?

↓ Y

646

◇ SEARCH OTHER EDGES? N

↓ Y

(C)

DESIGNATE EDGE TO BE MEASURED AND EDGE DETECTION PARAMETER — 648

(B)

(D)

660

N ◇ MARK DETECTION ERROR?

↓ Y

OPTIMIZE MARK DETECTION PARAMETER BASED ON OBTAINED MARK IMAGE DATA — 662

664

N ◇ MARK DETECTION ERROR?

↓ Y

666

◇ SEARCH OTHER MARKS? N

↓ Y

652
WAFER PROCESSING

DESIGNATE MARK TO BE MEASURED AND MARK DETECTION PARAMETER — 668

650
REJECT WAFER OR LOT

END

(C)

END

*Fig. 17A*

*Fig. 17B*

VC

N

*Fig. 17C*

VA

N

*Fig. 18A*

*Fig. 18B*

*Fig. 19*

```
        ( START )
            |
```

| SET WAFER LOADING REPEATABILITY MEASUREMENT OPERATION MODE | 820 |

| SET NUMBER OF MEASUREMENT TIMES OF WAFER LOADING REPEATABILITY | 822 |

| SET CORRECTION CONDITIONS OF DIFFERENCE BETWEEN WAFERS | 824 |

| SET WAFER LOADING REPEATABILITY EVALUATION FACTOR | 826 |

| SET OPERATION FOR THE CASE WAFER LOADING REPEATABILITY EXCEEDS THRESHOLD VALUE | 828 |

| SET SEARCH MEASUREMENT POSITION AUTOMATIC ADJUSTMENT FUNCTION | 830 |

| SET OPERATION FOR THE CASE SEARCH MEASUREMENT POSITION ERROR OCCURS | 832 |

```
            |
        ( END )
```

*Fig. 20*

*Fig. 21*

EP 1 791 169 A1

*Fig. 22*

EP 1 791 169 A1

*Fig. 23A*

*Fig. 23B*

*Fig. 24A*

*Fig. 24B*

*Fig. 25*

*Fig. 26*

## Fig. 27

```
                    ┌─────────┐
                    │  START  │
                    └────┬────┘
                         ▼
        ┌──────────────────────────────┐
        │   SETTING CONDITIONS FOR      │ ⌐ S11'
        │   REPEATABILITY MEASUREMENT   │
        └───────────────┬──────────────┘
                        ▼
          ┌───────────────────────┐
          │   PRE-ALIGNMENT OF     │ ⌐ S12'
          │        WAFER           │
          └───────────┬───────────┘
                      ▼
          ┌───────────────────────┐
          │  SET POSITION OF WAFER ON │ ⌐ S13'
          │      WAFER HOLDER      │
          └───────────┬───────────┘
                      ▼
      ┌──────────────────────────────────┐
      │  ADJUST THE POSITION OF WAFER     │ ⌐ S14'
      │  BASED ON MEASUREMENT RESULT OF   │
      │  POSITION SETTING REPEATABILITY   │
      └────────────────┬─────────────────┘
                       ▼
          ┌───────────────────────┐
          │   SEARCH MEASUREMENT   │ ⌐ S15'
          └───────────┬───────────┘
                      ▼
          ┌───────────────────────┐
          │    FINE MEASUREMENT    │ ⌐ S16'
          └───────────┬───────────┘
                      ▼
          ┌───────────────────────┐
          │    EGA COMPUTATION     │ ⌐ S17'
          └───────────┬───────────┘
                      ▼
      ┌──────────────────────────────┐
      │  COMPUTE WAFER POSITION       │ ⌐ S18'
      │  SETTING REPEATABILITY        │
      └───────────────┬──────────────┘
                      ▼
          ┌───────────────────────┐
          │   EXPOSURE PROCESSING  │ ⌐ S19'
          └───────────┬───────────┘
                      ▼                    S20'
                   ◇─────────────◇  ⌐ YES
                  ◇  NEXT WAFER   ◇──────────►
                  ◇   EXISTS?     ◇
                   ◇─────────────◇
                        │ NO
                        ▼
                    ┌─────────┐
                    │   END   │
                    └─────────┘
```

*Fig. 28*

```
                    ( START )
                        │
                        ▼
        ┌───────────────────────────────┐
        │  SET POSITION SETTING          │ ⌐ S21'
        │  REPEATABILITY                 │
        │  MEASUREMENT OPERATION MODE    │
        └───────────────────────────────┘
                        │
                        ▼
        ┌───────────────────────────────┐
        │  SET NUMBER OF MEASUREMENT     │ ⌐ S22'
        │  TIMES OF                      │
        │  POSITION SETTING REPEATABILITY│
        └───────────────────────────────┘
                        │
                        ▼
        ┌───────────────────────────────┐
        │  SET POSITION SETTING          │ ⌐ S23'
        │  REPEATABILITY                 │
        │  MEASUREMENT DATUM WAFER       │
        └───────────────────────────────┘
                        │
                        ▼
        ┌───────────────────────────────┐
        │  SET POSITION SETTING          │ ⌐ S24'
        │  REPEATABILITY                 │
        │  EVALUATION VALUE              │
        └───────────────────────────────┘
                        │
                        ▼
        ┌───────────────────────────────┐
        │  SET OPERATION FOR THE CASE    │ ⌐ S25'
        │  POSITION SETTING              │
        │  REPEATABILITY EXCEEDS         │
        │  THRESHOLD VALUE               │
        └───────────────────────────────┘
                        │
                        ▼
        ┌───────────────────────────────┐
        │  SET SEARCH MEASUREMENT        │ ⌐ S26'
        │  AUTOMATIC ADJUSTMENT FUNCTION │
        └───────────────────────────────┘
                        │
                        ▼
        ┌───────────────────────────────┐
        │  SET OPERATION FOR THE CASE    │ ⌐ S27'
        │  SEARCH                        │
        │  MEASUREMENT POSITION ERROR    │
        │  OCCURS                        │
        └───────────────────────────────┘
                        │
                        ▼
                   ( RETURN )
```

*Fig. 29*

BEFORE DELIVERY

AFTER DELIVERY

ADJUSTMENT ARM LOWERING VELOCITY

Z1

LOWERING Z POSITION

*Fig. 30*

CENTER TABLE LOWERING VELOCITY

Z0

LOWERING Z POSITION

## Fig. 31A

## Fig. 31B

*Fig. 32*

17a

61'

68'

67'          66'

IMAGING
UNIT

22                              60'

ALIGNMENT              64'
CONTROL
SYSTEM         63'                    65'

W

62'

*Fig. 33*

17a

71'

77'

76'

75'

IMAGING
UNIT

22

70'

74'

ALIGNMENT
CONTROL
SYSTEM

73'

W'

72'

EP 1 791 169 A1

**INTERNATIONAL SEARCH REPORT**

| | International application No. |
|---|---|
| | PCT/JP2005/015764 |

A. CLASSIFICATION OF SUBJECT MATTER
*H01L21/027* (2006.01), *G03F7/20* (2006.01), *H01L21/68* (2006.01)

According to International Patent Classification (IPC) or to both national classification and IPC

B. FIELDS SEARCHED

Minimum documentation searched (classification system followed by classification symbols)
*H01L21/027* (2006.01), *G03F7/20* (2006.01), *H01L21/68* (2006.01)

Documentation searched other than minimum documentation to the extent that such documents are included in the fields searched
Jitsuyo Shinan Koho          1922-1996   Jitsuyo Shinan Toroku Koho   1996-2005
Kokai Jitsuyo Shinan Koho    1971-2005   Toroku Jitsuyo Shinan Koho   1994-2005

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 07-221010 A (Canon Inc.), 18 August, 1995 (18.08.95), | 1-30,32-36, 40 |
| X | Full text; all drawings (Family: none) | 31,37-39 |
| A | JP 06-045428 A (Fujitsu Ltd.), 18 February, 1994 (18.02.94), | 1-30 |
| X | Examples & EP 580895 A2 | 41-44,46,47 |
| A | JP 09-162120 A (Ushio Inc.), 20 June, 1997 (20.06.97), | 1-30 |
| X | Full text; all drawings & EP 767409 A2      & US 5880816 A & EP 767409 B1 | 41-44,46,47, 51,52 |

☒ Further documents are listed in the continuation of Box C.      ☐ See patent family annex.

| * Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 25 November, 2005 (25.11.05) | 06 December, 2005 (06.12.05) |

| Name and mailing address of the ISA/ | Authorized officer |
|---|---|
| Japanese Patent Office | |
| Facsimile No. | Telephone No. |

Form PCT/ISA/210 (second sheet) (April 2005)

**INTERNATIONAL SEARCH REPORT**

| International application No. |
|---|
| PCT/JP2005/015764 |

C (Continuation).   DOCUMENTS CONSIDERED TO BE RELEVANT

| Category* | Citation of document, with indication, where appropriate, of the relevant passages | Relevant to claim No. |
|---|---|---|
| X | JP 10-163302 A  (Canon Inc.),<br>19 June, 1998 (19.06.98),<br>Examples<br>(Family: none) | 45,48-50 |
| A | JP 2000-228347 A  (Nikon Corp.),<br>15 August, 2000 (15.08.00),<br>Full text; all drawings<br>& US 6225012 B1           & US 2001/016293 A1<br>& US 6400445 B2 | 1-30 |

Form PCT/ISA/210 (continuation of second sheet) (April 2005)

**INTERNATIONAL SEARCH REPORT**

International application No.

PCT/JP2005/015764

| Box No. II | Observations where certain claims were found unsearchable (Continuation of item 2 of first sheet) |
|---|---|

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

| Box No. III | Observations where unity of invention is lacking (Continuation of item 3 of first sheet) |
|---|---|

This International Searching Authority found multiple inventions in this international application, as follows:

The technical feature of the invention relating to claims 1-30, 41-44, 46, 47, 51 and 52 is a point of obtaining the position coordinates of a mark in a substrate outer shape reference coordinate system.
The technical feature of the invention relating to claims 31-40 is a point of calculating substrate loading repeatability.
The technical feature of the invention relating to claims 45, 48-50 is a point of transmitting information of the outer edge of an object to a processing apparatus.

1. ☒ As all required additional search fees were timely paid by the applicant, this international search report covers all searchable claims.

2. ☐ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**
☐ The additional search fees were accompanied by the applicant's protest and, where applicable, the payment of a protest fee..

☐ The additional search fees were accompanied by the applicant's protest but the applicable protest fee was not paid within the time limit specified in the invitation.

☒ No protest accompanied the payment of additional search fees.

Form PCT/ISA/210 (continuation of first sheet (2)) (April 2005)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 61044429 A
- US 4780617 A
- JP 62084516 A
- JP 5283315 A
- JP 2001313250 A
- US 20030025890 A
- JP 2054103 A
- US 4962318 A
- JP 6283403 A
- US 5448332 A
- JP 9036202 A
- US 6225012 B
- US 6400445 B
- JP 60218853 A
- US 4907035 A
- JP 2003224057 A
- US 6762111 B
- US 6833309 B
- WO 9946835 A
- WO 9824115 A
- WO 9840791 A
- WO 9949504 A